(19) Europäisches Patentamt
European Patent Office
Office européen des brevets

(11) EP 1 708 033 B1

(12) EUROPEAN PATENT SPECIFICATION

(45) Date of publication and mention of the grant of the patent:
**05.10.2011 Bulletin 2011/40**

(51) Int Cl.:
***G03F 7/32*** *(2006.01)* ***G03F 7/16*** *(2006.01)*
***B41N 3/03*** *(2006.01)*

(21) Application number: **06006125.6**

(22) Date of filing: **24.03.2006**

(54) **Method of manufacturing a lithographic printing plate**

Verfahren zur Herstellung einer Lithografiedruckform

Procédé de fabrication d'une plaque d'impression lithographique

(84) Designated Contracting States:
**AT BE BG CH CY CZ DE DK EE ES FI FR GB GR HU IE IS IT LI LT LU LV MC NL PL PT RO SE SI SK TR**

(30) Priority: **29.03.2005 JP 2005095132**

(43) Date of publication of application:
**04.10.2006 Bulletin 2006/40**

(73) Proprietor: **FUJIFILM Corporation**
**Minato-ku**
**Tokyo (JP)**

(72) Inventor: **Hotta, Yoshinori**
**Fuji Photo Film Co., Ltd.**
**Haibara-gun**
**Shizuoka (JP)**

(74) Representative: **HOFFMANN EITLE**
**Patent- und Rechtsanwälte**
**Arabellastraße 4**
**81925 München (DE)**

(56) References cited:
**EP-A- 0 316 240**
**EP-A- 1 247 644**
**EP-A- 1 503 247**
**EP-A2- 1 157 854**
**GB-A- 1 515 174**
**US-A1- 2004 013 968**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

TECHNICAL FIELD

The present invention relates to a method of manufacturing a lithographic printing plate that is capable of being developed with an acidic to weakly alkaline developer.

RELATED BACKGROUND ART

Lithographic printing plates generally comprise oleophilic image areas which are receptive to ink during the printing operation and hydrophilic non-image areas which are receptive to dampening water. Lithographic printing is a process that utilizes the mutual repellence between water and printing ink by having the oleophilic image areas of the printing plate serving as ink-receptive areas and having the hydrophilic non-image areas serving as dampening water-receptive areas (non-ink-receptive areas), thus creating differences in the ability of ink to adhere to the surface of the plate and allowing the ink to be deposited only in the image areas. The ink that has been selectively deposited on the plate is then transferred to a printing medium such as paper.

Presensitized plates comprising an oleophilic photosensitive resin layer (image recording layer) on a hydrophilic support are widely used to make such lithographic printing plates. Generally, the lithographic printing plate is obtained by a platemaking process in which the presensitized plate is exposed to light through an original on lith film, then the portions of the image recording layer in image areas are left intact, whereas the rest of the image recording layer, which is not needed, is dissolved and removed with an alkaline developer or an organic solvent, thereby revealing the surface of the hydrophilic support and forming non-image areas.

Specifically, development processes known in the art generally consist of three steps: development of the plate with an aqueous alkali solution having a pH of 10 or more, followed in turn by rinsing of the alkaline agent from the plate in a rinsing bath, then treatment with a gum solution composed primarily of a hydrophilic resin. Where necessary, the process also includes a step of adding a replenishing solution to offset a decrease in pH owing to the absorption of carbon dioxide.

Accordingly, drawbacks associated with the development processes have included the need for a large amount of space to accommodate the automatic processor itself, the generation of increased amounts of wastewater (e.g., wastewater from development, wastewater from rinsing, gum wastewater) and the need to treat such wastewater, and problems relating to the environmental impact and running costs.

Because the methods of manufacturing lithographic printing plates have thus required, following light exposure, a step in which unnecessary areas of the image recording layer are dissolved and removed with a developer, environmental and safety considerations have given rise to the question of how to carry out processing with a developer having a more neutral pH and how to reduce the amount of wastewater generated in such processing. Specifically, there is a strong desire for, among other things, greater simplicity in the processing step, the use of developers that are weakly alkaline, and compatibility with requirements for a smaller footprint and lower running costs. Recently, the need for a solution to these problems is all the more acute because the treatment of wastewater discharged in connection with wet processing has become a major issue throughout the industrial world owing to concerns over the global environment.

Addressing the above problems, the present applicant has disclosed, in JP 2002-91016 A (the term "JP XXXX-XXXXXX A" as used herein means an "unexamined published Japanese patent application"): "A method of manufacturing a lithographic printing plate, comprising imagewise exposing a photosensitive lithographic printing plate having, on an aluminum support, a photosensitive layer made of a photopolymerizable photosensitive composition containing a compound having ethylenically unsaturated double bonds, a photopolymerization initiator and a polymer binder; then developing the exposed plate with a developer which includes an inorganic alkaline agent and a polyoxyalkylene ether group-bearing nonionic surfactant and has a pH of 10.0 to 12.5 and a conductivity of 3 to 30 mS/cm."

However, in the platemaking method described in JP 2002-91016 A, development at a pH below 10.0 is impossible because the photosensitive composition includes an alkali-soluble polymer.

US 2004/0013986 A1 relates to a method of processing a lithographic printing plate employing a roughened substrate. EP 0 316 240 is directed to a bilayered phosphoric acid anodized aluminum support comprising an upper stratum and a lower stratum, the upper stratum comprising pores having an average diameter of $1.0 \times 10^{-8}$ - $7.5 \times 10^{-8}$ m. GB 1,515,175 relates to a process for treating an exposed printing plate. EP 1 503 247 A2 relates to an image-forming method and a developer.

In addition, JP 2938397 B (the term "JP XXXXXXX B" as used herein means a "Japanese patent") describes: "A method of manufacturing a lithographic printing plate, which method includes the steps of (1) imagewise exposing an image-forming element which includes (i) an image-forming layer that lies on a hydrophilic surface of a plate base and includes hydrophobic thermoplastic polymer particles which are capable of coalescing under the influence of heat and are dispersed in a hydrophilic binder, and (ii) a compound which is present in the image-forming layer or its neighboring

layer and is capable of converting light to heat; then (2) developing the resulting imagewise-exposed image-forming element by mounting the element on the printing cylinder of a printing press and feeding dampening water and/or ink to the image-forming layer while rotating the printing cylinder".

Yet, concerning the presensitized plate used in the manufacturing method described in JP 2938397 B, although the hydrophobic thermoplastic polymer particles are caused by heat to coalesce and form an image upon imagewise exposure using an infrared laser, and the exposed plate, when subsequently mounted on the cylinder of the printing press, can be developed on-press with dampening water and/or ink, the lithographic printing plate thus obtained has a very low image strength (adhesion to the support), resulting in a less than adequate press life.

In recent years, the use of digitizing technology to electronically process, store and output image information by means of computers has become very widespread, and various new image output systems adapted to such digitizing technology have come into use. Most notably, these trends have given rise to computer-to-plate (CTP) technology in which digitized image information is carried on a highly convergent beam of radiation such as laser light which is used to scan a presensitized plate through exposure, thus directly producing a lithographic printing plate without relying on the use of lith film. One major technical challenge has been addressed to obtain presensitized plates suitable for CTP technology.

DISCLOSURE OF THE INVENTION

It is therefore an object of the present invention to provide a method of manufacturing a lithographic printing plate which has a long press life and a good scumming resistance, which can be developed with an acidic to weakly alkaline developer, and which is able to reduce the amount of wastewater associated with development.

The inventor of the invention has found that this object can be achieved by subjecting a presensitized plate comprising a lithographic printing plate support having a specific grained shape at the surface and an image recording layer on the support to imagewise exposure so as to form an image, then developing the exposed plate using an aqueous solution which contains a given amount of a specific surfactant and has a pH of 2 to 10.

Accordingly, the invention provides the platemaking method to obtain a lithographic printing plate in the following aspects (1) to (9).

(1) A platemaking method to obtain a lithographic printing plate, comprising the steps of:

recording an image, by imagewise exposure, on a presensitized plate comprising a lithographic printing plate support and an image recording layer on the support, then
developing the presensitized plate on which the image has been recorded so as to obtain a lithographic printing plate;

wherein the lithographic printing plate support is an aluminum plate having an arithmetical mean roughness $R_a$ of less than 0.4 $\mu$m and having on a surface thereof a grained shape with a structure bearing recessed portions (small waves) with an average opening diameter of 0.01 to 2.0 $\mu$m, and the developing step is carried out using an aqueous solution which contains at least 1 wt% of a nonionic surfactant and/or an anionic surfactant and has a pH of 2 to 10.

(2) The platemaking method of (1) above, wherein the aqueous solution used in the developing step contains a water-soluble polymeric compound.

(3) The platemaking method of (1) or (2) above, wherein the anionic surfactant has a sulfonate anionic group or a sulfate monoester anionic group, and has additionally an aromatic group which may have a substituent.

(4) The platemaking method of any one of (1) to (3) above, wherein the nonionic surfactant is a nonionic aromatic ether surfactant of the formula (1) below

$$X\text{-}Y\text{-}O\text{-}(A)_n\text{-}(B)_m\text{-}H \qquad (1)$$

where X is an aromatic group which may have a substituent; Y is a single bond or an alkylene group of 1 to 10 carbon atoms; A and B, which mutually differ, are $-CH_2CH_2O-$ or $-CH_2CH(CH_3)O-$; and n and m are both integers from 0 to 100, with the proviso that $n+m \geq 2$.

(5) The platemaking method of any one of (1) to (4) above, wherein the image recording layer contains a polymerization initiator, a polymerizable compound, and a hydrophobic binder polymer.

(6) The platemaking method of any one of (1) to (5) above, wherein the presensitized plate additionally has a protective layer on the image recording layer.

(7) The platemaking method of any one of (1) to (6) above, wherein a laser which emits light at a wavelength of 760 to 1200 nm is used in the imagewise exposure.

(8) The platemaking method of any one of (1) to (6) above, wherein a laser which emits light at a wavelength of 250

to 420 nm is used in the imagewise exposure.

(9) The platemaking method of any one of (1) to (8) above, wherein some or all of ingredients which form the image recording layer are encapsulated in microcapsules.

The invention provides a platemaking method to obtain a lithographic printing plate which has a long press life and a good scumming resistance, which can be developed with an acidic to weakly alkaline developer, and which enables the amount of wastewater associated with development to be reduced.

Accordingly, the invention is highly useful from the standpoint of the environment and safety. Moreover, the developer employed is not degraded by carbon dioxide and always has a uniform developing ability, enabling printing plates of a uniform quality to be manufactured.

BRIEF DESCRIPTION OF THE DRAWINGS

In the accompanying drawings:

FIG. 1 is a graph showing an example of an alternating current waveform that may be used in electrochemical graining treatment during the manufacture of a lithographic printing plate support;

FIG. 2 is a side view showing an example of a radial electrolytic cell that is used in electrochemical graining treatment with alternating current during the manufacture of a lithographic printing plate support;

FIG. 3 is a schematic cross-sectional view of an apparatus which carries out rinsing with a free-falling curtain of water that is used for rinsing during the manufacture of a lithographic printing plate support;

FIG. 4 is a schematic side view of a mechanical graining treatment step during the manufacture of a lithographic printing plate support; and

FIG. 5 is a schematic cross-sectional view of the processor used in the developing step in the examples described in the specification.

DESCRIPTION OF THE PREFERRED EMBODIMENTS

The inventive method of manufacturing lithographic printing plates (referred to below as "the inventive platemaking method") includes the steps of recording an image, by imagewise exposure, on a presensitized plate comprising a lithographic printing plate support and an image recording layer formed on the support; then developing the presensitized plate on which the image has been recorded so as to obtain a lithographic printing plate. The lithographic printing plate support has an arithmetical mean roughness $R_a$ of less than 0.4 μm and has on a surface thereof a grained shape with a structure bearing recessed portions with an average opening diameter of 0.01 to 2.0 μm. The developing step is carried out using an aqueous solution which contains at least 1 wt% of a nonionic surfactant and/or an anionic surfactant and has a pH of 2 to 10.

The presensitized plate (particularly the lithographic printing plate support and the image recording layer) used in the inventive platemaking method as well as the image recording step (particularly imagewise exposure) and the developing step (particularly the developer) is described in detail below.

[Presensitized Plate]

The presensitized plate used in the inventive platemaking method comprises a lithographic printing plate support having thereon an image recording layer on which an image is recorded by imagewise exposure. In addition, if necessary, a protective layer may be provided on the image recording layer. The components (e.g., lithographic printing plate support, image recording layer, protective layer) and ingredients making up the presensitized plate are described below.

<Lithographic Printing Plate Support>

The lithographic printing plate support used in the inventive platemaking method is an aluminum plate having an arithmetical mean roughness $R_a$ of less than 0.4 μm and has on a surface thereof a grained shape with a structure bearing recessed portions with an average opening diameter of 0.01 to 2.0 μm. A dimensionally stable plate-type hydrophilic support will suffice.

In the lithographic printing plate support, an arithmetical mean roughness $R_a$ within the above-indicated range is essential because it provides the lithographic printing plate with a good scumming resistance, and an average opening diameter within the above-indicated range is essential because it provides the printing plate with a long press life. The most likely reason is that, even though the arithmetical mean roughness $R_a$ is made small in this way to achieve a good scumming resistance, the support having recessed portions with an average opening diameter of 0.01 to 2.0 μm enables

enhancement of the adhesion to the subsequently described image recording layer that is removable with a developer, thus enhancing the press life.

In the practice of the invention, to further enhance the press life and scumming resistance, the arithmetical mean roughness $R_a$ of the lithographic printing plate support is preferably from 0.25 to 0.35 $\mu$m and the average opening diameter is preferably from 0.05 to 2.0 $\mu$m, and more preferably from 0.1 to 0.5 $\mu$m.

In the invention, to further improve the adhesion between the surface of the lithographic printing plate support and the image recording layer, it is preferable for the support to have recessed portions with a depth which is greater than the opening diameter. Specifically, the ratio of the depth to the opening diameter (depth/opening diameter) is preferably at least 0.1, more preferably at least 0.2, and most preferably from 0.4 to 0.6.

In the practice of the invention, the method used to measure the arithmetical mean roughness $R_a$ at the surface of the lithographic printing plate support is as follows:

Two-dimensional roughness measurement is carried out using a stylus-type roughness tester (e.g., Surfcom 575, manufactured by Tokyo Seimitsu Co., Ltd.), the mean roughness as defined in ISO 4287 is measured five times, and the average of the five resulting values is treated as the arithmetical mean roughness $R_a$.

The conditions when measuring the two-dimensional roughness are as follows: cutoff value, 0.8 mm; slope correction, FLAT-ML; measurement length, 3 mm; longitudinal magnification, 10,000X; scan rate, 0.3 mm/s; stylus tip diameter, 2 $\mu$m.

In the practice of the invention, the average opening diameter is determined by using an electron microscope to obtain a direct overhead image of the support surface at a magnification of 2,000X, selecting at least 50 pits having a medium wave structure (medium-wave pits) with continuous ring-like edges in the resulting electron micrograph, reading off the diameter of each pit as an opening diameter, and computing the average of these values.

To minimize the variability of measurement, equivalent circle diameter measurement can also be carried out using commercially available image analysis software. In this case, the above electron micrographs are scanned and digitized, then converted to binary values with the software, following which the equivalent circle diameters are determined.

The inventor carried out measurement of the average opening diameter and obtained substantially the same results from both visual measurement and digital processing. Aluminum plate as lithographic printing plate support is chosen for its good dimensional stability and relatively low cost.

The aluminum plate may be a pure aluminum plate, an alloy plate composed primarily of aluminum and containing small amounts of other elements, or a thin film of aluminum or aluminum alloy onto which plastic has been laminated. Other elements which may be present in the aluminum alloy include silicon, iron, manganese, copper, magnesium, chromium, zinc, bismuth, nickel and titanium. The content of other elements in the alloy is preferably not more than 10 wt%.

In the practice of the invention, the use of a pure aluminum plate is preferred. However, because completely pure aluminum is difficult to manufacture for reasons having to do with refining technology, the presence of small amounts of other elements is also acceptable. Aluminum plates suitable for use in the invention are not specified here as to composition, but include known materials that are used in the art.

The lithographic printing plate support used in the inventive platemaking method has a thickness of preferably 0.1 to 0.6 mm, more preferably 0.15 to 0.4 mm, and even more preferably 0.2 to 0.3 mm. This thickness can be changed as appropriate based on such considerations as the size of the printing press, the size of the printing plate and the desires of the user.

The lithographic printing plate support used in the inventive platemaking method can be surface-treated or coated with finely divided particles so as to impart an arithmetical mean roughness $R_a$ of less than 0.4 $\mu$m and to form on the surface thereof a grained shape with a structure bearing recessed portions with an average opening diameter of 0.01 to 2.0 $\mu$m.

The surface treatment typically carried out when the above-described aluminum plate serves as the support is described below.

Prior to use, the aluminum plate is preferably subjected to surface treatments such as graining treatment and anodizing treatment. The surface treatments improve the hydrophilic properties and easily ensure good adhesion between the image recording layer and the support.

Before the aluminum plate is subjected to graining treatment, the surface may be degreased if desired with a surfactant, organic solvent, alkaline aqueous solution to remove rolling oils from the surface.

Graining treatment of the aluminum plate surface may be carried out by various methods, such as mechanical graining, electrochemical graining (in which the surface is electrochemically dissolved) and chemical graining (in which the surface is selectively dissolved chemically).

Known methods of mechanical graining may be used, such as ball graining, brush graining, blast finishing or buffing.

Suitable methods for electrochemical graining include methods carried out with alternating current or direct

current in an electrolytic solution containing an acid such as hydrochloric aid or nitric acid. Also suitable is a method using a mixed acid, as described in JP 54-63902 A. Specifically, a method which involves first electrochemical graining treatment, first etching treatment, first desmutting treatment, second electrochemical graining treatment, second etching treatment and second desmutting treatment described below is preferred.

(First electrochemical graining treatment)

In the first electrochemical graining treatment, electrochemical graining is carried out by passing an alternating current through the aluminum plate in an acid-containing aqueous solution. The acid added to the aqueous solution is preferably nitric acid. By carrying out the first electrochemical graining treatment using a nitric acid-containing aqueous solution (nitric acid electrolytic graining treatment), pits having an average opening diameter of 0.5 to 2μ m are formed on the surface of the aluminum plate.

The nitric acid concentration in the aqueous solution is preferably from 1 to 100 g/L. Within this range, the pits will have a good uniformity.

The aqueous solution has a temperature of preferably 20 to 80˚C, and more preferably 30 to 60˚C. At a temperature of at least 20˚C, the cost of running a refrigerating unit for cooling is reduced to a modest level and the amount of ground water used for cooling can be minimized. At a temperature of not more than 80˚C, the corrosion resistance of the equipment is readily ensured.

The aqueous solution can be used after adding thereto a nitrate ion-containing compound, such as aluminum nitrate, sodium nitrate or ammonium nitrate, or a chloride ion-containing compound, such as aluminum chloride, sodium chloride or ammonium chloride. Metals which are present in the aluminum alloy may be dissolved in the aqueous solution, as exemplified by iron, copper, manganese, nickel, titanium, magnesium and silicon. From 1 to 100 g/L of hypochlorous acid or hydrogen peroxide may also be added.

A compound such as aluminum chloride or aluminum nitrate is preferably added to the aqueous solution to an aluminum ion concentration of 3 to 50 g/L. At an aluminum ion concentration in the above range, the pit uniformity is improved and the replenishment amount of the aqueous solution is not increased too much.

Moreover, by adding and using a compound capable of forming a complex with copper, uniform graining treatment may be carried out even on an aluminum plate having a high copper content. Compounds capable of forming a complex with copper include ammonia; amines obtained by substituting a hydrogen atom on ammonia with an (aliphatic or aromatic) hydrocarbon group, such as methylamine, ethylamine, dimethylamine, diethylamine, trimethylamine, cyclohexylamine, triethanolamine, triisopropanolamine and ethylenediaminetetraacetic acid (EDTA); and metal carbonates such as sodium carbonate, potassium carbonate and potassium hydrogencarbonate. Additional compounds suitable for this purpose include ammonium salts such as ammonium nitrate, ammonium chloride, ammonium sulfate, ammonium phosphate and ammonium carbonate. The solution has a temperature of preferably 10 to 60˚C, and more preferably 20 to 50˚C.

The concentrations of the respective ingredients in the aqueous solution are preferably controlled using a multi-component concentration measurement process, in combination with feedforward control and feedback control. In this way, precise concentration control of the aqueous solution used as the electrolytic solution is possible.

Illustrative examples of the multi-component concentration measurement process include a process in which the concentrations are measured using the ultrasonic wave propagation velocity in the aqueous solution and the electrical conductivity of the electrolytic solution, neutralization titration, capillary electrophoretic analysis, isotachophoretic analysis, and ion chromatography.

Ion chromatography is classified according to the type of detector as, for example, ion chromatography for absorbance detection, non-suppressed ion chromatography for conductometric detection, and suppressed ion chromatography. Of these, suppressed ion chromatography is preferable for ensuring the stability of measurement.

The first electrochemical graining treatment may be carried out in accordance with, for example, the electrochemical graining processes (electrolytic graining processes) described in JP 48-28123 B ("JP XX-XXXXXX B" as used herein means an "examined published Japanese patent publication") and GB 896,563 B. These electrolytic graining processes use an alternating current having a sinusoidal waveform, but they may also be carried out using special waveforms like those described in JP 52-58602 A. Use can also be made of the waveforms described in JP 3-79799 A. Other processes that may be employed for this purpose include those described in JP 55-158298 A, JP 56-28898 A, JP 52-58602 A, JP 52-152302 A, JP 54-85802 A, JP 60-190392 A, JP 58-120531 A, JP 63-176187 A, JP 1-5889 A, JP 1-280590 A, JP 1-118489 A, JP 1-148592 A, JP 1-178496 A, JP 1-188315 A, JP 1-154797 A, JP 2-235794 A, JP 3-260100 A, JP 3-253600 A, JP 4-72079 A, JP 4-72098 A, JP 3-267400 A and JP 1-141094 A. In addition to the above, electrolytic treatment can also be carried out using alternating currents of special frequency such as have been proposed in connection with methods for manufacturing electrolytic capacitors. These are described in, for example, US 4,276,129 and US 4,676,879.

Various electrolytic cells and power supplies have been proposed for use in electrolytic treatment. For example,

use may be made of those described in US 4,203,637, JP 56-123400 A, JP 57-59770 A, JP 53-12738 A, JP 53-32821 A, JP 53-32822 A, JP 53-32823 A, JP 55-122896 A, JP 55-132884 A, JP 62-127500 A, JP 1-52100 A, JP 1-52098 A, JP 60-67700 A, JP 1-230800 A, JP 3-257199 A, JP 52-58602 A, JP 52-152302 A, JP 53-12738 A, JP 53-12739 A, JP 53-32821 A, JP 53-32822 A, JP 53-32833 A, JP 53-32824 A, JP 53-32825 A, JP 54-85802 A, JP 55-122896 A, JP 55-132884 A, JP 48-28123 B, JP 51-7081 B, JP 52-133838 A, JP 52-133840 A, JP 52-133844 A, JP 52-133845 A, JP 53-149135 A and JP 54-146234 A.

The power supply may be, for example, one which uses commercial AC power or may be an inverter-controlled power supply. Of these, an inverter-controlled power supply which uses an insulated gate bipolar transistor (IGBT) is preferred because of its excellent load-following ability when carrying out control to keep the current value (current density of aluminum plate) constant in response to such factors as the width and thickness of the aluminum plate and fluctuations in the concentrations of ingredients in the electrolytic solution.

No particular limitation is imposed on the waveform of the alternating current used in the first electrochemical graining treatment. For example, a sinusoidal, square, trapezoidal or triangular waveform may be used. "Trapezoidal waveform" refers herein to a waveform like that shown in FIG. 1.

The amount of electricity in the first electrochemical graining treatment is preferably in the range of 1 to 1000 $C/dm^2$ and more preferably 50 to 300 $C/dm^2$ in terms of the total amount of electricity when the aluminum plate serves as an anode. The current density is preferably 10 to 100 $A/dm^2$. At a current density of at least 10 $A/dm^2$, the productivity is enhanced. At a current density of not more than 100 $A/dm^2$, the voltage is not so high and the power capacity is not increased so much, which may lead to the reduction of the power supply cost.

FIG. 2 is a side view of a radial electrolytic cell that is used to carry out electrochemical graining treatment using alternating current during the manufacture of a lithographic printing plate support in the present invention.

One or more AC power supplies may be connected to the electrolytic cell. To control the anode/cathode current ratio of the alternating current applied to the aluminum plate opposite to the main electrodes and thereby carry out uniform graining and to dissolve carbon from the main electrodes, it is advantageous to provide an auxiliary anode and divert some of the alternating current as shown in FIG. 2. FIG. 2 shows an aluminum plate 11, a radial drum roller 12, main electrodes 13a and 13b, an electrolytic treatment solution 14, a solution feed inlet 15, a slit 16, a solution channel 17, an auxiliary anode 18, thyristors 19a and 19b, an AC power supply 20, a main electrolytic cell 40 and an auxiliary anode cell 50. By using a rectifying or switching device to divert some of the current as direct current to the auxiliary anode provided in the separate cell from that containing the two main electrodes, it is possible to control the ratio between the current value furnished for the anodic reaction which acts on the aluminum plate opposite to the main electrodes and the current value furnished for the cathodic reaction. The current ratio (ratio between the total amount of electricity when the aluminum plate serves as an anode and the total amount of electricity when the aluminum plate serves as an cathode) is preferably 0.9 to 3 and more preferably 0.9 to 1.0.

Any known electrolytic cell employed for surface treatment, including vertical, flat and radial type electrolytic cells, may be used to carry out electrochemical graining treatment. Radial-type electrolytic cells such as those described in JP 5-195300 A are especially preferred. The electrolytic solution is passed through the electrolytic cell either parallel or counter to the direction in which the aluminum web advances.

Following completion of the first electrochemical graining treatment, it is desirable to remove the solution from the aluminum plate with nip rollers, rinse the plate with water for 1 to 10 seconds, then remove the water with nip rollers.

Rinsing treatment is preferably carried out using a spray line. The spray line used in rinsing treatment is typically one having a plurality of spray tips, each of which discharges a fan-like spray of water and is situated along the width of the aluminum plate. The interval between the spray tips is preferably 20 to 100 mm, and the amount of water discharged per spray tip is preferably 1 to 20 L/min. Rinsing with a plurality of spray lines is preferred.

(First etching treatment)

The purpose of the first etching treatment carried out between the first electrochemical graining treatment and the second electrochemical graining treatment is to dissolve smut that arises in the first electrochemical graining treatment by bringing it into contact with the aqueous alkali solution, and to dissolve the edges of the pits formed by the first electrochemical graining treatment by bringing them into contact with the aqueous alkali solution. The present step dissolves the edges of the large pits formed by the first electrochemical graining treatment, smoothing the surface and discouraging ink from catching on such edges. As a result, presensitized plates of excellent scumming resistance can be obtained.

In the first etching treatment, the amount of material removed by etching (also referred to below as the "etching amount") is preferably from 0.1 to 10 $g/m^2$, and more preferably from 0.1 to 5 $g/m^2$. In an etching amount falling within this range, the diameter of the pits formed in the first electrochemical graining treatment can be maintained within the desired range.

Alkalis that may be used in the aqueous alkali solution are exemplified by caustic alkalis and alkali metal salts.

Specific examples of suitable caustic alkalis include sodium hydroxide and potassium hydroxide. Specific examples of suitable alkali metal salts include alkali metal silicates such as sodium metasilicate, sodium silicate, potassium metasilicate and potassium silicate; alkali metal carbonates such as sodium carbonate and potassium carbonate; alkali metal aluminates such as sodium aluminate and potassium aluminate; alkali metal aldonates such as sodium gluconate and potassium gluconate; and alkali metal hydrogenphosphates such as sodium secondary phosphate, potassium secondary phosphate, sodium primary phosphate and potassium primary phosphate. Of these, caustic alkali solutions and solutions containing both a caustic alkali and an alkali metal aluminate are preferred on account of the high etch rate and low cost. An aqueous solution of sodium hydroxide is especially preferred.

In the first etching treatment, the aqueous alkali solution has preferably a concentration of 1 to 50 wt% and more preferably 10 to 35 wt%.

It is preferable for the aqueous alkali solution to contain aluminum ions. The aluminum ion concentration is preferably 0.01 to 10 wt% and more preferably 3 to 8 wt%.

The aqueous alkali solution temperature is preferably 20 to 90˚C. The treatment time is preferably 1 to 120 seconds.

Illustrative examples of methods for bringing the aluminum plate after first electrochemical graining treatment into contact with the aqueous alkali solution include a method in which the aluminum plate is passed through a tank filled with an aqueous alkali solution, a method in which the aluminum plate is immersed in a tank filled with an aqueous alkali solution, and a method in which the surface of the aluminum plate is sprayed with an aqueous alkali solution.

The most desirable of these is a method that involves spraying the surface of the aluminum plate with an aqueous alkali solution. A method in which the etching solution is sprayed onto the aluminum plate at a rate of 10 to 100 L/min per spray line from preferably a plurality of spray lines bearing 2 to 5 mm diameter openings at a pitch of 10 to 50 mm is especially desirable.

Following the completion of etching treatment with the aqueous alkali solution, it is desirable to remove the etching solution from the aluminum plate with nip rollers, subject the plate to rinsing treatment with water for 1 to 10 seconds, then remove the water with nip rollers.

Rinsing treatment is preferably carried out by rinsing with a rinsing apparatus that uses a free-falling curtain of water and also by rinsing with spray lines.

FIG. 3 is a schematic cross-sectional view of an apparatus 100 which carries out rinsing with a free-falling curtain of water. As shown in FIG. 3, the apparatus 100 that carries out rinsing treatment with a free-falling curtain of water has a water holding tank 104 that holds water 102, a pipe 106 that feeds water to the water holding tank 104, and a flow distributor 108 that supplies a free-falling curtain of water from the water holding tank 104 to an aluminum plate 1.

In this apparatus 100, the pipe 106 feeds water 102 to the water holding tank 104. When the water 102 in the water holding tank 104 overflows, it is distributed by the flow distributor 108 and the free-falling curtain of water is supplied to the aluminum plate 1. A flow rate of 10 to 100 L/min is preferred when this apparatus 100 is used. The distance L over which the water 102 between the apparatus 100 and the aluminum plate 1 exists as a free-falling curtain of liquid is preferably from 20 to 50 mm. Moreover, it is preferable for the aluminum plate to be inclined at an angle $\alpha$ to the horizontal of 30 to 80˚.

By using an apparatus like that in FIG. 3 which rinses the aluminum plate with a free-falling curtain of water, the aluminum plate can be uniformly rinsed. This in turn makes it possible to enhance the uniformity of treatment carried out prior to rinsing.

A preferred example of an apparatus that carries out rinsing treatment with a free-falling curtain of water is described in JP 2003-96584 A.

Alternatively, rinsing may be carried out with a spray line having a plurality of spray tips that discharge fan-like sprays of water and are disposed along the width of the aluminum plate. The interval between the spray tips is preferably 20 to 100 mm, and the amount of water discharged per spray tip is preferably 0.5 to 20 L/min. The use of a plurality of spray lines is preferred.

(First desmutting treatment)

After the first etching treatment, it is preferable to carry out acid pickling (first desmutting treatment) to remove contaminants (smut) remaining on the surface of the aluminum plate. Desmutting treatment is carried out by bringing an aqueous acid solution into contact with the aluminum plate.

Examples of acids that may be used include nitric acid, sulfuric acid, hydrochloric acid, chromic acid, phosphoric acid, hydrofluoric acid and fluoroboric acid. More specifically, wastewater from the aqueous sulfuric acid solution used in the anodizing treatment step to be described later, wastewater from the aqueous nitric acid solution used in the first electrochemical graining treatment, and wastewater from the aqueous hydrochloric acid solution used in the second electrochemical graining treatment can be preferably used.

In the first desmutting treatment, it is preferable to use an acidic solution containing 0.5 to 30 wt% of an acid

and 0.5 to 10 wt% of aluminum ions. The first desmutting treatment is carried out by bringing the aluminum plate after the first etching treatment into contact with an acidic solution containing 0.5 to 30 wt% of an acid such as hydrochloric acid, nitric acid or sulfuric acid (and 0.01 to 5 wt% of aluminum ions).

In the first desmutting treatment, the temperature of the acidic solution is preferably 25˚C to 90˚C and the treatment time is preferably 1 to 180 seconds.

Illustrative examples of the method of bringing the aluminum plate after the first etching treatment into contact with the acidic solution include passing the aluminum plate through a tank filled with the acidic solution, immersing the aluminum plate in a tank filled with the acidic solution, and spraying the acidic solution onto the surface of the aluminum plate.

Of these, a method in which the acidic solution is sprayed onto the surface of the aluminum plate is preferred. More specifically, a method in which the acidic solution is sprayed from at least one spray line, and preferably two or more spray lines, each having 2 to 5 mm diameter openings spaced at a pitch of 10 to 50 mm, at a rate of 10 to 100 L/min per spray line is desirable.

After desmutting treatment, it is preferable to remove the solution with nip rollers, then to carry out rinsing treatment with water for 1 to 10 seconds and again remove the water with nip rollers.

Rinsing treatment is the same as rinsing treatment following etching treatment with an aqueous alkali solution. However, it is preferable for the amount of water used per spray tip to be from 1 to 20 L/min.

(Second electrochemical graining treatment)

In the second electrochemical graining treatment, an alternating current is passed through the aluminum plate in an acid-containing aqueous solution for electrochemical graining treatment. The acid to be added to the aqueous solution is preferably hydrochloric acid. The second electrochemical graining treatment using an aqueous solution containing hydrochloric acid (electrolytic graining treatment with hydrochloric acid) is capable of obtaining the aluminum plate on the surface of which pits having an average opening diameter of 0.01 to 0.2 $\mu$m are formed.

The second electrochemical graining treatment is basically the same as the first electrochemical graining treatment. Different points from the first electrochemical graining treatment will be mainly described below.

The aqueous solution has preferably a hydrochloric acid concentration of 1 to 100 g/L. When the concentration falls within the above range, uniformity of the pits formed on the surface of the aluminum plate is enhanced.

The aqueous solution contains preferably 0.05 to 10 g/L of sulfuric acid or nitric acid. Sulfuric acid and nitric acid form an oxide film through an anodic reaction. The surface having uniform asperities can be thus formed.

The aluminum ion concentration in the aqueous solution is preferably 3 to 50 g/L. When the aluminum ion concentration falls within the above range, uniformity of the pits formed is enhanced and the replenishment amount of the aqueous solution is not increased too much.

No particular limitation is imposed on the AC power supply waveform used in the second electrochemical graining treatment. For example, a sinusoidal, square, trapezoidal or triangular waveform may be used.

The amount of electricity in the second electrochemical graining treatment is preferably at least 20 C/dm$^2$, more preferably 20 to 100 C/dm$^2$ and even more preferably 30 to 70 C/dm$^2$ in terms of the total amount of electricity when the aluminum plate serves as an anode.

In an amount of electricity within the above range, it is easy to obtain a surface area ratio $\Delta S^{5(0.02\text{-}0.2)}$ in the lithographic printing plate support of from 50 to 90% and an arithmetical mean roughness $R_a$ on the surface of 0.35 $\mu$m or less, thus facilitating the production of a lithographic printing plate having a long press life and good scumming resistance.

In the present specification, $\Delta S^{5(0.02\text{-}0.2)}$ is determined by the formula:

$$\Delta S^{5(0.02-0.2)}\ (\%) = [(S_x^{5(0.02-0.2)} - S_0^5)/S_0^5] \times 100$$

wherein, $S_x^{5(0.02\text{-}0.2)}$ is the actual surface area of a 5 $\mu$m square surface region as determined by three-point approximation based on data obtained by extracting 0.02 to 0.2 $\mu$m wavelength components from three-dimensional data on the surface region measured with an atomic force microscope at 512 x 512 points and $S_0^5$ is the geometrically measured surface area of the same 5 $\mu$m square surface region.

(Second etching treatment)

The purpose of the second etching treatment carried out after the second electrochemical graining treatment is to dissolve smut that arises in the second electrochemical graining treatment and to dissolve the edges of the pits

formed by the second electrochemical graining treatment.

The second etching treatment is basically the same as the first etching treatment. The etching amount is preferably 0.01 to 0.08 g/m$^2$, more preferably 0.02 to 0.06 g/m$^2$, and even more preferably 0.03 to 0.05 g/m$^2$.

In an etching amount falling within the above range, it is easy to obtain a surface area ratio $\Delta S^{5(0.02-0.2)}$ of from 50 to 90% and a surface arithmetical mean roughness $R_a$ of less than 0.4 $\mu$m, thus facilitating the production of a lithographic printing plate having a long press life and good scumming resistance.

(Second desmutting treatment)

After the second etching treatment has been carried out, it is preferable to carry out acid pickling (second desmutting treatment) to remove contaminants (smut) remaining on the surface of the aluminum plate. The second desmutting treatment can be carried out basically in the same way as the first desmutting treatment.

When the same type of the electrolytic solution as that used in the subsequent anodizing treatment is used for the desmutting solution in the second desmutting treatment, solution removal with nip rollers and rinsing with water that are to be carried out after the desmutting treatment can be omitted.

The second desmutting treatment is preferably carried out in an electrolytic cell of an anodizing apparatus used in anodizing treatment to be described later where the aluminum plate is to be subjected to cathodic reaction. This configuration eliminates the necessity for providing an independent desmutting bath for the second desmutting treatment, which may lead to equipment cost reduction.

The aluminum plate that has been grained may optionally be subjected to anodizing treatment to enhance the wear resistance.

Various electrolytes capable of forming a porous anodized layer may be used in anodizing treatment of the aluminum plate. Generally, sulfuric acid, hydrochloric acid, phosphoric acid, oxalic acid, chromic acid, sulfamic acid, benzenesulfonic acid and amidosulfonic acid may be used singly or in combination of two or more thereof. The concentrations of these electrolytes are determined as appropriate according to the type of electrolyte.

The anodizing treatment conditions vary empirically according to the electrolyte used, although it is generally suitable for the solution to have an electrolyte concentration of 1 to 80 wt% and a temperature of 5 to 70°C, and for the current density to be 5 to 60 A/dm$^2$, the voltage to be 1 to 100 V, and the electrolysis time to be 10 seconds to 5 minutes.

The weight of the anodized layer formed is preferably 1.0 to 5.0 g/m$^2$ and more preferably 1.5 to 4.0 g/m$^2$. When the weight is less than 1 g/m$^2$, scratches are readily formed on the plate. A weight of 5 g/m$^2$ or more requires a large amount of electric power, which is economically disadvantageous. An anodized layer weight of 1.5 to 4 g/m$^2$ is more preferred. It is also desirable for anodizing treatment to be carried out in such a way that the difference in the anodized layer weight between the center of the aluminum plate and the areas near the edges is not more than 1 g/m$^2$.

To further improve the properties of the lithographic printing plate support used in the inventive platemaking method, a treatment for enlarging micropores of the anodized layer, a treatment for sealing the micropores of the anodized layer, and a surface hydrophilizing treatment in which the support is immersed in an aqueous solution containing a hydrophilic compound as described in JP 2001-253181 A and JP 2001-322365 A are preferably carried out as needed in terms of adhesion to the image recording layer to be described later, hydrophilic properties, scumming resistance and heat insulating properties.

Illustrative examples of sealing methods that may used include steam sealing, sealing treatment with an aqueous solution containing an inorganic fluorine compound (e.g., treatment with hexafluorozirconic acid alone, treatment with sodium fluoride), steam sealing which involves the addition of lithium chloride, and sealing treatment with hot water.

Of these, sealing treatment with an aqueous solution containing an inorganic fluorine compound, sealing treatment with steam, and sealing treatment with hot water are preferred.

Suitable hydrophilizing treatments include alkali metal silicate processes as described in US 2,714,066, US 3,181,461, US 3,280,734 and US 3,902,734. In these alkali metal silicate processes, the support is subjected to immersion or electrolytic treatment in an aqueous solution of, for example, sodium silicate.

Other types of hydrophilizing treatment include treatment with potassium hexafluorozirconate described in JP 36-22063 B, and treatment with polyvinylphosphonic acid described in US 3,276,868, US 4,153,461 and 4,689,272.

If a support having a surface of insufficient hydrophilicity, such as a polyester film, is used as the lithographic printing plate support, it is desirable to apply a hydrophilic layer onto the support so as to render the surface hydrophilic.

Suitable examples of the hydrophilic layer include hydrophilic layers obtained by applying a coating fluid containing a colloid of an oxide or hydroxide of at least one element selected from the group consisting of beryllium, magnesium, aluminum, silicon, titanium, boron, germanium, tin, zirconium, iron, vanadium, antimony and transition metals, as described in JP 2001-199175 A; hydrophilic layers having an organic hydrophilic matrix obtained by crosslinking or pseudo-crosslinking an organic hydrophilic polymer, as described in JP 2002-79772 A; hydrophilic layers having an inorganic hydrophilic matrix obtained by a sol-gel transition consisting of the hydrolysis of a polyalkoxysilane, titanate, zirconate or aluminate, and a condensation reaction; and hydrophilic layers composed of inorganic thin films having a

metal oxide-containing surface.

Of these, a hydrophilic layer obtained by applying a coating fluid containing a colloid of an oxide or hydroxide of silicon is preferred.

When a polyester film is used, it is preferable to provide an antistatic layer on the hydrophilic layer side of the lithographic printing layer support, on the opposite side, or on both sides thereof. In particular, providing an antistatic layer between the lithographic printing plate support and the hydrophilic layer is more preferred because it also helps to enhance adhesion between the lithographic printing plate support and the hydrophilic layer.

Specific antistatic layers of this type which may be used include the polymer layer containing a finely divided metal oxide or a flatting agent dispersed therein which is described in JP 2002-79772 A.

The lithographic printing plate support obtained by such surface treatment has a color density, given as the reflection density, of preferably 0.15 to 0.65. At a reflection density within this range, there can be obtained both a good image-forming ability due to an anti-halation effect during imagewise exposure, and good image visibility following development.

<Image Recording Layer>

The image recording layer of the presensitized plate used in the platemaking method of the invention is not subject to any particular limitation, provided it is a hydrophilic image recording layer on which an image can be recorded by the subsequently described imagewise exposure and which can be developed using the subsequently described developer.

To facilitate development and provide a long press life, it is preferable for such an image recording layer to include a polymerization initiator, a polymerizable compound and a hydrophobic binder polymer. The polymerization initiator, polymerizable compound and hydrophobic binder polymer are described below.

(Polymerization Initiator)

Polymerization initiators which may be used in the invention are compounds that generate a radical or an acid under light or heat energy, and initiate or promote the polymerization of a compound having a polymerizable unsaturated group.

Such polymerization initiators may be suitably selected from among known radical generators, acid generators, and compounds having a small bond dissociation energy.

Compounds which generate a radical or an acid include organic halogen compounds, carbonyl compounds, organic peroxides, azo compounds, azide compounds, metallocene compounds, hexaarylbiimidazole compounds, organic boron compounds, disulfone compounds, oxime ester compounds and onium salt compounds.

Organic halogen compounds that may be used include those mentioned in, for example, Wakabayashi et al.: Bull. Chem. Soc. Japan 42, 2924 (1969), US 3,905,815, JP 46-4605 B, JP 48-36281 A, JP 53-133428 A, JP 55-32070 A, JP 60-239736 A, JP 61-169835 A, JP 61-169837 A, JP 62-58241 A, JP 62-212401 A, JP 63-70243 A, JP 63-298339 A, and M.P. Hutt: Journal of Heterocyclic Chemistry 1, No. 3 (1970).

Specifically, the use of oxazole compounds and s-triazine compounds substituted with a trihalomethyl group is preferred. The use of s-triazine derivatives having at least one mono-, di- or trihalogenated methyl group attached to the s-triazine ring, and oxadiazole derivatives having at least one such group attached to the oxadiazole ring is more preferred.

Compounds that may be used include, more specifically, 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and the following compounds.

(I)-1

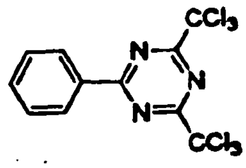

(I)-2

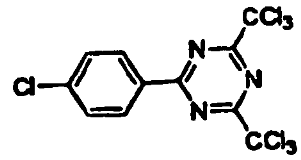

(I)-3

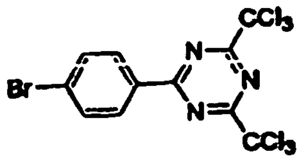

(I)-4

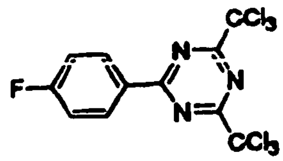

(I)-5

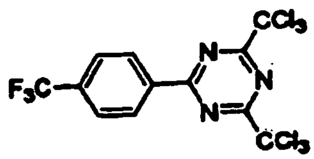

(I)-6

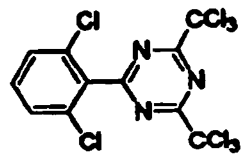

(I)-7

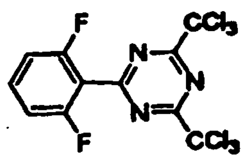

(I)-8

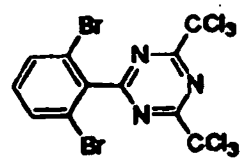

(I)-9

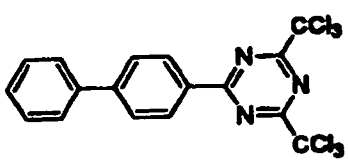

(I)-10

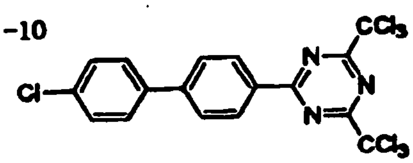

(I)-11

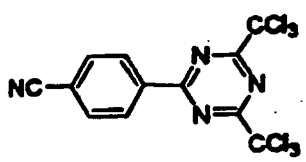

(I)-12

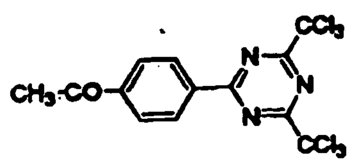

(I)-13

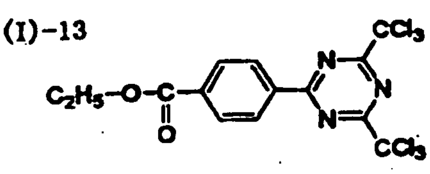

(I)-14

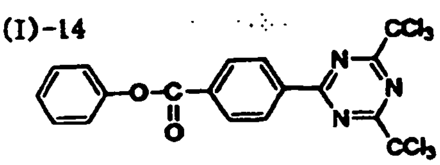

(I)-15

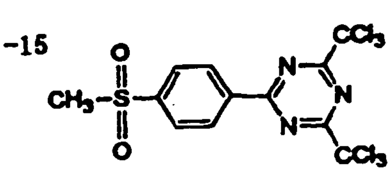

(I)-16

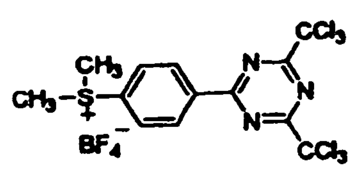

(I)-17

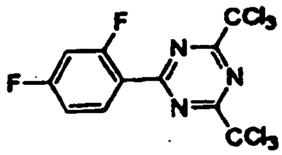

(I)-18

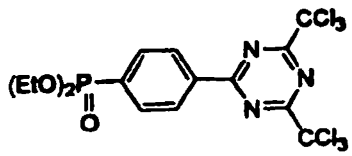

(I)-19

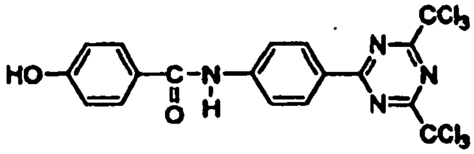

(I)-20

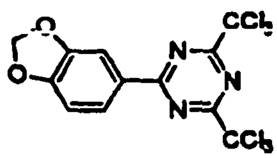

(I)-21

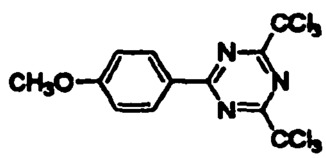

(I)-22

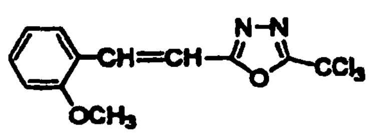

(I)-23

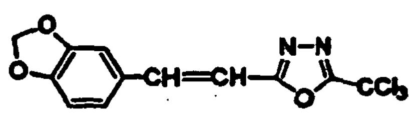

(I)-24

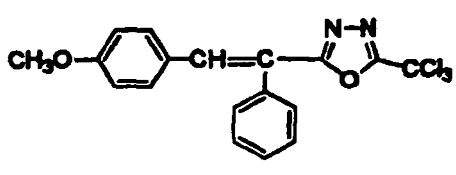

(I)-25

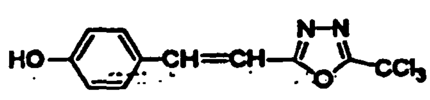

(I)-26

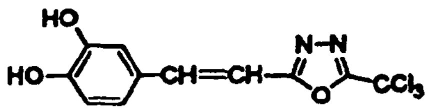

(I)-27

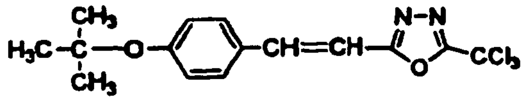

Specific examples of carbonyl compounds that may be used include benzophenone and benzophenone derivatives such as Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1-hydroxycyclohexyl phenyl ketone, α-hydroxy-2-methyl phenyl propanone, 1-hydroxy-1-methylethyl-(p-isopropylphenyl) ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxanthone and thioxanthone derivatives such as 2-ethylthioxanthone, 2-isopropylthioxanthone, 2-chlorothioxanthone, 2,4-dimethylthioxanthone, 2,4-diethylthioxanthone and 2,4-diisopropylthioxanthone; and benzoic acid ester derivatives such as ethyl p-dimethylaminobenzoate and ethyl p-diethylaminobenzoate.

Examples of azo compounds that may be used include the azo compounds mentioned in JP 8-108621 A.

Specific examples of organic peroxides that may be used include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinic acid peroxide, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl) peroxydicarbonate, tert-butyl peroxyacetate, tert-butyl peroxypivalate, tert-butyl peroxyneodecanoate, tert-butyl peroxyoctanoate, tert-butyl peroxylaurate, tertiary carbonate, 3,3',4,4'-tetra-(t-butylperoxycarbonyl)benzophenone, 3,3',4,4'-tetra-(t-hexyl peroxycarbonyl)benzophenone, 3,3',4,4'-tetra-(p-isopropylcumyl peroxycarbonyl)benzophenone, carbonyl di(t-butyl peroxydihydrogendiphthalate) and carbonyl di(t-hexyl peroxydihydrogendiphthalate).

Metallocene compounds that may be used include various titanocene compounds mentioned in, for example, JP 59-152396 A, JP 61-151197 A, JP 63-41484 A, JP 2-249 A, JP 2-4705 A and JP 5-83588 A, such as dicyclopentadienyltitanium bisphenyl, dicyclopentadienyltitanium bis-2,6-difluorophen-1-yl, dicyclopentadienyltitanium bis-2,4-difluorophen-1-yl, dicyclopentadienyltitanium bis-2,4,6-trifluorophen-1-yl, dicyclopentadienyltitanium bis-2,3,5,6-tetrafluorophen-1-yl, dicyclopentadienyltitanium bis-2,3,4,5,6-pentafluorophen-1-yl, dimethylcyclopentadienyltitanium bis-2,6-difluorophen-1-yl, dimethylcyclopentadienyltitanium bis-2,4,6-trifluorophen-1-yl, dimethylcyclopentadienyltitanium bis-2,3,5,6-tetrafluorophen-1-yl and dimethylcyclopentadienyltitanium bis-2,3,4,5,6-pentafluorophen-1-yl; and the iron-arene complexes mentioned in, for example, JP 1-304453 A and JP 1-152109 A.

Hexaarylbiimidazole compounds that may be used include various compounds mentioned in, for example, JP 6-29285 B, US 3,479,185, US 4,311,783 and US 4,622,286.

Specific examples include 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of organic boron compounds that may be used include the organic borates mentioned in, for example, JP 62-143044 A, JP 62-150242 A, JP 9-188685 A, JP 9-188686 A, JP 9-188710 A, JP 2000-131837 A, JP 2002-107916 A, JP 2764769 B, JP 2002-116539 A and by Martin Kunz in Rad Tech' 98. Proceedings (April 19-22, 1998, Chicago); the organic boron sulfonium complexes and organic boron oxosulfonium complexes mentioned in JP 6-157623 A, JP 6-175564 A and JP 6-175561 A; the organic boron iodonium complexes mentioned in JP 6-175554 A and JP 6-175553 A; the organic boron phosphonium complexes mentioned in JP 9-188710 A; and the organic boron transition metal coordination complexes mentioned in JP 6-348011 A, JP 7-128785 A, JP 7-140589 A, JP 7-306527 A and JP 7-292014 A.

Examples of disulfone compounds that may be used include the compounds mentioned in, for example, JP 61-166544 A and JP 2003-328465 A.

Examples of oxime ester compounds that may be used include the compounds mentioned in, for example, JCS Perkin II (1979) 1653-1660, JCS Perkin II (1979) 156-162, Journal of Photopolymer Science and Technology (1995) 202-232, JP 2000-66385 A and JP 2000-80068 A.

Specific examples include the compounds having the following structural formulas.

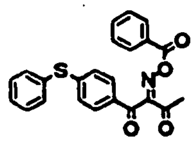 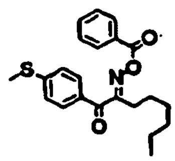 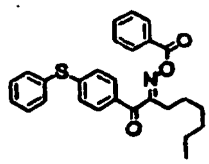 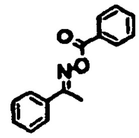 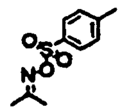

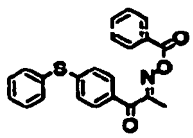 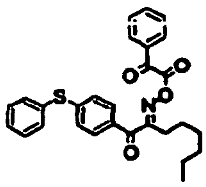 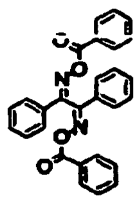 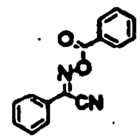 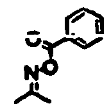

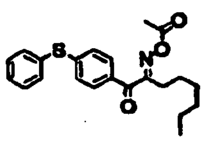 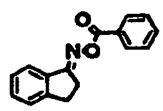 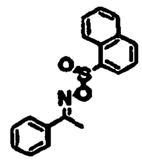 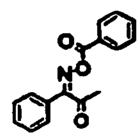 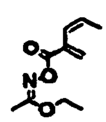

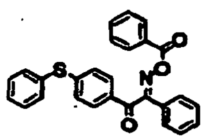 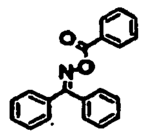 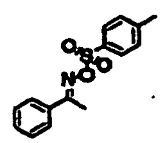 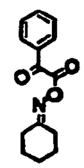 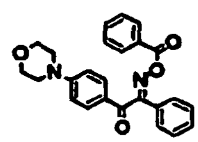

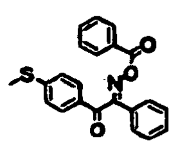 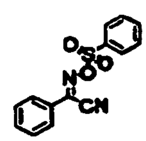

Specific examples of onium salt compounds that may be used include the diazonium salts mentioned by S.I. Schlesinger in Photogr. Sci. Eng. 18, 387 (1974) and by T.S. Bal et al. in Polymer 21, 423 (1980); the ammonium salts mentioned in US 4,069,055 and JP 4-365049 A; the phosphonium salts mentioned in US 4,069,055 and US 4,069,056; the iodonium salts mentioned in EP 104,143 B, JP 2-150848 A and JP 2-296514 A; the sulfonium salts mentioned in EP 370,693 B, EP 233,567 B, EP 297,443 B, EP 297,442 B, US 4,933,377, US 4,760,013, US 4,734,444, US 2,833,827, DE 2,904,626, DE 3,604,580 and DE 3,604,581; the selenonium salts mentioned by J.V. Crivello et al. in Macromolecules 10 (6), 1307 (1977) and by J.V. Crivello et al. in J. Polymer Sci., Polymer Chem. Ed. 17, 1047 (1979); and the arsonium salts mentioned by C.S. Wen at al. in Teh, Proc. Conf. Rad. Curing ASIA, p. 478 (October 1988, Tokyo).

Onium salts preferred for use in the invention are the onium salts represented by the formulas (RI-I) to (RI-III) below.

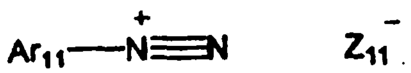

( R I – I )

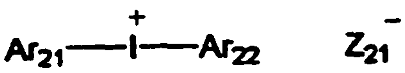

( R I –II )

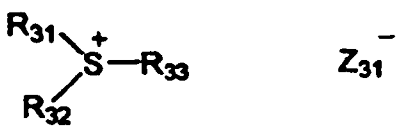

(R I –III )

In the formula (RI-I), $Ar_{11}$ is an aryl group of up to 20 carbon atoms which may have 1 to 6 substituents. Preferred substituents include alkyl groups of 1 to 12 carbon atoms, alkenyl groups of 1 to 12 carbon atoms, alkynyl groups of 1 to 12 carbon atoms, aryl groups of 1 to 12 carbon atoms, alkoxy groups of 1 to 12 carbon atoms, aryloxy groups of 1 to 12 carbon atoms, halogen atoms, alkylamino groups of 1 to 12 carbon atoms, dialkylamino groups of 1 to 12 carbon atoms, alkylamide or arylamide groups of 1 to 12 carbon atoms, carbonyl group, carboxy group, cyano group, sulfonyl group, thioalkyl groups of 1 to 12 carbon atoms and thioaryl groups of 1 to 12 carbon atoms.

$Z_{11}^-$ is a monovalent anion, specific examples of which include halide ions, perchlorate ions, hexafluorophosphate ions, tetrafluoroborate ions, sulfonate ions, sulfinate ions, thiosulfonate ions and sulfate ions. Of these, perchlorate ions, hexafluorophosphate ions, tetrafluoroborate ions, sulfonate ions and sulfinate ions are preferred for good stability.

In the formula (RI-II), $Ar_{21}$ and $Ar_{22}$ are each independently an aryl group of up to 20 carbon atoms which may have 1 to 6 substituents. Preferred substituents include alkyl groups of 1 to 12 carbon atoms, alkenyl groups of 1 to 12 carbon atoms, alkynyl groups of 1 to 12 carbon atoms, aryl groups of 1 to 12 carbon atoms, alkoxy groups of 1 to 12 carbon atoms, aryloxy groups of 1 to 12 carbon atoms, halogen atoms, alkylamino groups of 1 to 12 carbon atoms, dialkylamino groups of 1 to 12 carbon atoms, alkylamide or arylamide groups of 1 to 12 carbon atoms, carbonyl group, carboxy group, cyano group, sulfonyl group, thioalkyl groups of 1 to 12 carbon atoms and thioaryl groups of 1 to 12 carbon atoms.

$Z_{21}^-$ is a monovalent anion, specific examples of which include halide ions, perchlorate ions, hexafluorophosphate ions, tetrafluoroborate ions, sulfonate ions, sulfinate ions, carboxylate ions, thiosulfonate ions and sulfate ions. Of these, perchlorate ions, hexafluorophosphate ions, tetrafluoroborate ions, sulfonate ions, sulfinate ions and carboxylate ions are preferred for good stability and reactivity.

In the formula (RI-III), $R_{31}$, $R_{32}$ and $R_{33}$ are each independently an aryl, alkyl, alkenyl or alkynyl group of up to 20 carbon atoms which may have 1 to 6 substituents. Of these, aryl groups are preferred for good reactivity and stability. Preferred substituents include alkyl groups of 1 to 12 carbon atoms, alkenyl groups of 1 to 12 carbon atoms, alkynyl groups of 1 to 12 carbon atoms, aryl groups of 1 to 12 carbon atoms, alkoxy groups of 1 to 12 carbon atoms, aryloxy groups of 1 to 12 carbon atoms, halogen atoms, alkylamino groups of 1 to 12 carbon atoms, dialkylamino groups of 1 to 12 carbon atoms, alkylamide or arylamide groups of 1 to 12 carbon atoms, carbonyl group, carboxy group, cyano group, sulfonyl group, thioalkyl groups of 1 to 12 carbon atoms and thioaryl groups of 1 to 12 carbon atoms.

$Z_{31}^-$ is a monovalent anion, specific examples of which include halide ions, perchlorate ions, hexafluorophosphate ions, tetrafluoroborate ions, sulfonate ions, sulfinate ions, carboxylate ions, thiosulfonate ions, and sulfate ions. Of these, perchlorate ions, hexafluorophosphate ions, tetrafluoroborate ions, sulfonate ions, sulfinate ions and carboxylate ions are preferred for good stability and reactivity. The carboxylate ions mentioned in JP 2001-343742 A are more preferred, and the carboxylate ions mentioned in JP 2002-148790 A are most preferred.

Specific structural formulas of onium salts represented by the formulas (RI-I) to (RI-III) are shown below.

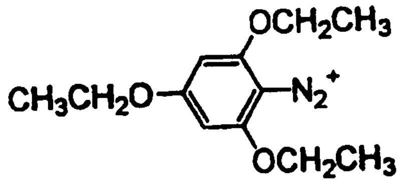 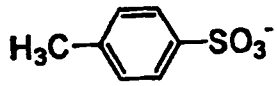 (N-1)

$PF_6^-$ (N-2)

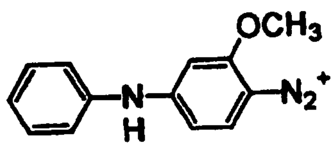 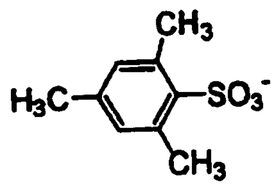 (N-3)

$ClO_4^-$ (N-4)

$PF_6^-$ (N-5)

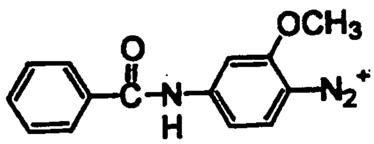 $CF_3SO_3^-$ (N-6)

$BF_4^-$ (N-7)

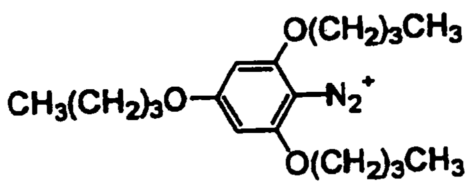 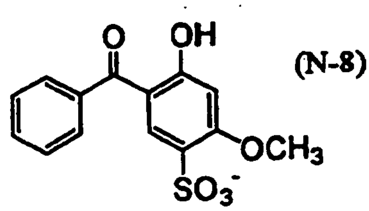 (N-8)

$ClO_4^-$ (N-9)

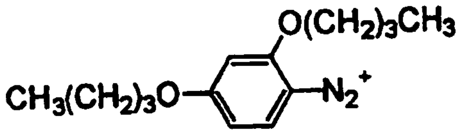 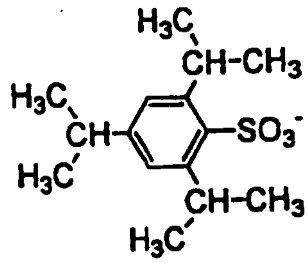 (N-10)

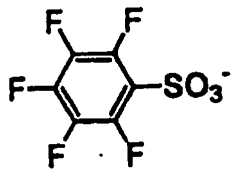 (N-11)

$PF_6^-$ (N-12)

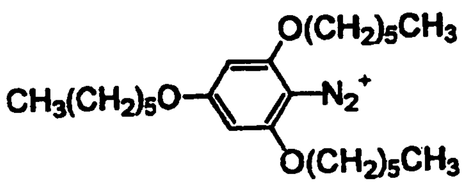 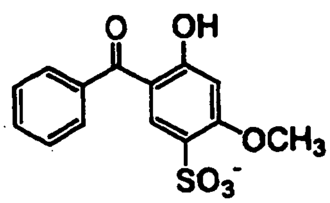 (N-13)

$ClO_4^-$ (N-14)

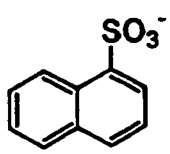 (N-15)

$PF_6^-$ (N-16)

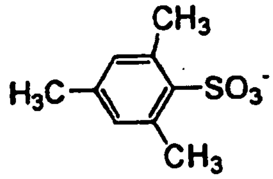 (N-17)

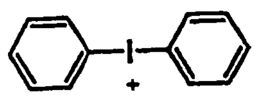

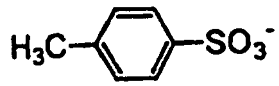

(I-1)

$PF_6^-$ (I-2)

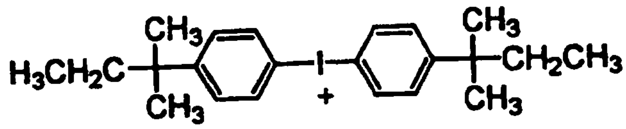

$PF_6^-$ (I-3)

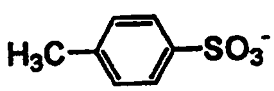

(I-4)

$ClO_4^-$ (I-5)

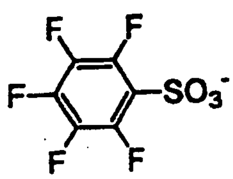

(I-6)

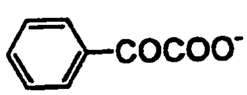

(I-7)

$CF_3SO_3^-$ (I-8)

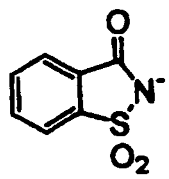

(I-9)

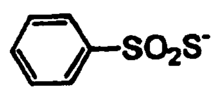

(I-10)

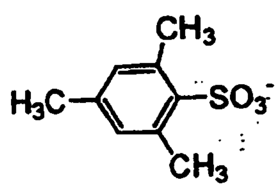

(I-11)

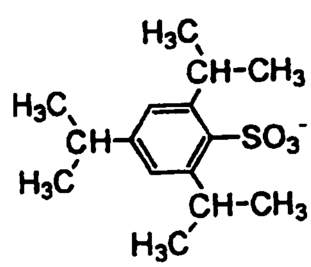

(I-12)

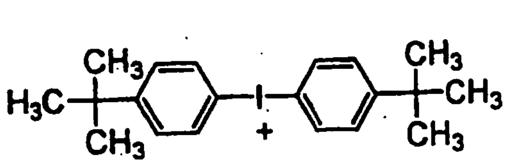 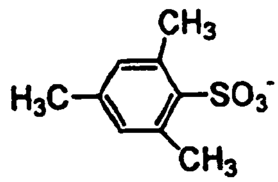 (I-13)

$ClO_4^-$ (I-14)

$PF_6^-$ (I-15)

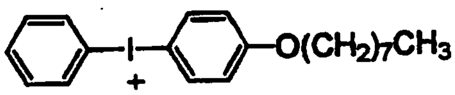 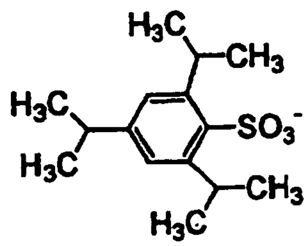 (I-16)

$CF_3COO^-$ (I-17)

$CF_3SO_3^-$ (I-18)

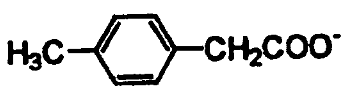 (I-19)

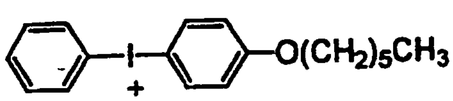 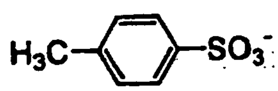 (I-20)

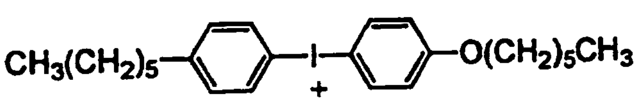 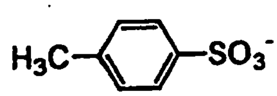 (I-21)

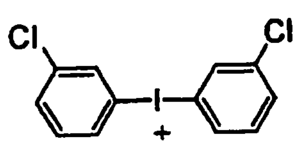 $BF_4^-$ (I-22)

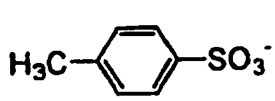 (I-23)

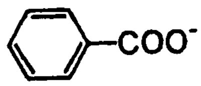 (I-18)

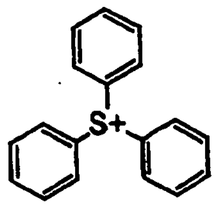

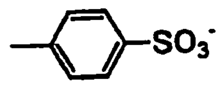 (S-1)

$PF_6^-$ (S-2)

$ClO_4^-$ (S-3)

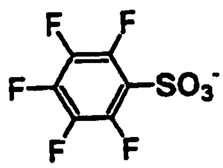 (S-4)

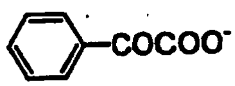 (S-5)

$CF_3SO_3^-$ (S-6)

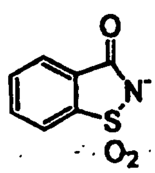 (S-7)

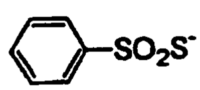 (S-8)

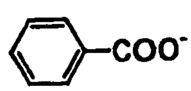 (S-9)

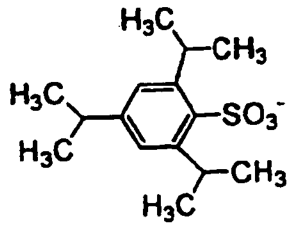 (S-10)

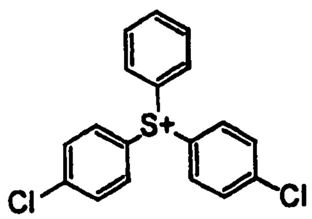

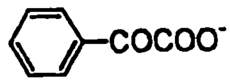 (S-11)

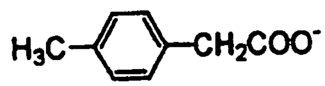 (S-12)

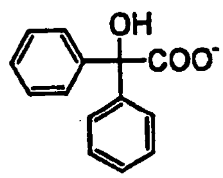 (S-13)

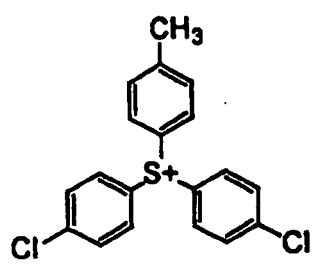

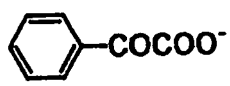 (S-14)

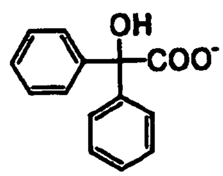 (S-15)

$BF_4^-$ (S-16)

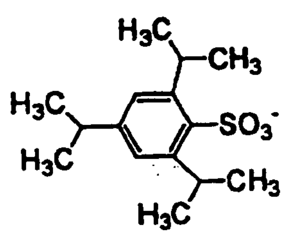 (S-17)

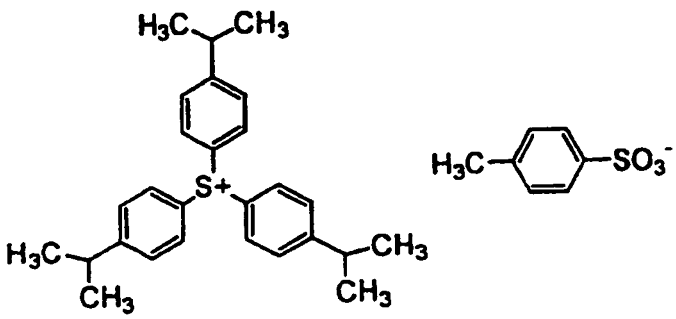

(S-18)

The polymerization initiator is not limited to the above-described compounds which generate a radical or an acid. However, for good reactivity and stability, the polymerization initiator is more preferably a triazine initiator, an organic halogen compound, an oxime ester compound, a diazonium salt, an iodonium salt or a sulfonium salt.

In the practice of the invention, these polymerization initiators may be used singly or in combination of two or more thereof.

These polymerization initiators may be added to the layer that includes the other ingredients or may be added to a separately provided layer.

These polymerization initiators are added in a proportion, based on all the solid ingredients making up the image recording layer, of preferably 0.1 to 50 wt%, more preferably 0.5 to 30 wt%, and most preferably 0.8 to 20 wt%.

(Polymerizable Compound)

Polymerizable compounds that can be used in the invention are addition polymerizable compounds having at least one ethylenically unsaturated double bond, and are selected from compounds having at least one, and preferably two or more, ethylenically unsaturated bonds. Use can be made of any addition polymerizable compound known in the prior art, without particular limitation.

In the practice of the invention, the polymerizable compound includes compounds having a variety of chemical forms, including monomers, prepolymers such as dimers, trimers and oligomers, mixtures of any of the above, and copolymers of any of the above.

The monomers and copolymers are exemplified by unsaturated carboxylic acids (e.g., acrylic acid, methacrylic acid, itaconic acid, crotonic acid, isocrotonic acid, maleic acid) and esters and amides thereof. Of these, it is preferable to use an ester of an unsaturated carboxylic acid with an aliphatic polyol or an amide of an unsaturated carboxylic acid with an aliphatic polyamine compound. Preferred use can also be made of the addition reaction product of an unsaturated carboxylic acid ester or amide having a nucleophilic substituent such as a hydroxy, amino or mercapto group with a monofunctional or polyfunctional isocyanate or epoxy compound; the dehydration condensation reaction product of the foregoing ester or amide with a monofunctional or polyfunctional carboxylic acid; the addition reaction product of an unsaturated carboxylic acid ester or amide having an electrophilic substituent such as an isocyanate or epoxy group with a monofunctional or polyfunctional alcohol, amine or thiol; or the substitution reaction product of an unsaturated carboxylic acid ester or amide having a removable substituent such as a halogen atom or a tosyloxy group with a monofunctional or polyfunctional alcohol, amine or thiol. Moreover, use can also be made of compound groups in which a suitable compound such as unsaturated phosphonic acid, styrene or vinyl ether is substituted for the above-mentioned unsaturated carboxylic acid.

Illustrative examples of monomers which are esters of unsaturated carboxylic acids and aliphatic polyol compounds include acrylic acid esters, methacrylic acid esters, itaconic acid esters, crotonic acid esters, isocrotonic acid esters and maleic acid esters. These may be used singly or in combination of two or more thereof.

Specific examples of acrylic acid esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer and isocyanuric acid ethylene oxide-modified triacrylate.

Specific examples of methacrylic acid esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl] dimethylmethane and bis[p-(methacryloxyethoxy)phenyl]dimethylmethane.

Itaconic acid esters include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate.

Crotonic acid esters include ethylene glycol dicrotonate, tetramethylene glycol dicrotonate, pentaerythritol dicrotonate and sorbitol tetradicrotonate.

Isocrotonic acid esters include ethylene glycol diisocrotonate, pentaerythritol diisocrotonate and sorbitol tetraisocrotonate.

Maleic acid esters include ethylene glycol dimaleate, triethylene glycol dimaleate, pentaerythritol dimaleate and sorbitol tetramaleate.

Preferred examples of other esters which may be used as monomers include the aliphatic alcohol esters mentioned in JP 51-47334 B and JP 57-196231 A; esters having aromatic skeletons such as those mentioned in JP 59-5240 A, JP 59-5241 A and JP 2-226149 A; and the amino group-bearing esters mentioned in JP 1-165613 A.

Specific examples of amides of unsaturated carboxylic acids with aliphatic polyamines that may be used as monomers include methylenebis(acrylamide), methylenebis(methacrylamide), 1,6-hexamethylenebis(acrylamide), 1,6-hexamethylenebis(methacrylamide), diethylenetriaminetris(acrylamide), xylylenebis(acrylamide) and xylylenebis(methacrylamide). These may be used singly or in combination of two or more thereof.

Other suitable amide-type monomers include those having a cyclohexylene structure which are mentioned in JP 54-21726 B.

Urethane-type addition polymerizable compounds prepared using an addition reaction between an isocyanate group and a hydroxy group are also suitable as the polymerizable compound used in the invention. Specific examples include the vinylurethane compounds having two or more polymerizable vinyl groups per molecule that are obtained by adding a hydroxy group-bearing vinyl monomer of the formula (A) below to the polyisocyanate compounds having two or more isocyanate groups per molecule mentioned in JP 48-41708 B.

$$CH_2{=}C(R_4)COOCH_2CH(R_5)OH \qquad (A)$$

In the formula (A), $R_4$ and $R_5$ each independently represent -H or $-CH_3$.

Urethane acrylates such as those mentioned in JP 51-37193 A, JP 2-32293 B and JP 2-16765 B, and the urethane compounds having an ethylene oxide-type skeleton mentioned in JP 58-49860 B, JP 56-17654 B, JP 62-39417 B and JP 62-39418 B are also suitable as polymerzable compounds that can be used in the invention.

Other polymerizable compounds that may be used in the invention include the addition polymerizable compounds having in the molecule an amino structure or a sulfide structure that are mentioned in JP 63-277653 A, JP 63-260909 A and JP 1-105238 A. By using such addition polymerizable compounds, photopolymerizable compositions of exceptional sensitivity (speed) can be obtained.

Other polymerizable compounds that can be used in the invention include polyfunctional acrylates and methacrylates, such as the polyester acrylates mentioned in JP 48-64183 A, JP 49-43191 B and JP 52-30490 B, and epoxy acrylates obtained by reacting an epoxy resin with (meth)acrylic acid. Further examples include the specific unsaturated compounds mentioned in JP 46-43946 B, JP 1-40337 B and JP 1-40336 B, and the vinylphosphonic acid compounds mentioned in JP 2-25493 A. In some cases, it will be desirable to use the perfluoroalkyl group-containing structures mentioned in JP 61-22048 A. Use can also be made of the photocurable monomers and oligomers mentioned in Nippon Setchaku Kyokaishi, Vol. 20, No. 7, 300-308 (1984).

Exemplary vinyl ether group-bearing compounds that may be used in the invention include those mentioned in JP 2002-029162 A. Specific, non-limiting, examples include tetramethylene glycol divinyl ether, trimethylolpropane trivinyl ether, tetraethylene glycol divinyl ether, pentaerythritol divinyl ether, pentaerythritol trivinyl ether, pentaerythritol tetravinyl ether, 1,4-bis[2-(vinyloxy)ethyloxy]benzene, 1,2-bis[2-(vinyloxy)ethyloxy]benzene, 1,3-bis[2-(vinyloxy)ethyloxy]benzene, 1,3,5-tris[2-(vinyloxy)ethyloxy]benzene, 4,4'-bis[2-(vinyloxy)ethyloxy]biphenyl, 4,4'-bis[2-(vinyloxy)ethyloxy]diphenyl ether, 4,4'-bis[2-(vinyloxy)ethyloxy]diphenylmethane, 1,4-bis[2-(vinyloxy)ethyloxy]naphthalene, 2,5-bis[2-(vinyloxy)ethyloxy]furan, 2,5-bis[2-(vinyloxy)ethyloxy]thiophene, 2,5-bis[2-(vinyloxy)ethyloxy]imidazole, 2,2-bis[4-[2-(vinyloxy)ethyloxy]phenyl]propane (the bis(vinyloxyethyl)ether of bisphenol A), 2,2-bis[4-(vinyloxymethyloxy)phenyl]propane and 2,2-bis[4-(vinyloxy)phenyl]propane.

In the practice of the invention, details concerning use of the polymerizable compound, for example, what type of structure it should have, whether to use one such compound alone or a combination of two or more thereof, and the amount of addition can be selected as desired in accordance with the performance characteristics ultimately intended

for the presensitized plate. For example, selection may be based on the following criteria.

For good sensitivity, a structure having a high unsaturated group content per molecule is preferred. In most cases, a functionality of at least two is desirable. To increase the strength of image areas (i.e., the cured film), a functionally of three or more is preferred. Also effective are methods in which both the sensitivity and strength are adjusted by using in combination compounds having differing numbers of functional groups or differing polymerizable groups (e.g., acrylic acid esters, methacrylic acid esters, styrene compounds, vinyl ether compounds).

Selection of the polymerizable compound and how it is used are also important factors affecting both the compatibility and dispersibility of the compound with respect to other ingredients in the image recording layer (e.g., water-insoluble polymers, initiators, colorants). For instance, sometimes the compatibility can be enhanced by using a low-purity compound or by using together two or more polymerizable compounds. It is also possible to select a specific structure so as to enhance adhesion to the support or the subsequently described protective layer.

In the practice of the invention, such polymerizable compounds may be used singly or in combination of two or more thereof.

Such a polymerizable compound is added in a proportion, with respect to the total solids making up the image recording layer, of preferably 5 to 80 wt%, and more preferably 25 to 75 wt%.

(Hydrophobic Binder Polymer)

Hydrophobic binder polymers that can be used in the invention are preferably water-insoluble polymers. Ones which contain substantially no acid groups, such as carboxy group, sulfone group or phosphate group, are preferred.

That is, hydrophobic binder polymers that can be used in the invention are preferably insoluble in water and aqueous solutions having a pH of at least 10. Specifically, it is preferable for the hydrophobic binder polymer to have a solubility in water and aqueous solutions with a pH of at least 10 ot not more than 0.5 wt%, and more preferably not more than 0.1 wt%. By using such a hydrophobic binder polymer, the film strength, water resistance and ink receptivity of the image recording layer are improved, enabling an longer press life to be achieved.

Insofar as the performance of the lithographic printing plate obtained by the inventive platemaking method is not compromised, hydrophobic binder polymers which have a solubility within the above-indicated range and are known in the prior art may be suitably used as the above-described hydrophobic binder polymers. The use of linear organic polymers having film formability is preferred.

Exemplary hydrophobic binder polymers include acrylic resins, polyvinyl acetal resins, polyurethane resins, polyamide resins, epoxy resins, methacrylic resins, styrene resins, and polyester resins. Any one or combinations of two or more thereof may be used. Of these, the use of an acrylic resin is preferred.

More specifically, a (meth)acrylate copolymer is preferred. A copolymer of an alkyl (meth)acrylate or an aralkyl ester with a (meth)acrylic acid ester containing a $-CH_2CH_2O-$ unit or a $-CH_2CH_2NH-$ unit as R on the ester residue (-COOR) of the (meth)acrylic acid ester is especially preferred. The alkyl group on the alkyl (meth)acrylate is preferably an alkyl group of 1 to 5 carbon atoms, and more preferably methyl. An exemplary aralkyl (meth)acrylate is benzyl (meth) acrylate.

In the practice of the invention, crosslinkability can be imparted to the hydrophobic binder polymer to enhance the film strength in image areas. To impart crosslinkability to the hydrophobic binder polymer, crosslinkable functional groups such as ethylenically unsaturated bonds may be introduced into the polymer. The crosslinkable functional groups may be introduced by copolymerization.

Examples of hydrophobic binder polymers having ethylenically unsaturated bonds in the molecule include polymers of acrylic acid or methacrylic acid esters or amides, in which polymers the ester or amide residues (the R' in -COOR' or -CONHR') have an ethylenically unsaturated bond.

Exemplary residues (the above-mentioned R') having ethylenically unsaturated bonds include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (wherein each of $R^1$ to $R^3$ represents a hydrogen atom, a halogen atom, or an alkyl, aryl, alkoxy or aryloxy group of 1 to 20 carbon atoms, and $R^1$ and $R^2$ or $R^3$ may be bonded together to form a ring; the letter n is an integer from 1 to 10; and X is a dicyclopentadienyl residue).

Specific examples of suitable ester residues include $-CH_2CH=CH_2$ (mentioned in JP 7-21633 B), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NHCOO-CH_2CH=CH_2$ and $-CH_2CH_2O-X$ (wherein X is a dicyclopentadienyl residue).

Specific examples of suitable amide residues include $-CH_2CH=CH_2$, $-CH_2CH_2-Y$ (wherein Y is a cyclohexene residue) and $-CH_2CH_2-OCO-CH=CH_2$.

The hydrophobic binder polymer having crosslinkability is cured by, for example, the addition of free radicals (polymerization initiating radicals, or propagation radicals during polymerization of the polymerizable compound) to the crosslinkable functional groups on the polymer to effect addition polymerization, either directly between polymers or via chain polymerization of the polymerizable compounds, so as to form crosslinks between the polymer molecules. Alternatively, the hydrophobic binder polymer having crosslinkability is cured when atoms in the polymer (e.g., hydrogen atoms on carbon atoms adjacent to the crosslinkable functional groups) are pulled off by free radicals, thereby forming polymer radicals which bond together, resulting in the formation of crosslinks between the polymer molecules.

The crosslinkable group content in the hydrophobic binder polymer (content of radical-polymerizable unsaturated double bonds, as determined by iodometry) is preferably 0.1 to 10.0 mmol, more preferably 1.0 to 7.0 mmol, and most preferably 2.0 to 5.5 mmol, per gram of the hydrophobic binder polymer.

In the practice of the invention, the hydrophobic binder polymer preferably has hydrophilic groups to enhance the ability of the image recording layer to be developed by an aqueous solution. Moreover, for enhancing press life, it is important that the hydrophobic binder polymer have a good compatibility with the polymerizable compound in the image recording layer; in other words, it is also preferable for the hydrophobic binder polymer to have oleophilic groups.

Therefore, in the practice of the invention, to enhance the developability and lengthen the press life, it is effective to copolymerize hydrophilic groups and oleophilic groups in the hydrophobic binder polymer. Suitable examples of the hydrophilic groups include hydroxy, carboxylate, hydroxyethyl, ethyleneoxy, hydroxypropyl, polyoxyethyl, polyoxypropyl, amino, aminoethyl, aminopropyl, ammonium, amide and carboxymethyl groups.

The hydrophobic binder polymer has a weight-average molecular weight of preferably at least 5,000, and more preferably from 10,000 to 300,000, and has a number-average molecular weight of preferably at least 1,000, and more preferably from 2,000 to 250,000. The polydispersity (weight-average molecular weight/number-average molecular weight) is preferably from 1.1 to 10.

The hydrophobic binder polymer may be a random polymer, a block polymer or a graft polymer. A random polymer is preferred.

In the present invention, the hydrophobic binder polymers may be used singly or as a mixture of two or more thereof.

The content of such hydrophobic binder polymer is preferably 5 to 90 wt%, more preferably 10 to 70 wt%, and most preferably 10 to 60 wt%, based on the total solids in the image recording layer. When the content falls within this range, the resulting presensitized plate exhibits excellent image forming properties and a high image area strength.

(Infrared Absorber)

In the practice of the invention, when imagewise exposure is carried out using a light source that emits infrared light, an infrared absorber may be used in combination with the above-described polymerization initiator in the image recording layer of the presensitized plate employed in the inventive platemaking method. The function of the infrared absorber is to convert absorbed infrared light into heat. The heat obtained by conversion of the infrared light causes the polymerization initiator to thermally decompose, generating radicals.

The infrared absorber used in the invention is a dye or pigment having an absorption maximum in a wavelength range of 760 to 1200 nm.

Dyes which may be used include commercial dyes and known dyes that are mentioned in the technical literature, such as Senryo Binran [Handbook of Dyes] (The Society of Synthetic Organic Chemistry, Japan, 1970). Suitable dyes include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts, and metal-thiolate complexes (e.g., nickel thiolate complexes).

Preferred dyes include the cyanine dyes mentioned in JP 58-125246 A, JP 59-84356 A, JP 60-78787 A and GB 434,875 B; the methine dyes mentioned in JP 58-173696 A, JP 58-181690 A and JP 58-194595 A; the naphthoquinone dyes mentioned in JP 58-112793 A, JP 58-224793 A, JP 59-48187 A, JP 59-73996 A, JP 60-52940 A and JP 60-63744 A; and the squarylium dyes mentioned in JP 58-112792 A.

The near-infrared absorbing sensitizers mentioned in US 5,156,938 can also be advantageously used. Other compounds that are suitable for use in this way include the substituted arylbenzo(thio)pyrylium salts mentioned in US 3,881,924; the trimethinethiapyrylium salts mentioned in JP 57-142645 A (US 4,327,169), the pyrylium compounds mentioned in JP 58-181051 A, JP 58-220143 A, JP 59-41363 A, JP 59-84248 A, JP 59-84249 A, JP 59-146063 A and JP 59-146061 A; the cyanine dyes mentioned in JP 59-216146 A; the pentamethinethiopyrylium salts mentioned in US 4,283,475; and the pyrylium compounds mentioned in JP 5-13514 B and JP 5-19702 B.

Additional suitable examples include the near-infrared absorbing dyes of the formulas (I) and (II) in US 4,756,993.

Of these known dyes and pigments, cyanine dyes, squarylium dyes, pyrylium salts, nickel-thiolate complexes and indolenine cyanine dyes are preferred, cyanine dyes and indolenine cyanine dyes are more preferred, and cyanine dyes of the formula (II) below are most preferred.

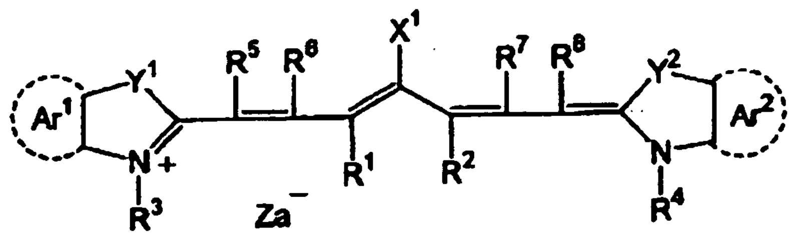

( II )

In the formula (II), $X^1$ is a hydrogen atom, a halogen atom, $-NPh_2$ (where "Ph" represents a phenyl group), $-X^2-L^1$, or a group of the following formula.

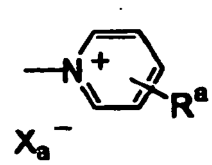

In the above formula, $X^2$ is an oxygen atom, a nitrogen atom or a sulfur atom; $L^1$ is a hydrocarbon group of 1 to 12 carbon atoms, an aromatic ring having a heteroatom, or a hydrocarbon group of 1 to 12 carbon atoms having a heteroatom. "Heteroatom," as used herein, refers to a nitrogen, sulfur, oxygen, halogen or selenium atom.

$Xa^-$ is defined in the same way as $Za^-$ described below; and $R^a$ is a hydrogen atom, alkyl group, aryl group, substituted or unsubstituted amino group or halogen atom.

In the formula (II), $R^1$ and $R^2$ are each independently a hydrocarbon group of 1 to 12 carbon atoms which may be mutually bonded to form a ring. For good storage stability of the image recording layer-forming coating fluid, it is preferable for $R^1$ and $R^2$ each to be a hydrocarbon group having at least two carbon atoms. It is especially preferable for $R^1$ and $R^2$ to be bonded together so as to form a 5- or 6-membered ring.

In the formula (II), $Ar^1$ and $Ar^2$ are each independently an aromatic hydrocarbon group that may be substituted. Preferred aromatic hydrocarbon groups include benzene and naphthalene rings. Preferred substituents include hydrocarbon groups of up to 12 carbon atoms, halogen atoms, and alkoxy groups of up to 12 carbon atoms.

$Y^1$ and $Y^2$ are each independently a sulfur atom or a dialkylmethylene group of up to 12 carbon atoms.

$R^3$ and $R^4$ are each independently a hydrocarbon group of up to 20 carbon atoms which may be substituted. Preferred substituents include alkoxy groups of up to 12 carbon atoms, carboxy group and sulfo group.

$R^5$, $R^6$, $R^7$ and $R^8$ are each independently a hydrogen atom or a hydrocarbon group of up to 12 carbon atoms. In consideration of the availability of the starting materials, it is preferable for each of $R^5$ to $R^8$ to be a hydrogen atom.

$Za^-$ represents a counteranion. In cases where the cyanine dye of the formula (II) has an anionic substituent in the structure and there is no need for charge neutralization, $Za^-$ is unnecessary. For good storage stability of the image recording layer-forming coating fluid, preferred examples of $Za^-$ include halide ions, perchlorate ions, tetrafluoroborate ions, hexafluorophosphate ions and sulfonate ions. Of these, perchlorate ions, hexafluorophosphate ions and arylsulfonate ions are more preferred.

Specific examples of cyanine dyes of the formula (II) that may be preferably used in the invention include those described in Paragraphs [0017] to [0019] of JP 2001-133969 A.

Other preferred examples of the cyanine dyes of the formula (II) include the specific indolenine cyanine dyes mentioned in JP 2002-278057 A.

Pigments which may be used as the infrared absorber include commercial pigments and pigments mentioned in the technical literature, such as the Colour Index, Saishin Ganryo Binran [Latest Handbook of Pigments] (Japan Association of Pigment Technology, 1977), Saishin Ganryo Oyo Gijutsu [Recent Pigment Applications Technology] (CMC Publishing Co., Ltd., 1986), and Insatsu Inki Gijutsu [Printing Ink Technology] (CMC Publishing Co., Ltd., 1984).

Suitable pigments include black pigments, yellow pigments, orange pigments, brown pigments, red pigments, violet pigments, blue pigments, green pigments, fluorescent pigments, metal powder pigments and polymer-bonded dyes.

Specific examples of such pigments include insoluble azo pigments, azo lake pigments, condensed azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, lake pigments, azine pigments, nitroso pigments, nitro pigments, natural pigments, fluorescent pigments, inorganic pigments and carbon black. Of these, carbon black is preferred.

The pigments may be used without being surface treated or may be used after surface treatment. Examples of surface treatment methods include surface coating with a resin or wax, surfactant deposition, and bonding a reactive substance (e.g., a silane coupling agent, an epoxy compound or a polyisocyanate) to the pigment surface. Surface treatment methods that may be used include those described in Kinzoku Sekken no Seishitsu to Oyo [Properties and Applications of Metallic Soaps] (Saiwai Shobo), Insatsu Inki Gijutsu [Printing Ink Technology] (CMC Publishing Co., Ltd., 1984), and Saishin Ganryo Oyo Gijutsu [Recent Pigment Applications Technology] (CMC Publishing Co., Ltd., 1986).

The pigment has a particle size which is in a range of preferably 0.01 to 10 μm, more preferably 0.05 to 1 μm, and even more preferably 0.1 to 1 μm. When the particle size of the pigment is within the above range, the pigment dispersion has a good stability in the image recording layer-forming coating fluid, and an image recording layer obtained has a good uniformity.

Known dispersion techniques, such as those which can be used in ink production or toner production, may be employed as the method for dispersing the pigment. Illustrative examples of equipment that may be used for this purpose include an ultrasonic disperser, a sand mill, an attritor, a pearl mill, a super mill, a ball mill, an impeller, a disperser, a KD mill, a colloid mill, a dynatron, a three-roll mill and a pressure kneader. These methods of dispersion and dispersion apparatuses are described in Saishin Ganryo Oyo Gijutsu [Recent Pigment Applications Technology] (CMC Publishing Co., Ltd., 1986).

In the practice of the invention, such infrared absorbers may be used singly or in combination of two or more thereof.

To inhibit side effects which may interfere with the polymerization reaction, it is preferable to add such infrared absorbers to the image recording layer in the minimum required amount.

In the invention, these infrared absorbers are added in a proportion, based on the total solids in the image recording layer, of preferably 0.001 to 50 wt%, more preferably 0.005 to 30 wt%, and most preferably 0.01 to 10 wt%. When the addition ratio of the infrared absorber falls within the above range, a high sensitivity can be achieved without adversely affecting the uniformity or film strength of the image recording layer.

(Sensitizer)

In the practice of the invention, when imagewise exposure is carried out using a light source that emits light at a wavelength of 250 to 420 nm, the radical-generating efficiency can be increased by using a sensitizer in combination with the polymerization initiator in the image recording layer of the presensitized plate employed in the inventive platemaking method.

Specific examples of sensitizers include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthone, benzil, dibenzalacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone. These may be used singly or in combination of two or more thereof.

Preferred examples of the sensitizer are the compounds of the formula (III) below mentioned in JP 51-48516 B.

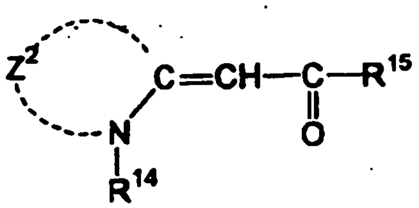

(III)

In the formula (III), $R^{14}$ is an alkyl group (e.g., methyl, ethyl, propyl) or a substituted alkyl group (e.g., 2-hydroxyethyl, 2-methoxyethyl, carboxymethyl, 2-carboxyethyl). $R^{15}$ is an alkyl group (e.g., methyl, ethyl) or an aryl group (e.g., phenyl, p-hydroxyphenyl, naphthyl, thienyl).

In the formula (III), $Z^2$ is a non-metallic atomic group required to form the nitrogen-containing heterocyclic nucleus generally used in a cyanine dye. Specific examples include benzothiazoles (e.g., benzothiazole, 5-chlorobenzothiazole, 6-chlorobenzothiazole), naphthothiazoles (e.g., α-naphthothiazole, β-naphthothiazole), benzoselenazoles (e.g., benzoselenazole, 5-chlorobenzoselenazole, 6-methoxybenzoselenazole), naphthoselenazoles (e.g., α-naphthoselenazole, β-naphthoselenazole), benzoxazoles (e.g., benzoxazole, 5-methylbenzoxazole, 5-phenylbenzoxazole), and naphthoxazoles (e.g., α-naphthoxazole, β-naphthoxazole).

The compounds of the formula (III) are exemplified by compounds with a chemical structure that combines these $Z^2$, $R^{14}$, and $R^{15}$ groups, and may be suitably selected and used from among many known substances that exist.
Suitable examples of the sensitizer include also the merocyanine dyes mentioned in JP 5-47095 B and ketocoumarin compounds of the formula (IV) below.

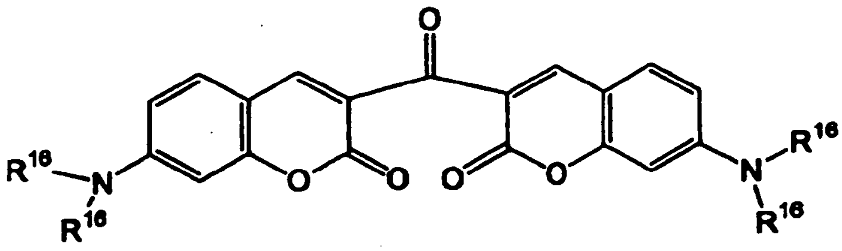

(IV)

In the formula (IV), $R^{16}$ is an alkyl group, such as methyl or ethyl.
In the practice of the invention, such sensitizers may be used singly or as a combination of two or more.
Such sensitizers are added in a proportion, based on the total solids in the image recording layer, of preferably 0.1 to 50 wt%, more preferably 0.5 to 30 wt%, and most preferably 0.8 to 20 wt%.
In addition, if necessary, various additives may also be included in the image recording layer of the presensitized plate employed in the inventive platemaking method. These are described below.

(Hydrophilic Polymer)

A hydrophilic polymer may be included in the image recording layer of the presensitized plate employed in the inventive platemaking method so as to improve developability and enhance the dispersion stability of microcapsules.
Suitable examples of hydrophilic polymers include those having hydrophilic groups, such as hydroxy, carboxy, carboxylate, hydroxyethyl, polyoxyethyl, hydroxypropyl, polyoxypropyl, amino, aminoethyl, aminopropyl, ammonium, amide, carboxymethyl, sulfonate and phosphate groups. Such polymers may be used singly or in combination of two or more.
Specific examples include gum arabic, casein, gelatin, starch derivatives, carboxymethyl cellulose and its sodium salt, cellulose acetate, sodium alginate, vinyl acetate-maleic acid copolymers, styrene-maleic acid copolymers, polyacrylic acids and their salts, polymethacrylic acids and their salts, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetates having a degree of hydrolysis of at least 60 mol%, and preferably at least 80 mol%, polyvinyl formal, polyvinyl butyral, polyvinyl pyrrolidone, acrylamide homopolymers and copolymers, methacrylamide homopolymers and copolymers, N-methylolacrylamide homopolymers and copolymers, polyvinylpyrrolidones, alcohol-soluble nylons, and polyethers of 2,2-bis(4-hydroxyphenyl)propane with epichlorohydrin.
The hydrophilic polymer used in the invention has a weight-average molecular weight of preferably at least 5,000, and more preferably from 10,000 to 300,000. The hydrophilic polymer may be a random polymer, a block polymer, or a graft polymer.
In the practice of the invention, such hydrophilic polymers may be used alone or as a combinations of two or more thereof.
The content of the hydrophilic polymer in the image recording layer, based on the total solids in the image recording layer, is preferably not more than 20 wt%, and more preferably not more than 10 wt%.

(Surfactant)

To promote the developability of the exposed plate and enhance the coating surface shape, a surfactant may be included in the image recording layer of the presensitized plate employed in the inventive platemaking method.
Exemplary surfactants include nonionic surfactants, anionic surfactants, cationic surfactants, amphoteric surfactants and fluorochemical surfactants. Use may be made of a single surfactant or of a combination of two or more surfactants.

Any known nonionic surfactant may be used in the invention without particular limitation. Specific examples include polyoxyethylene alkyl ethers, polyoxyethylene alkyl phenyl ethers, polyoxyethylene polystyrylphenyl ethers, polyoxyethylene polyoxypropylene alkyl ethers, partial fatty acid esters of glycerol, partial fatty acid esters of sorbitan, partial fatty acid esters of pentaerythritol, fatty acid monoesters of propylene glycol, partial fatty acid esters of sucrose, partial fatty acid esters of polyoxyethylene sorbitan, partial fatty acid esters of polyoxyethylene sorbitol, fatty acid esters of polyethylene glycol, partial fatty acid esters of polyglycerol, polyoxyethylenated castor oils, partial fatty acid esters of polyoxyethylene glycerol, fatty acid diethanolamides, N,N-bis-2-hydroxyalkylamines, polyoxyethylene alkyl amines, fatty acid esters of triethanolamine, trialkylamine oxides, polyethylene glycol, and copolymers of polyethylene glycol and polypropylene glycol.

Any known anionic surfactant may be used in the invention without particular limitation. Specific examples include fatty acid salts, abietic acid salts, hydroxyalkanesulfonates, alkanesulfonates, dialkylsulfosuccinates, linear alkylbenzenesulfonates, branched alkylbenzenesulfonates, alkylnaphthalenesulfonates, alkylphenoxypolyoxyethylene propylsulfonates, polyoxyethylene alkylsulfophenyl ether salts, sodium N-methyl-N-oleyltaurate, the disodium salts of N-alkylsulfosuccinic acid monoamides, petroleum sulfonates, sulfated tallow oil, sulfates of fatty acid alkyl esters, alkyl sulfates, polyoxyethylene alkyl ether sulfates, fatty acid monoglyceride sulfates, polyoxyethylene alkylphenyl ether sulfates, polyoxyethylene styrylphenyl ether sulfates, alkyl phosphates, polyoxyethylene alkyl ether phosphates, polyoxyethylene alkylphenyl ether phosphates, partially saponified styrene-maleic anhydride copolymers, partially saponified olefin-maleic anhydride copolymers and naphthalenesulfonic acid-formalin condensates.

Any known cationic surfactant may be used in the invention without particular limitation. Examples include alkylamine salts, quaternary ammonium salts, polyoxyethylene alkylamine salts and polyethylene polyamine derivatives.

Any known amphoteric surfactant may be used in the invention without particular limitation. Examples include carboxybetaines, aminocarboxylic acids, sulfobetaines, aminosulfates and imidazolines.

In the surfactants mentioned above, the term "polyoxyethylene" may be substituted with the more general term "polyoxyalkylene," additional examples of which include polyoxymethylene, polyoxypropylene and polyoxybutylene. Surfactants containing these latter polyoxyalkylene groups can likewise be used in the present invention.

Fluorochemical surfactants having perfluoroalkyl groups in the molecule are also suitable as the surfactant. Examples of such fluorochemical surfactants include anionic surfactants such as perfluoroalkylcarboxylates, perfluoroalkylsulfonates and perfluoroalkylphosphates; amphoteric surfactants such as perfluoroalkylbetain; cationic surfactants such as perfluoroalkyltrimethylammonium salts; and nonionic surfactants such as perfluoroalkylamine oxides, perfluoroalkyl-ethylene oxide adducts, oligomers containing perfluoroalkyl groups and hydrophilic groups, oligomers containing perfluoroalkyl groups and lipophilic groups, oligomers containing perfluoroalkyl groups, hydrophilic groups and lipophilic groups, and urethanes containing perfluoroalkyl groups and lipophilic groups. Preferred examples include the fluorochemical surfactants mentioned in JP 62-170950 A, JP 62-226143 A and JP 60-168144 A.

In the practice of the invention, such surfactants may be used singly or as a combination of two or more thereof.

The surfactant content in the image recording layer is preferably 0.001 to 10 wt%, and more preferably 0.01 to 7 wt%, based on the total solids in the image recording layer.

(Colorant)

Dyes having a large absorption in the visible light range can be used as image colorants in the image recording layer of the presensitized plate employed in the inventive platemaking method.

Specific examples include Oil Yellow #101, Oil Yellow #103, Oil Pink #312, Oil Green BG, Oil Blue BOS, Oil Blue #603, Oil Black BY, Oil Black BS and Oil Black T-505 (all of which are produced by Orient Chemical Industries, Ltd.); and also Victoria Pure Blue, Crystal Violet (CI 42555), Methyl Violet (CI 42535), Ethyl Violet, Rhodamine B (CI 145170B), Malachite Green (CI 42000), Methylene Blue (CI 52015), and the dyes mentioned in JP 62-293247 A. Preferred use can also be made of pigments such as phthalocyanine pigments, azo pigments, carbon black and titanium oxide.

The addition of these colorants is desirable because they enable image areas and non-image areas to be easily distinguished from each other following image formation.

In the practice of the invention, such colorants may be used singly or in combination of two or more.

The amount of colorant added to the image recording layer is preferably 0.01 to 10 wt %, based on the total solids in the image recording layer.

(Printing-Out Agent)

An acid or radical-responsive chromogenic compound may be added to the image recording layer of the presensitized plate employed in the inventive platemaking method in order to form a print-out image.

Examples of compounds which can be effectively used as such a printing-out agent include diphenylmethane, triphenylmethane, thiazine, oxazine, xanthene, anthraquinone, iminoquinone, azo and azomethine dyes.

Specific examples include dyes such as Brilliant Green, Ethyl Violet, Methyl Green, Crystal Violet, Basic Fuchsin, Methyl Violet 2B, Quinaldine Red, Rose Bengal, Metanil Yellow, thymolsulfophthalein, Xylenol Blue, Methyl Orange, Paramethyl Red, Congo Red, Benzopurpurin 4B, α-Naphthyl Red, Nile Blue 2B, Nile Blue A, Methyl Violet, Malachite Green, Parafuchsin, Victoria Pure Blue BOH (produced by Hodogaya Chemical Co., Ltd.), Oil Blue #603 (Orient Chemical Industries, Ltd.), Oil Pink #312 (Orient Chemical Industries, Ltd.), Oil Red 5B (Orient Chemical Industries, Ltd.), Oil Scarlet #308 (Orient Chemical Industries, Ltd.), Oil Red OG (Orient Chemical Industries, Ltd.), Oil Red RR (Orient Chemical Industries, Ltd.), Oil Green #502 (Orient Chemical Industries, Ltd.), Spiron Red BEH Special (Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-β-naphthyl-4-p-diethylaminophenylimino-5-pyrazolone; and leuco dyes such as p,p',p"-hexamethyltriaminotriphenylmethane (Leuco Crystal Violet) and Pergascript Blue SRB (Ciba Geigy).

In addition to the above, leuco dyes known to be used in heat-sensitive or pressure-sensitive paper may also be advantageously used as a printing-out agent. Specific examples include Crystal Violet Lactone, Malachite Green Lactone, Benzoyl Leucomethylene Blue, 2-(N-phenyl-N-methylamino)-6-(N-p-tolyl-N-ethyl)aminofluoran, 2-anilino-3-methyl-6-(N-ethyl-p-toluidino)fluoran, 3,6-dimethoxyfluoran, 3-(N,N-diethylamino)-5-methyl-7-(N,N-dibenzylamino) fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethylamino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-azaphthalide and 3-(4-diethylaminophenyl)-3-(1-ethyl-2-methylindol-3-yl)phthalide.

In the practice of the invention, such printing-out agents may be used singly or in combination of two or more.

The amount of printing-out agent added to the image recording layer is preferably 0.01 to 15 wt%, based on the total solids in the image recording layer.

(Polymerization Inhibitor)

To prevent unwanted thermal polymerization of the radical polymerizable compound during production or storage of the image recording layer, it is desirable to add a small amount of a thermal polymerization inhibitor to the image recording layer of the presensitized plate employed in the inventive platemaking method.

Preferred examples of the thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol) and aluminum N-nitroso-N-phenylhydroxylamine.

In the practice of the invention, such polymerization inhibitors may be used singly or in combination of two or more.

The amount of polymerization inhibitor added to the image recording layer is preferably from about 0.01 wt% to about 5 wt %, based on the total solids in the image recording layer.

(Higher Fatty Acid Derivative)

In the image recording layer of the presensitized plate employed in the inventive platemaking method, to prevent oxygen from inhibiting polymerization, a higher fatty acid derivative such as behenic acid or behenamide may be added and induced to concentrate primarily at the surface of the image recording layer as the layer dries after coating.

In the practice of the invention, such higher fatty acid derivatives may be used singly or in combination of two or more.

The higher fatty acid derivative is included in the image recording layer in an amount of preferably about 0.1 to about 10 wt%, based on the total solids in the image recording layer.

(Plasticizer)

The image recording layer of the presensitized plate employed in the inventive platemaking method may contain a plasticizer.

Preferred examples of the plasticizer include phthalic acid esters such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate and diallyl phthalate; glycol esters such as dimethyl glycol phthalate, ethyl

phthalyl ethyl glycolate, methyl phthalyl ethyl glycolate, butyl phthalyl butyl glycolate, and triethylene glycol dicaprylate; phosphoric acid esters such as tricresyl phosphate and triphenyl phosphate; dibasic fatty acid esters such as diisobutyl adipate, dioctyl adipate, dimethyl sebacate, dibutyl Sebacate, dioctyl azelate and dibutyl maleate; and polyglycidyl methacrylate, triethyl citrate, triacetyl glycerine and butyl laurate.

In the practice of the invention, such plasticizers may be used singly or in combination of two or more.

The plasticizer content in the image recording layer is preferably not more than about 30 wt%, based on the total solids in the image recording layer.

(Fine Inorganic Particles)

The image recording layer of the presensitized plate employed in the inventive platemaking method may contain fine inorganic particles to improve the strength of the cured film in image areas.

Preferred examples include finely divided silica, alumina, magnesium oxide, titanium oxide, magnesium carbonate, calcium alginate, and mixtures thereof. Even if these do not convert light to heat, they can be used for such purposes as strengthening the film and strengthening interfacial adhesion due to surface roughening.

The fine inorganic particles have an average size of preferably 5 nm to 10 $\mu$m, and more preferably 0.5 $\mu$m to 3 $\mu$m. Within this range, they disperse stably in the image recording layer, enabling the image recording layer to maintain a sufficient degree of film strength and enabling the formation of non-image areas having excellent hydrophilic properties that are not prone to scumming during printing.

Fine inorganic particles of this type are readily available as commercial products, such as in the form of colloidal silica dispersions.

Any one type or combinations of two or more types of such fine inorganic particles may be used in the practice of the invention.

The content of these fine inorganic particles in the image recording layer is preferably not more than 20 wt%, and more preferably not more than 10 wt%, based on the total solids in the image recording layer.

(Low-Molecular-Weight Hydrophilic Compound)

To improve developability, the image recording layer of the presensitized plate employed in the inventive platemaking method may contain a low-molecular-weight hydrophilic compound.

Illustrative examples of suitable low-molecular-weight hydrophilic compounds include the following water-soluble organic compounds: glycols such as ethylene glycol, diethylene glycol, triethylene glycol, propylene glycol, dipropylene glycol and tripropylene glycol, as well as ether or ester derivatives thereof; polyhydroxy compounds such as glycerol and pentaerythritol; organic amines such as triethanolamine, diethanolamine and monoethanolamine, as well as salts thereof; organic sulfonic acids such as toluenesulfonic acid and benzenesulfonic acid, as well as salts thereof; organic phosphonic acids such as phenylphosphonic acid, as well as salts thereof; and organic carboxylic acids such as tartaric acid, oxalic acid, citric acid, malic acid, lactic acid, gluconic acid and amino acids, as well as salts thereof.

Such low-molecular-weight hydrophilic compounds may be used singly or in combination of two or more thereof in the invention.

The content of such low-molecular-weight hydrophilic compound in the image recording layer is preferably not more than 20 wt%, and more preferably not more than 10 wt%, based on the total solids in the image recording layer.

In the practice of the invention, suitable methods for incorporating the above constituents (polymerization initiator, polymerizable compound, and hydrophobic binder polymer, as well as the following ingredients which may be added if desired: infrared absorber, sensitizer, hydrophilic polymer, surfactant, colorant, printing-out agent, polymerization inhibitor, higher fatty acid derivative, plasticizer, fine inorganic particles and low-molecular-weight hydrophilic compound) in the image recording layer include methods, like those described in JP 2001-277740 A and JP 2001-277742 A, in which some of the above constituents are encapsulated in microcapsules. Alternatively, all of the above ingredients used to form the image recording layer may be encapsulated in microcapsules.

In the practice of the invention, when microcapsules are used, the respective constituents may be included inside and outside the microcapsules in an arbitrarily determined ratio.

Other known methods may be used for microencapsulating the constituents of the image recording layer. Illustrative examples include the methods involving the use of coacervation described in US 2,800,457 and US 2,800,458; the methods that rely on interfacial polymerization described in US 3,287,154, JP 38-19574 B and JP 42-446 B; the methods involving polymer precipitation described in US 3,418,250 and US 3,660,304; the method that uses an isocyanate polyol wall material described in US 3,796,669; the method that uses an isocyanate wall material described in US 3,914,511; the methods that use a ureaformaldehyde or urea formaldehyde-resorcinol wall-forming material which are described in US 4,001,140, 4,087,376 and 4,089,802; the method which uses wall materials such as melamine-formaldehyde resins and hydroxycellulose that is described in US 4,025,445; the in situ methods involving monomer polymerization that are taught in JP 36-9163 B and JP 51-9079 B; the spray drying processes described in GB 930,422 B and US 3,111,407; and the electrolytic dispersion cooling processes described in GB 952,807 B and GB 967,074 B.

Microcapsule walls preferred for use in this invention are those which have three-dimensional crosslinkages and are solvent-swellable. Accordingly, it is preferable for the microcapsule wall material to be at least one selected from the group consisting of polyurea, polyurethane, polyester, polycarbonate and polyamide. Polyurea and/or polyurethane are especially preferred.

The microcapsule wall may include therein a compound having a crosslinkable functional group such as an ethylenically unsaturated bond that can be introduced into the above-described water-insoluble polymer.

In the practice of the invention, the microcapsule is preferably one having an average particle size of 0.01 to 3.0 μm, more preferably 0.05 to 2.0 μm, and most preferably 0.10 to 1.0 μm. At a microcapsule average particle size within this range, it is possible to obtain a good resolution and a good stability over time.

The image recording layer of the presensitized plate employed in the inventive platemaking method can be formed by coating the lithographic printing plate support with a coating fluid prepared by dispersing or dissolving the various above-described constituents in a solvent. Alternatively, the image recording layer can be formed by dispersing or dissolving the same or different constituents from among those described above in the same or different solvents to prepare a plurality of coating fluids, applying the prepared coating fluids a plurality of times, and repeatedly drying.

Specific examples of the solvent include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water. These may be used alone or as mixtures of two or more thereof.

The coating fluid used in the invention has a solids concentration of preferably 1 to 50 wt%.

Any of various coating methods may be used in the practice of the invention. Examples of suitable methods of coating include bar coating, spin coating, spray coating, curtain coating, dip coating, air knife coating, blade coating and roll coating.

The image recording layer coating weight (solids content) on the support obtained after coating and drying varies depending on the intended application, although an amount of 0.3 to 3.0 $g/m^2$ is generally preferred. At an image recording layer coating weight within this range, a good sensitivity and good image recording layer film properties are obtained.

<Undercoat Layer>

In the presensitized plate employed in the inventive platemaking method, it is desirable to provide an undercoat layer of a polymerizable group-bearing compound on the lithographic printing plate support.

When an undercoat layer is provided, the image recording layer is provided on the undercoat layer. In exposed areas, the undercoat layer strengthens adhesion between the support and the image recording layer. In unexposed areas, the undercoat layer facilities separation of the image recording layer from the support, thus improving the developability.

Preferred examples of the undercoat layer include the addition polymerizable ethylenic double bond reactive group-bearing silane coupling agents mentioned in JP 10-282679 A, and the ethylenic double bond reactive group-bearing phosphorus compounds mentioned in JP 2-304441 A. Compounds having a polymerizable group, such as methacryl or allyl, and a group that adsorbs to the support, such as a sulfonate group, phosphate or phosphate ester group, are more preferred. Compounds which also have, in addition to a polymerizable group and a group which adsorbs to the support, a hydrophilicity imparting group such as an ethylene oxide group are also preferred.

The coating weight (solids) of the undercoat layer is preferably from 0.1 to 100 $mg/m^2$, and more preferably from 1 to 30 $mg/m^2$.

<Protective Layer>

In the presensitized plate used in the inventive platemaking method, the image recording layer may optionally have a protective layer formed thereon to prevent scuffing and other damage to the image recording layer, to serve as an oxygen barrier, and to prevent ablation during exposure to a high-intensity laser.

In the practice of the invention, imagewise exposure in the subsequently described image recording step is ordinarily carried out under conditions open to the atmosphere. A protective layer prevents oxygen and low-molecular-weight compounds such as basic substances which are present in the atmosphere and would interfere with the radical polymerization reactions triggered by light exposure in the image recording layer from entering the image recording layer, thus keeping the image-forming reactions triggered by exposure under open-air conditions from being hindered. Therefore the properties desired of the protective layer preferably include a low permeability of oxygen and low-molecular-weight compounds such as basic compounds, good transmittance of the light used for exposure, excellent adhesion to the image recording layer, and ready removal with an aqueous solution during a simple developing step following exposure.

Various protective layers endowed with such properties have been investigated and are closely described in, for example, US 3,458,311 and JP 55-49729 B.

Materials that may be used in the protective layer include water-soluble polymeric compounds having a relatively good crystallinity, such as polyvinyl alcohol (PVA), polyvinyl pyrrolidone, acidic celluloses, gelatin, gum arabic and polyacrylic acid. Of these, the use of polyvinyl alcohol as the primary component provides the best results with respect to basic properties such as the oxygen barrier properties and removability of the protective layer during development.

So long as the polyvinyl alcohol includes unsubstituted vinyl alcohol units which provide the protective layer with the required oxygen barrier properties and water solubility, some of the vinyl alcohol units may be substituted with esters, ethers or acetals, and the layer may include also other copolymerizable components.

It is preferable for the polyvinyl alcohol to be 71 to 100% hydrolyzed and to have a degree of polymerization in a range of 300 to 2,400. Specific examples of such polyvinyl alcohols include the following, all produced by Kuraray Co., Ltd.: PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8.

In the practice of the invention, conditions such as the protective layer ingredients (choice of PVA, use of additives, etc.) and coating weight may be suitably selected after taking into consideration not only the oxygen barrier properties and the removability during development, but also other characteristics, including the antifogging properties, adhesion, and scuff resistance of the protective layer.

In general, a higher percent hydrolysis of the PVA (i.e., a higher content of unsubstituted vinyl alcohol units in the protective layer) and a greater film thickness provides higher oxygen barrier properties, resulting in better sensitivity. Moreover, to prevent undesirable polymerization reactions from occurring during production and storage, to prevent fogging during imagewise exposure, and to prevent thick image lines and other unwanted effects, it is preferable for the oxygen permeability to be not too high. Specifically, an oxygen permeability A at 25˚C and a pressure of not more than one atmosphere such that $0.2 \le A \le 20$ cc/m$^2$·day is preferred.

To enhance its flexibility, the protective layer may include other ingredients such as glycerol and dipropylene glycol in an amount corresponding to several weight percent based on the above-described water-soluble polymeric compound. Moreover, several weight percent, based on the above water-soluble polymeric compound, of anionic surfactants such as sodium alkylsulfates and sodium alkylsulfonates; amphoteric surfactants such as alkyl aminocarboxylates and alkyl aminodicarboxylates; and nonionic surfactants such as polyoxyethylene alkyl phenyl ethers may be added.

When such a protective layer, which is hydrophilic because it contains a water-soluble polymeric compound, is laminated onto the oleophilic image recording layer, the protective layer has a tendency to delaminate owing to out-of-contact defects. In areas of delamination, defects such as poor curing of the film may arise due to the inhibition of polymerization caused by oxygen.

Therefore, in the practice of the invention, properties such as adhesion of the protective layer to image areas and scuff resistance, are also very important in the handling of the presensitized plate.

Various proposals have been made for improving adhesion between the image recording layer and the protective layer. For example, JP 49-70702 A and GB 1,303,578 B mention that sufficient adhesion can be achieved by mixing 20 to 60 wt% of an acrylic emulsion or a water-insoluble vinyl pyrrolidone-vinyl acetate copolymer into a hydrophilic polymer composed primarily of polyvinyl alcohol, and laminating the resulting mixture onto the image recording layer. Any such known art may be employed for this purpose when working the present invention.

Other functions may also be imparted to the protective layer. For example, by adding a colorant (e.g., a water-soluble dye) which has an excellent transmittance of the infrared light used for exposure and can efficiently absorb light of other wavelengths, the amenability of the presensitized plate to handling under a safelight can be improved without lowering the sensitivity.

In the practice of the invention, the protective film has a film thickness of preferably 0.1 to 5 μm, and more preferably 0.2 to 2 μm.

Specific examples of methods that may be used to apply the protective layer are described in US 3,458,311 and JP 55-49729 B.

<Back Coat>

In the presensitized plate employed in the inventive platemaking method, if necessary, after the lithographic printing plate support has been surface-treated or an undercoat has been formed thereon, a back coat may be provided on the back side of the lithographic printing plate support.

The back coat is preferably a metal oxide coat obtained by the hydrolysis and polycondensation of the organic polymeric compounds mentioned in JP 5-45885 A or the organic or inorganic metal compounds mentioned in JP 6-35174 A. Of these coats, alkoxy compounds of silicon, such as $Si(OCH_3)_4$, $Si(OC_2H_5)_4$, $Si(OC_3H_7)_4$ and $Si(OC_4H_9)_4$, are preferred because they are inexpensive and readily available.

The inventive platemaking method includes an image recording step in which an image is recorded on the presensitized plate by imagewise exposure, and a developing step in which a lithographic printing plate is obtained by using a specific aqueous solution (developer) to carry out development on the presensitized plate on which an image has been recorded.

The image recording step and developing step are described in detail below.

[IMAGE RECORDING STEP]

In the image recording step, an image is recorded onto the above-described presensitized plate by imagewise exposure.

Here, "imagewise exposure" refers to exposure in an image-wise manner through a transparent original bearing, for example, a line image or a halftone image, or exposure in an image-wise manner as by laser scanning based on digital data. Specific examples of suitable light sources for exposure include carbon arc lamps, mercury vapor lamps (particularly high-pressure mercury vapor lamps), xenon lamps, metal halide lamps, fluorescent lamps, tungsten lamps, halogen lamps, strobe lights, ultraviolet lasers, visible light lasers, and infrared lasers.

Of these, the use of a laser is especially preferred. Specific examples of preferred lasers include solid-state lasers and semiconductor lasers which emit infrared light at a wavelength of 760 to 1200 nm, UV semiconductor lasers which emit light at wavelengths of 250 to 420 nm, argon ion lasers which emit visible light, and FD-YAG lasers. Of these, to simplify platemaking, a laser which emits infrared or ultraviolet light that allows one to work under a white light or a yellow light is preferred.

Moreover, when a laser is used, scanning and exposure in an imagewise manner based on digital data is preferred. To shorten the exposure time, it is desirable to use a multi-beam laser device.

[DEVELOPING STEP]

In the developing step, the presensitized plate on which an image has been recorded in the foregoing image recording step is developed using a specific aqueous solution (developer), thereby giving a lithographic printing plate.

Here, the specific developer used in the platemaking method of the invention is an aqueous solution containing at least 1 wt%, preferably at least 3 wt%, of a nonionic surfactant and/or an anionic surfactant, and having a pH of 2 to 10, preferably 4 to 9.

Using such a specific developer makes the inventive platemaking method highly beneficial in terms of the environment and safety. Moreover, because carbon dioxide does not cause deterioration and the developability remains unchanged, printing plates of a uniform quality can be produced. This is probably because the developer has a pH of 2 to 10 and is thus acidic to weakly alkaline, and also because, owing to the fact that the developer is acidic to weakly alkaline, there is no need for the use of a replenisher to offset a drop in pH due to the absorption of carbon dioxide. In addition, using such a specific developer improves the developability of the presensitized plate and also improves the scumming resistance of the lithographic printing plate. The most likely reason is that the developer has a better ability to penetrate the image recording layer, in addition to which the dispersibility in the developer of the image recording layer components removed by development can be maintained, thus inhibiting the re-deposition of image recording layer components onto non-image areas.

The developer is described below.

<Developer>

The following anionic surfactants and nonionic surfactants may be included in the developer used in the platemaking method of the invention.

Exemplary anionic surfactants include fatty acid salts, abietic acid salts, hydroxyalkanesulfonates, alkanesulfonates, dialkylsulfosuccinates, linear alkylbenezenesulfonates, branched alkylbenzenesulfonates, alkylnaphthalenesulfonates, alkylphenoxypolyoxyethylene propylsulfonates, polyoxyethylene alkylsulfophenyl ether salts, sodium N-methyl-N-oleyltaurate, the disodium salts of N-alkylsulfosuccinic acid monoamides, petroleum sulfonates, sulfated castor oil, sulfated tallow oil, sulfates of fatty acid alkyl esters, alkyl sulfates, polyoxyethylene alkyl ether sulfates, fatty acid monoglyceride sulfates, polyoxyethylene alkylphenyl ether sulfates, polyoxyethylene styrylphenyl ether sulfates, alkyl phosphates, polyoxyethylene alkyl ether phosphates, polyoxyethylene alkylphenyl ether phosphates, partially saponified styrene-maleic anhydride copolymers, partially saponified olefin-maleic anhydride copolymers and naphthalenesulfonate-formalin condensates.

In the practice of the invention, the anionic surfactant is preferably one having a sulfonate anionic group or a sulfate monoester anionic group and also having an aromatic group which may be substituted. Preferred examples of such anionic surfactants include compounds of the formula (I) or (II) below.

$$R_1-SO_3^- \qquad (I) \qquad\qquad R_2-O-SO_3^- \qquad (II)$$

In the above formulas, $R_1$ and $R_2$ are each an alkyl, cycloalkyl, alkenyl, aralkyl or aryl group which may be substituted.

The alkyl group is exemplified by alkyl groups of 1 to 20 carbon atoms, suitable examples of which include methyl, ethyl, propyl, n-butyl, sec-butyl, hexyl, 2-ethylhexyl, octyl, decyl, dodecyl, hexadecyl and stearyl.

The cycloalkyl group may be monocyclic or polycyclic. Monocyclic cycloalkyl groups preferably have 3 to 8 carbon atoms; specific examples include cyclopropyl, cyclopentyl, cyclohexyl and cyclooctyl. Suitable examples of polycyclic cycloalkyl groups include adamantyl, norbornyl, isobornyl, camphanyl, dicyclopentyl, α-pinel and tricyclodecanyl.

The alkenyl group is preferably an alkenyl group having 2 to 20 carbon atoms, suitable examples of which include vinyl, allyl, butenyl, and cyclohexenyl.

The aralkyl group is preferably an aralkyl group having 7 to 12 carbon atoms, suitable examples of which include benzyl, phenethyl and naphthylmethyl.

The aryl group is preferably an aryl group having 6 to 15 carbon atoms, suitable examples of which include phenyl, tolyl, dimethylphenyl, 2,4,6-trimethylphenyl, naphthyl, anthryl and 9,10-dimethoxyanthryl.

Substituents that may be used include monovalent non-metallic atomic groups other than hydrogen atoms. Suitable examples include halogen atoms (fluorine, bromine, chlorine, iodine), hydroxy group, alkoxy groups, aryloxy groups, acyl groups, amide groups, ester groups, acyloxy groups, carboxy group, carboxylate anionic group and sulfonate anionic group.

Specific examples of the alkoxy groups in such substituents include ones having 1 to 40 carbon atoms, and preferably 1 to 20 carbon atoms, such as methoxy, ethoxy, propyloxy, isopropyloxy, butyloxy, pentyloxy, hexyloxy, dodecyloxy, stearyloxy, methoxyethoxy, poly(ethyleneoxy) and poly(propyleneoxy). Specific examples of the aryloxy groups include ones with 6 to 18 carbon atoms, such as phenoxy, tolyloxy, xylyloxy, mesityloxy, cumenyloxy, methoxyphenyloxy, ethoxyphenyloxy, chlorophenyloxy, bromophenyloxy and naphthyloxy. Specific examples of the acyl groups include ones having 2 to 24 carbon atoms, such as acetyl, propanoyl, butanoyl, benzoyl and naphthoyl. Specific examples of the amide groups include ones having 2 to 24 carbon atoms, such as acetamide, propionamide, dodecanamide, palmitamide, stearylamide, benzamide and naphthamide. Specific examples of the acyloxy groups include ones having 2 to 20 carbon atoms, such as acetoxy, propanoyloxy, benzoyloxy and naphthoyloxy. Specific examples of the ester groups include ones having 1 to 24 carbon atoms, such as methyl ester, ethyl ester, propyl ester, hexyl ester, octyl ester, dodecyl ester and stearyl ester groups. Use may also be made of combinations of two or more of these substituents.

Of the compounds of the formulas (I) and (II), to further enhance the scumming resistance of the lithographic printing plate obtained by the inventive platemaking method, it is preferable for the anionic surfactant to be a compound of the formula (I-A) or (I-B) below.

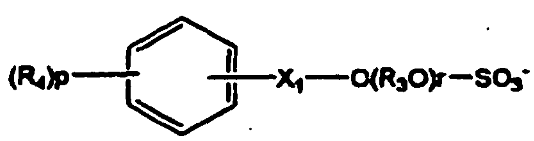

(I-A)

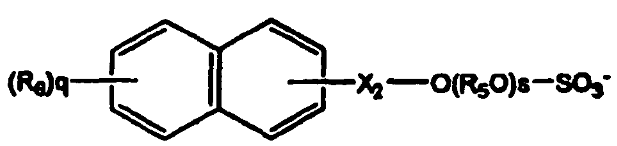

(I-B)

In the above formulas, $R_3$ and $R_5$ are each a linear or branched alkylene group of 1 to 5 carbon atoms; $R_4$ and $R_6$ are each a linear or branched alkylene group of 1 to 20 carbon atoms; the letters p and q are each 0, 1 or 2; $X_1$ and

$X_2$ are each a single bond or an alkylene group of 1 to 10 carbon atoms; and the letters r and s are each integers from 1 to 100. If the letters r or s is 2 or more, two or more different groups may be selected as $R_3$ or $R_5$.

Specific examples of compounds of the formulas (I) and (II) that are suitable as the anionic surfactant include the following.

$C_8H_{17}-SO_3^- Na^+$

(I-1)

$C_{12}H_{25}-SO_3^- Na^+$

(I-2)

$C_{14}H_{29}-SO_3^- Na^+$

(I-3)

$C_{16}H_{33}-SO_3^- Na^+$

(I-4)

$C_8H_{17}-O-CH_2CH_2-SO_3^- Na^+$

(I-5)

$C_{12}H_{25}-O-CH_2CH_2-SO_3^- Na^+$

(I-6)

$C_{12}H_{25}-O-(CH_2)_4-SO_3^- Na^+$

(I-7)

$C_{16}H_{33}-O-(CH_2)_4-SO_3^- Na^+$

(I-8)

$C_{11}H_{23}-CO-NH-CH_2CH_2-SO_3^- Na^+$

(I-9)

$C_{17}H_{33}-CO-NH-CH_2CH_2-SO_3^- Na^+$

(I-10)

$C_{17}H_{35}-CO-NH-CH_2CH_2-SO_3^- Na^+$

(I-11)

$C_{17}H_{33}-CO-NH-(CH_2)_4-SO_3^- Na^+$

(I-12)

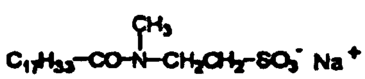

(I-13)

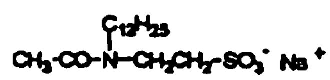

(I-14)

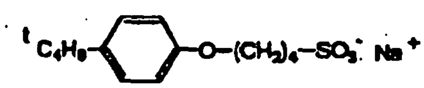

(I-15)

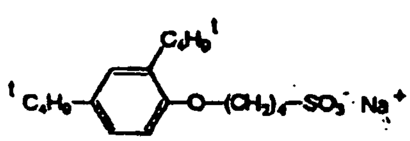

(I-16)

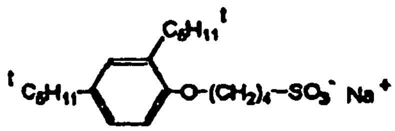

(I-17)

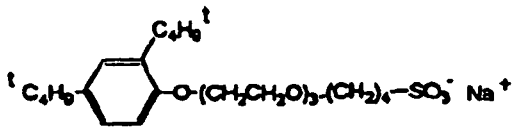

(I-18)

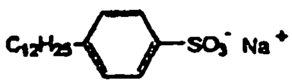

(I-19)

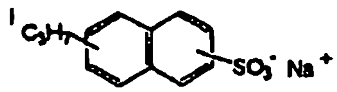

(I-20)

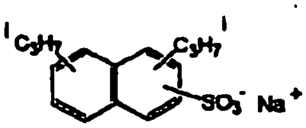

(I-21)

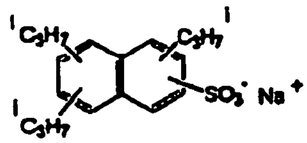

(I-22)

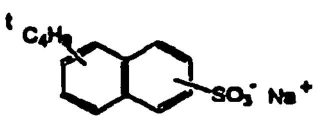

(I-23)

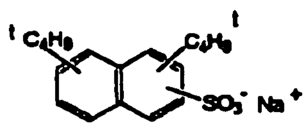

(I-24)

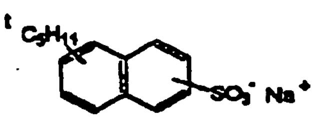

(I-25)

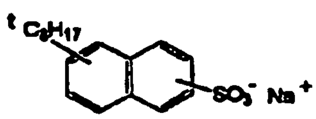

(I-26)

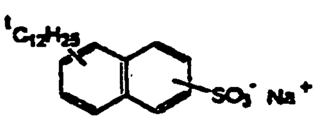

(I-27)

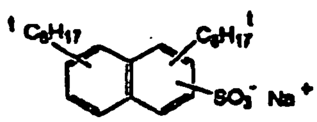

(I-28)

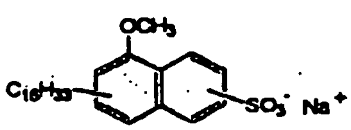

(I-29)

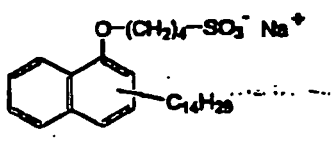

(I-30)

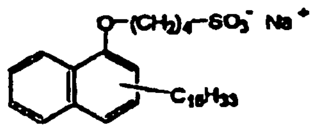

(I-31)

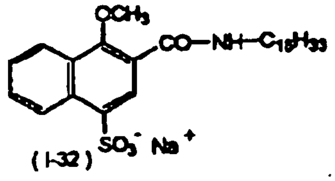

(I-32)

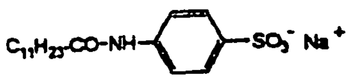

(I-33)

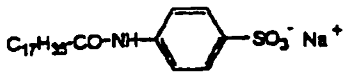

(I-34)

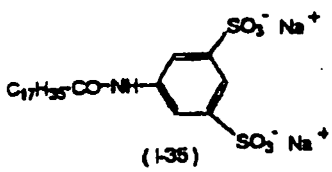

(I-35)

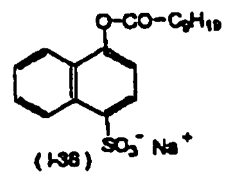

(I-36)

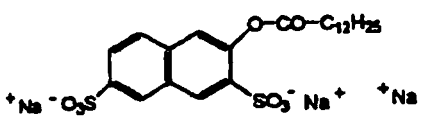

(I-37)

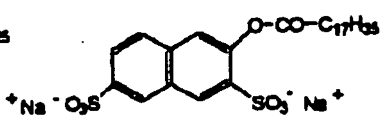

(I-38)

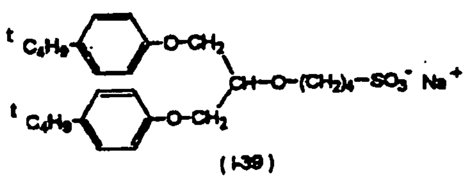

(I-39)

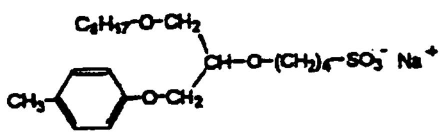

(I-40)

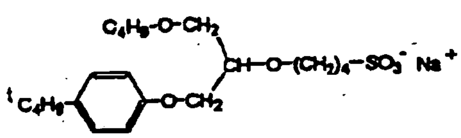

(I-41)

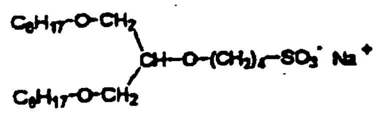

(I-42)

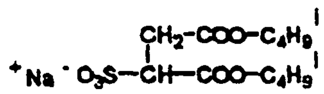

(I-43)

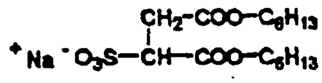

(I-44)

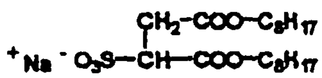

(I-45)

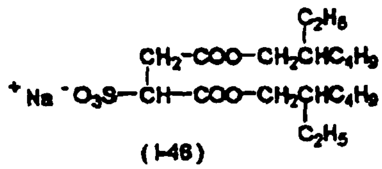

(I-46)

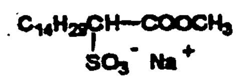

(I-47)

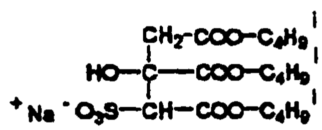

(I-48)

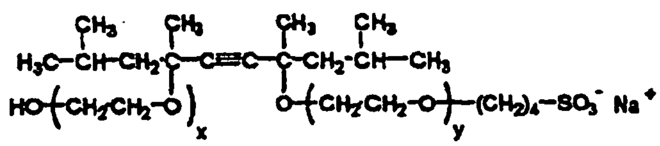

(I-49)

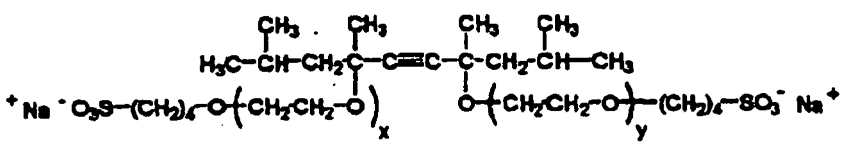

(I-50)

$C_8H_{17}-O-SO_3^-\ Na^+$

(II-1)

$C_{10}H_{21}-O-SO_3^-\ Na^+$

(II-2)

$C_{12}H_{25}-O-SO_3^-\ Na^+$

(II-3)

$C_{16}H_{33}-O-SO_3^-\ Na^+$

(II-4)

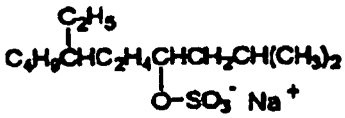

(II-5)

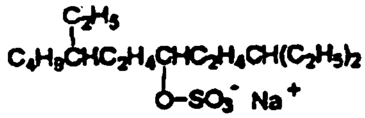

(II-6)

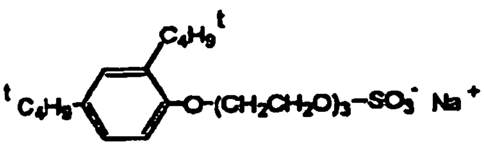

(II-7)

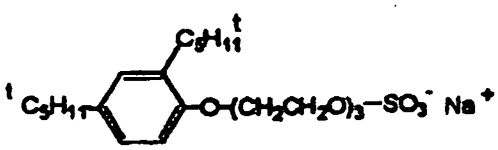

(II-8)

$^{+}Na\ ^{-}O_3S-O-(CH_2CH_2O)_x-SO_3^-\ Na^+$

(II-9)

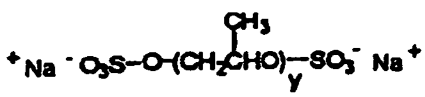

(II-10)

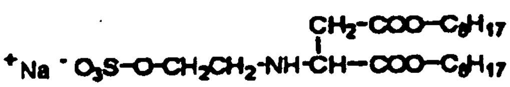

(II-11)

$C_{17}H_{35}CO-NH-CH_2CH_2-O-SO_3^-\ Na^+$

(II-12)

(II-13) 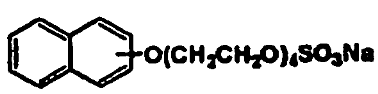

(II-14) 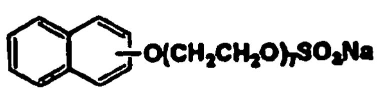

(II-15) 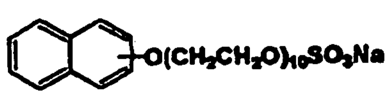

(II-16) 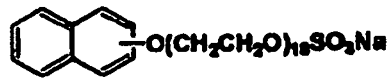

(II-17) 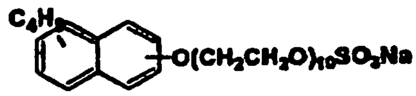

(II-18) 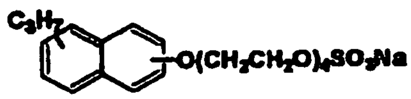

(II-19) 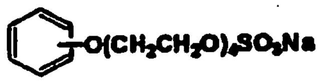

(II-20) 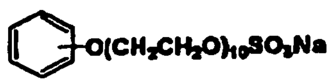

(II-21) 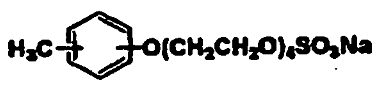

(II-22) 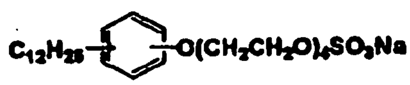

The letters x and y in the above examples are integers from 1 to 20 (each being average values) which indicate the number of repeating ethyleneoxy chains and propyleneoxy chains, respectively.

In the practice of the invention, the anionic surfactant content, based on the total weight of the developer, is preferably from 1 to 10 wt%, and more preferably from 2 to 10 wt%. When the anionic surfactant content falls within this range, the developer has an improved ability to penetrate the image recording layer and thus has an excellent developability (ability to dissolve the image recording layer). Moreover, the dispersibility in the developer of image recording layer components removed by development is easy to maintain, inhibiting the re-deposition ot image recording layer components onto non-image areas. As a result, the lithographic printing plate obtained following development has a good scumming resistance.

The compounds of the formulas (I) and (II) used as the anionic surfactant are generally commercially available. Such commercial products are manufactured by, inter alia, Asahi Denka Co., Ltd., Kao Corporation, Sanyo Chemical Industries, Ltd., New Japan Chemical Co., Ltd., Dai-ichi Kogyo Seiyaku Co., Ltd., Takemoto Oil & Fat Co., Ltd., Toho Chemical Industry Co., Ltd., and NOF Corporation.

Illustrative examples of nonionic surfactants include polyoxyethylene alkyl ethers, polyoxyethylene alkyl phenyl ethers, polyoxyethylene polyoxypropylene alkyl ethers, polyoxyethylene polystyrylphenyl ethers, partial fatty acid esters of glycerol, partial fatty acid esters of sorbitan, partial fatty acid esters of pentaerythritol, fatty acid monoesters of propylene glycol, partial fatty acid esters of sucrose, partial fatty acid esters of polyoxyethylene sorbitan, partial fatty acid esters of polyoxyethylene sorbitol, fatty acid esters of polyethylene glycol, partial fatty acid esters of polyglycerol, polyoxyethylenated castor oils, partial fatty acid esters of polyoxyethylene glycerol, polyoxyethylene diglycerols, fatty acid diethanolamides, N,N-bis-2-hydroxyalkylamines, polyoxyethylene alkyl amines, fatty acid esters of triethanolamine, trialkylamine oxides and polyoxyethylene-polyoxypropylene block copolymers.

In the practice of the invention, the nonionic surfactant is preferably a nonionic aromatic ether surfactant of the following formula (1)

$$X\text{-}Y\text{-}O\text{-}(A)_n\text{-}(B)_m\text{-}H \qquad (1)$$

In the formula (1), X is an aromatic group which may have substituents; Y is a single bond or an alkylene group of 1 to 10 carbon atoms; A and B are mutually differing groups and represent $-CH_2CH_2O-$ or $-CH_2CH(CH_3)O-$; and the letters n and m are both integers from 0 to 100, with the proviso that $n+m \geq 2$.

Specific examples of the aromatic group represented by X in the formula include phenyl, naphthyl and anthranyl. These aromatic groups may have substituents exemplified by organic groups of 1 to 100 carbon atoms. Examples of such organic groups include all organic groups of the formula (1-A) or (1-B) below. In the formula (1), when $m \geq 1$ and $n \geq 1$, A and B may each be a random copolymer or a block copolymer.

Of the nonionic aromatic ether surfactants of the formula (1), compounds of the formulas (1-A) and (1-B) below are preferred as the nonionic surfactant.

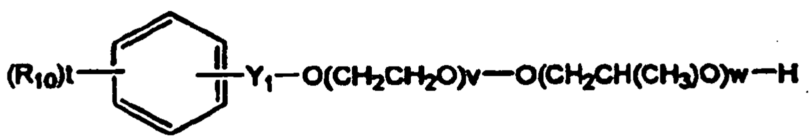

(1-A)

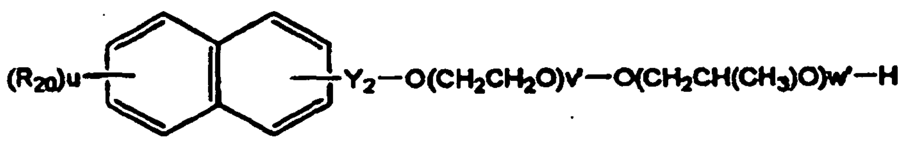

(1-B)

In the formulas (1-A) and (1-B), $R_{10}$ and $R_{20}$ are each a hydrogen atom or an organic group of 1 to 100 carbon atoms; the letters t and u each represent the integer 1 or 2; $Y_1$ and $Y_2$ are each a single bond or an alkylene group of 1 to 10 carbon atoms; and the letters v, w, v' and w' independently represent an integer from 0 to 100, with the proviso that $v+w \geq 2$ and $v'+w' \geq 2$.

In the formula (1-A), if the letter t is 2 and $R_{10}$ is an organic group of 1 to 100 carbon atoms, the two $R_{10}$ groups may be the same or different and taken together to form a single ring.

Also, in the formula (1-B), if the letter u is 2 and $R_{20}$ is an organic group of 1 to 100 carbon atoms, the two $R_{20}$ groups may be the same or different and taken together to form a single ring.

Here, the organic groups of 1 to 100 carbon atoms represented by $R_{10}$ and $R_{20}$ in the above formulas are exemplified by aliphatic hydrocarbon groups and aromatic hydrocarbon groups which may be saturated or unsaturated and may be linear or branched. Illustrative examples include alkyl groups, alkenyl groups, alkynyl groups, aryl groups, aralkyl groups, alkoxy groups, aryloxy groups, N-alkylamino groups, N,N-dialkylamino groups, N-arylamino groups, N, N-diarylamino groups, N-alkyl-N-arylamino groups, acyloxy groups, carbamoyloxy group, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, acylamino groups, N-alkylacylamino groups, N-arylacylamino groups, acyl groups, alkoxycarbonylamino groups, alkoxycarbonyl groups, aryloxycarbonyl groups, carbamoyl group, N-alkylcarbamoyl groups, -N,N-dialkylcarbamoyl groups, N-arylcarbamoyl groups, N,N-diarylcarbamoyl groups, N-alkyl-N-arylcarbamoyl groups, polyoxyalkylene chains, and any of the foregoing organic groups to which a polyoxyalkylene chain is bonded. The alkyl groups mentioned above may be linear or branched.

Preferred examples of these $R_{10}$ and $R_{20}$ groups include hydrogen atoms, linear or branched alkyl groups of 1 to 10 carbon atoms; alkoxy, alkoxycarbonyl, N-alkylamino, N,N-dialkylamino, N-alkylcarbamoyl, acyloxy or acylamino groups of 1 to 10 carbon atoms; polyoxyalkylene chains having about 5 to 20 recurring units, aryl groups of 6 to 20 carbon atoms, and aryl groups to which a polyoxyalkylene chain having about 5 to 20 recurring units is bonded.

In the formulas (1-A) and (1-B), v and v' are preferably from 3 to 50, and more preferably from 5 to 30. Similarly, w and w' are preferably from 0 to 10, and more preferably from 0 to 5. The polyoxyethylene moieties represented by v and v' and the polyoxypropylene moieties represented by w and w' may each be a random copolymer or a block copolymer.

Specific examples of nonionic aromatic ether surfactants of the formula (1-A) include polyoxyethylene phenyl

ether, polyoxyethylene methyl phenyl ether, polyoxyethylene octyl phenyl ether and polyoxyethylene nonyl phenyl ether.

Specific examples of nonionic aromatic ether surfactants of the formula (1-B) include polyoxyethylene naphthyl ether, polyoxyethylene methyl naphthyl ether, polyoxyethylene octyl naphthyl ether and polyoxyethylene nonyl naphthyl ether.

Other illustrative examples of nonionic aromatic ether surfactants of the formula (1-A) or (1-B) include the following.

| A-Y | |
|---|---|
| Y-1 | 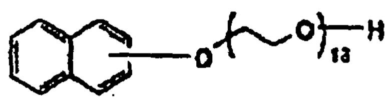 |
| Y-2 | 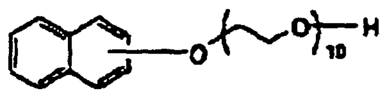 |
| Y-3 | 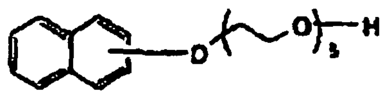 |
| Y-4 | 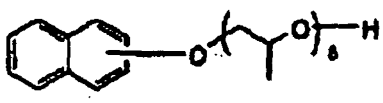 |
| Y-5 | 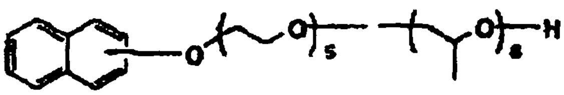 |
| Y-6 | 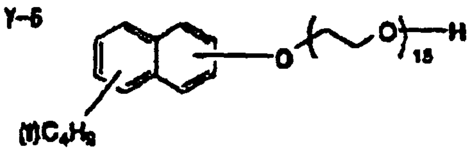 |
| Y-7 | 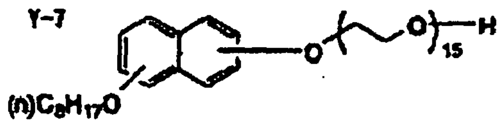 |
| Y-8 | 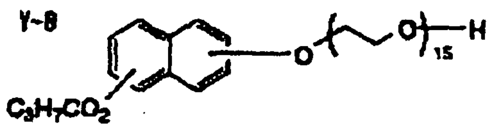 |
| Y-9 | 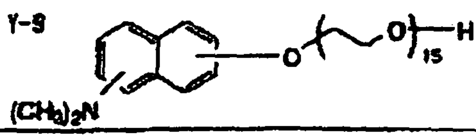 |

| A−W | |
|---|---|
| Y-10 | 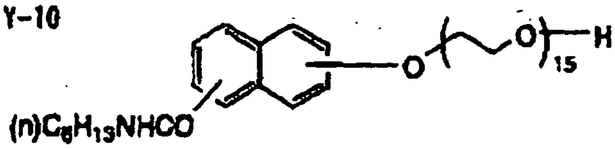 |
| Y-11 | 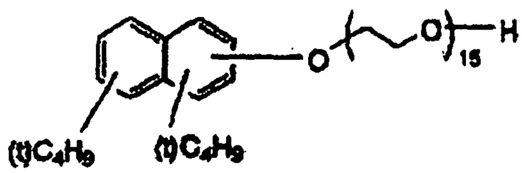 |
| Y-12 | 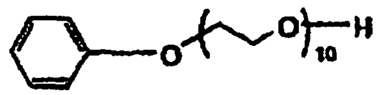 |
| Y-13 | 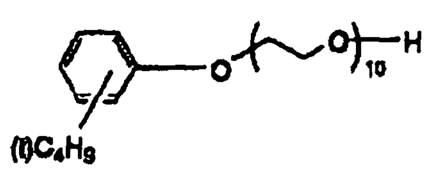 |
| Y-14 | 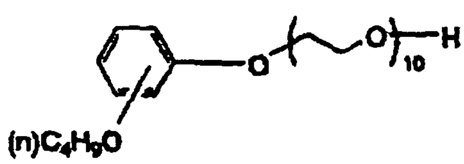 |
| Y-15 | 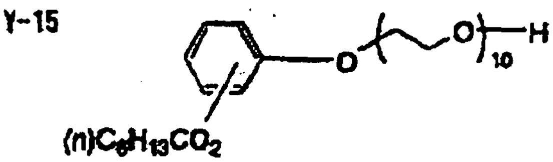 |
| Y-16 | 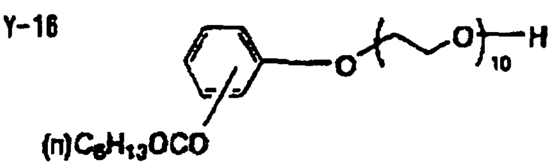 |

| | A−W |
|---|---|
| Y-17 | 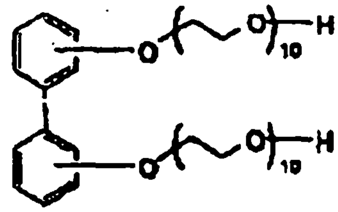 |
| Y-18 | 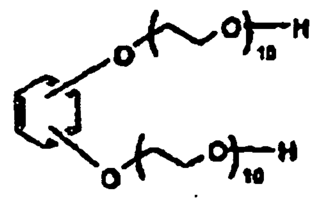 |
| Y-19 | 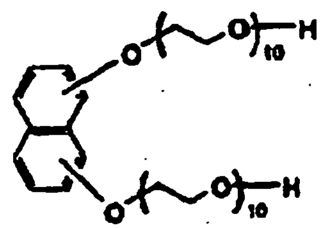 |
| Y-20 | 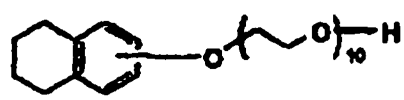 |
| Y-21 | 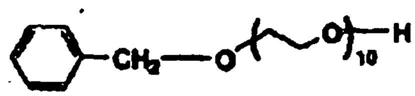 |
| Y-22 | 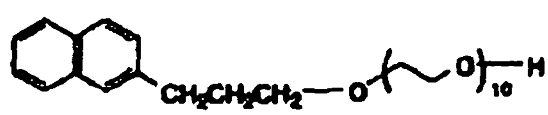 |

In the practice of the invention, the nonionic surfactant content is preferably from 1 to 20 wt%, and more preferably from 2 to 10 wt%, based on the total weight of the developer. When the nonionic surfactant content falls within this range, the developer has an improved ability to penetrate the image recording layer and thus has an excellent developability (ability to dissolve the image recording layer). Moreover, the dispersibility in the developer of image recording layer components removed by development is easy to maintain, minimizing the re-deposition of image recording layer components onto non-image areas. As a result, the lithographic printing plate obtained following development has a good scumming resistance.

In the practice of the invention, acetylene glycol- or acetylene alcohol-based oxyethylene addition products and fluorochemical or silicon-based anionic or nonionic surfactants may likewise be used as these surfactants (anionic surfactant and nonionic surfactant).

Such surfactants may also be used in combination of two or more. For example, it may be advantageous to use in combination two or more mutually differing anionic surfactants or nonionic surfactants, or to use in combination one or more anionic surfactants with one or more nonionic surfactants.

Moreover, it is desirable to suitably select and use such surfactants while taking into consideration their impact on the environment. As noted above, at least 1 wt% of a nonionic surfactant and/or an anionic surfactant is included,

based on the total weight of the developer.

In addition to the above-described surfactants, the presence of a water-soluble polymeric compound in the developer used in the inventive platemaking method is desirable for further enhancing the scumming resistance. This is because the water-soluble polymeric compound adsorbs onto non-image areas during development and, during operations such as mounting of the lithographic printing plate onto the press following development, serves to protect from contamination non-image areas that lie exposed.

Specific examples of water-soluble polymeric compounds include soybean polysaccharides, modified starches, gum arabic, dextrin, cellulose derivatives (e.g., carboxymethyl cellulose, carboxyethyl cellulose, methyl cellulose) and modified forms thereof, pullulan, polyvinyl alcohol and derivatives thereof, polyvinyl pyrrolidone, polyacrylamide and acrylamide copolymers, vinyl methyl ether-maleic anhydride copolymers, vinyl acetate-maleic anhydride copolymers and styrene-maleic anhydride copolymers.

Any known soybean polysaccharides may be used. For example, various grades of Soyafibe (manufactured by Fuji Oil Co., Ltd.), which are well known as commercial products, may be used. The use of those having a viscosity, as a 10 wt% aqueous solution, of 10 to 100 mPa/s is preferred.

Preferred examples of modified starches include those of the formula (I) below. Specific examples of the modified starches of formula (I) include corn, potato, tapioca, rice and wheat. Modification to achieve such modified starches is carried out by dissolving starch with an acid, enzyme to about 5 to 30 glucose residues per molecule, then adding oxypropylene in an alkali.

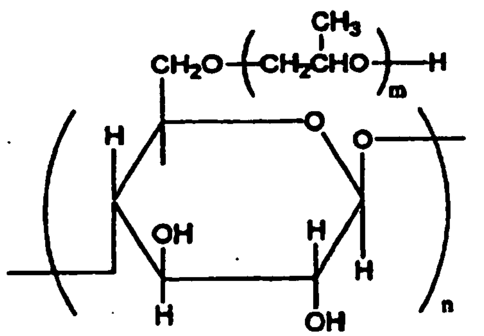

(I)

In the formula (I), the degree of etherification (degree of substitution) is from 0.05 to 1.2 per glucose unit, the letter n represents an integer from 3 to 30, and the letter m represents an integer from 1 to 3.

Especially preferred water-soluble polymeric compounds include soybean polysaccharides, modified starch, gum arabic, dextrin, carboxymethyl cellulose and polyvinyl alcohol.

In the practice of the invention, such water-soluble polymeric compounds may be used singly or in combination of two or more thereof.

The content of the water-soluble polymeric compound, based on the total weight of the developer, is preferably from 0.1 to 20 wt%, and more preferably from 0.5 to 10 wt%.

In addition to the above components, the developer used in the inventive platemaking method may also include wetting agents, preservatives, chelating compounds, antiforming agents, organic acids, organic solvents, inorganic acids and inorganic salts.

Preferred wetting agents include ethylene glycol, propylene glycol, triethylene glycol, butylene glycol, hexylene glycol, diethylene glycol, dipropylene glycol, glycerol, trimethylolpropane and diglycerol. These may be used singly, or in combination of two or more thereof.

In the practice of the invention, the content of the above wetting agent, based on the total weight of the developer, is preferably from 0.1 to 5 wt%.

Preferred preservatives include phenol and phenol derivatives, formalin, imidazole derivatives, sodium dehydroacetate, 4-isothiazolin-3-one derivatives, benzoisothiazolin-3-one, benzotriazole derivatives, amidine and guanidine derivatives, quaternary ammonium salts, derivatives of pyridine, quinoline and guanidine, diazine, triazole derivatives, oxazole, oxazine derivatives, and nitrobromo alcohols such as 2-bromo-2-nitropropan-1,3-diol, 1,1-dibromo-1-nitro-2-ethanol and 1,1-dibromo-1-nitro-2-propanol.

In the invention, the use of combinations of two or more of the above preservatives is preferred for efficacy against various molds and bacteria.

The content of the above-described preservative, which is an amount in which stable potency is exhibited against bacteria, molds, yeasts, will vary depending on the type of bacterium, mold or yeast. Generally, a preservative content of 0.01 to 4 wt%, based on the total weight of the developer, is preferred.

Illustrative examples of chelating compounds include organic phosphonic acids and phosphonoalkanetricarboxylic acids such as ethylenediaminetetraacetic acid and its potassium and sodium salts; diethylenetriaminepentaacetic acid and its potassium and sodium salts; triethylenetetraminehexaacetic acid and its potassium and sodium salts; hydroxyethylethylenediaminetriacetic acid and its potassium and sodium salts; nitrilotriacetic acid and its sodium salt; 1-hydroxyethane-1,1-diphosphonic acid and its potassium and sodium salts; and aminotri(methylenephosphonic acid) and its potassium and sodium salts. Organic amine salts of the above chelating agents may be effectively used instead of sodium and potassium salts.

In the practice of the invention, such chelating agents may be suitably selected from among those which are stable in developer compositions and do not compromise the printability.

The content of such a chelating agent, based on the total weight of the developer, is preferably from 0.001 to 1.0 wt%.

Antiforming agents that may be used include ordinary silicone-based self-emulsifying, or emulsifying, antiforming agents, and nonionic surfactant-type compounds having an HLB of 5 or less. Of these, a silicone foam inhibitor is preferred. Either an emulsion dispersing or a solubilizing type foam inhibitor may be used.

In the practice of the invention, the content of such an antiforming agent, based on the total weight of the developer, is preferably in a range of 0.001 to 1.0 wt%.

Illustrative examples of organic acids include citric acid, acetic acid, oxalic acid, malonic acid, salicylic acid, octanoic acid, tartaric acid, malic acid, lactic acid, levulinic acid, p-toluenesulfonic acid, xylenesulfonic acid, phytic acid and organic phosphonic acid. The organic acid may be used in the form of an alkali metal salt or ammonium salt thereof.

In the practice of the invention, the content of such an organic acid, based on the total weight of the developer, is preferably from 0.01 to 0.5 wt%.

Illustrative examples of inorganic acids and inorganic salts include phosphoric acid, metaphosphoric acid, monobasic ammonium phosphate, dibasic ammonium phosphate, monobasic sodium phosphate, dibasic sodium phosphate, monobasic potassium phosphate, dibasic potassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium bisulfate and nickel sulfate.

In the practice of the invention, the content of such an inorganic acid and an inorganic salt, based on the total weight of the developer, is preferably from 0.01 to 0.5 wt%.

If necessary, the developer used in the inventive platemaking method may be obtained by dissolving or dispersing the above components in water. The solids concentration in the developer is preferably from 1 to 20 wt%. It is also possible to prepare the developer in a concentrated form and dilute it with water at the time of use.

In the inventive platemaking method, examples of methods for bringing such a developer into contact with the presensitized plate in the developing step include manual processing, immersion processing and machine processing.

One method of manual processing involves thoroughly soaking a sponge or absorbent cotton with the developer, processing the plate while wiping the entire surface with the soaked sponge or cotton, then thoroughly rinsing the surface with water.

An example of an immersion processing method involves immersing the presensitized plate for about 60 seconds in a vat or deep tank filled with developer, stirring the developer, then thoroughly rinsing the plate with water while wiping it with absorbent cotton or a sponge.

Machine processing can be carried out using a gum coater or automatic processor of a type known to be used on conventional presensitized plates and CTP plates.

Exemplary automatic processors include machines which carry out processing by pumping up developer from a development tank and spraying it onto the plate from a spray nozzle, machines which use guide rolls to immerse the printed plate in the developer within a tank filled with developer and to pass the plate through the developer, and machines which carry out what may be referred to as "disposable" processing in which substantially unused developer is fed to each plate in exactly the required amount. Regardless of which type of automatic processor is used, it preferably has a rubbing mechanism that uses a brush or a Moulton roller. Use can also be made of an integrated apparatus which also includes therein a laser exposure section and an automated developer section.

[CONTACTING STEP]

To further improve the scumming resistance, it is preferable for the inventive platemaking method to have a contacting step in which the lithographic printing plate obtained from the foregoing developing step is brought into contact with an aqueous solution containing the above-described water-soluble polymeric compound. The reason for this is believed to be the same as the reason for the improvement in scumming resistance that results from including the water-soluble polymeric compound described earlier in the developer.

[DRYING STEP]

To facilitate subsequent handling, it is also preferable to include in the platemaking method of the invention a drying step in which the lithographic printing plate obtained from the developing step described above is dried. Exemplary drying methods include air drying or hot-air drying in which the plate is held in a drying chamber, and methods involving the use of a dryer that accompanies the gum coater or automatic processor.

In the inventive platemaking method, by using a lithographic printing plate support which has an arithmetical mean roughness $R_a$ of less than 0.4 $\mu$m and on a surface thereof a specific grained shape bearing recessed portions with an average opening diameter of 0.01 to 2.0 $\mu$m, the resulting lithographic printing plate will have both a good press life and a good scumming resistance. This is most likely because, as mentioned above, even when a small arithmetical mean roughness $R_a$ is provided in this way to achieve a good scumming resistance, the support having recessed portions with an average opening diameter of 0.01 to 2.0 $\mu$m enables enhancement of the adhesion to the image recording layer that is removable with a developer to be described later, thus enhancing the press life.

Also, in the inventive platemaking method, employing a specific developer having a pH of 2 to 10 and containing at least 1 wt% of a nonionic surfactant and/or an anionic surfactant is highly useful from the standpoint of the environment and safety. Moreover, because the developer employed is not degraded by carbon dioxide and always has a uniform developability, printing plates of a uniform quality and improved scumming resistance can be manufactured. As already noted above, the reasons for this appear to be that the developer employed has an acidic to weakly alkaline pH of 2 to 10, which eliminates the necessity for using a replenisher to offset a decline in pH due to the absorption of carbon dioxide, and also that, following development, non-image areas are further hydrophilized.

EXAMPLES

Examples are given below by way of illustration and not by way of limitation.

1. Fabrication of Aluminum Plate

Melts were prepared from aluminum alloys containing the various ingredients shown in Table 1 below (wt%), with the balance being aluminum and inadvertent impurities. The melts were subjected to molten metal treatment and filtration, then were cast into 500 mm thick, 1,200 mm wide ingots by a direct chill casting process. The ingots were scalped with a scalping machine, removing an average of 10 mm of material from the surface, then soaked and held at 550˚C for about 5 hours. When the temperature had fallen to 400˚C, the ingots were rolled on a hot rolling mill to a thickness of 2.7 mm. In addition, heat treatment was carried out at 500˚C in a continuous annealing furnace, following which cold rolling was carried out to a final thickness of 0.3 mm and a sheet width of 1060 mm, thereby giving Aluminum Plates 1 to 3.

In addition, an Aluminum Plate 4 was obtained in the same way as Aluminum Plate 1, except that an embossing roll was used in cold rolling.

Table 1

| Material | Composition (wt %) | | | | | | | |
|---|---|---|---|---|---|---|---|---|
| | Si | Fe | Cu | Mn | Mg | Cr | Zn | Ti |
| Aluminum 1 | 0.080 | 0.300 | 0.001 | 0.001 | 0.000 | 0.001 | 0.003 | 0.021 |
| Aluminum 2 | 0.076 | 0.270 | 0.023 | 0.001 | 0.000 | 0.001 | 0.003 | 0.021 |
| Aluminum 3 | 0.278 | 0.413 | 0.201 | 0.892 | 0.783 | 0.022 | 0.122 | 0.034 |

2. Fabrication of Lithographic Printing Plate Support

The aluminum plates obtained above were subjected to the surface treatment described below, thereby forming Lithographic Printing Plate Supports 1 to 10.

<Surface Treatment>

Surface treatment was effected by carrying out the following treatment operations (a) to (j) on the aluminum plates without interruption.

(a) Mechanical Graining Treatment

Using an apparatus like that shown in FIG. 4, mechanical graining treatment was carried out with a rotating roller-type nylon brush while feeding an abrasive slurry consisting of a suspension (specific gravity, 1.12) of abrasive (pumice) and water to the surface of each aluminum plate. FIG. 4 shows an aluminum plate 1, roller-type brushes 2 and 4, an abrasive slurry 3, and support rollers 5, 6, 7 and 8. The abrasive had an average particle size of 30 $\mu$m. The brushes were made of nylon 6/10 and had a bristle length of 50 mm and a bristle diameter of 0.3 mm. Each nylon brush was constructed of a 300 mm diameter stainless steel cylinder in which holes had been formed and bristles densely set. Three rotating brushes were used. Two support rollers (200 mm diameter) were provided below each brush and spaced 300 mm apart. The brushes were rotated at a speed of 200 rpm in the same direction as the direction in which the aluminum plate was moved. Following mechanical graining treatment, the aluminum plate had an arithmetical mean roughness $R_a$ of 0.45 $\mu$m.

(b) Etching with Aqueous Alkali Solution (First Etching Treatment)

Etching was carried out by using a spray line to spray the aluminum plate with an aqueous solution having a sodium hydroxide concentration of 370 g/L, an aluminum ion concentration of 100 g/L, and a temperature of 70˚C. The amount of material removed by etching from the surface of the aluminum plate to be subsequently electrochemically grained was 5 g/m$^2$.

The etching solution was then removed from the aluminum plate with nip rollers, following which the sheet was rinsed with water for 5 seconds using a spray line having spray tips which discharge a fan-like spray of water, and the water was removed with nip rollers.

(c) Desmutting with Aqueous Acid Solution (First Desmutting Treatment)

Desmutting was carried out by using a spray line to spray the aluminum plate with an aqueous solution having a sulfuric acid concentration of 170 g/L, an aluminum ion concentration of 5 g/L, and a temperature of 50˚C from a spray line for 5 seconds. Wastewater from the subsequently described anodizing treatment step (j) was used as the aqueous sulfuric acid solution.

The desmutting solution was then removed from the aluminum plate with nip rollers, following which the plate was rinsed with water for 5 seconds using a spray line having spray tips which discharge a fan-like spray of water, and the water was removed with nip rollers.

(d) Electrochemical Graining Treatment with Alternating Current in Aqueous Acid Solution (First Electrochemical Graining Treatment)

After being subjected to treatment (c), the aluminum plate was electrochemically grained using as the electrolytic solution an aqueous solution (temperature, 35˚C) having the hydrochloric acid, nitric acid and aluminum ion concentrations shown in Table 2, and using a power supply capable of generating an alternating current of the desired waveform by controlling the electrical current with an inverter that uses an IGBT device.

The waveform of the electrical current used, the rise time when the waveform is trapezoidal, the frequency of the electrical current used, the amount of electricity and the current ratio are each shown in Table 2. The amount of electricity is the total amount of electricity used during the reaction when the aluminum plate serves as the anode, and the current ratio is the ratio of the total amount of electricity during the reaction when the aluminum plate serves as the cathode to the total amount of electricity during the reaction when the aluminum plate serves as the anode. In the fabrication of the support 5, electrochemical graining treatment in an amount of electricity of 50 C/dm$^2$ was carried out eight times.

The current density (peak value of alternating current) during the reaction when the aluminum plate served as the anode was 50 A/dm$^2$, and the duty ratio was 0.5.

Concentration control of the electrolytic solution was carried out by adding the hydrochloric acid, nitric acid and water in amounts proportional to the amount of current to be passed through, based on a data table prepared beforehand, carrying out multi-component concentration measurement using capillary electrophoresis and, based on the results of measurement, correcting the amounts of hydrochloric acid, nitric acid and water added.

The solution was then removed from the aluminum plate with nip rollers, following which the plate was rinsed with water for 5 seconds using a spray line having spray tips which discharge a fan-like spray of water, and the water was removed with nip rollers.

(e) Etching with Aqueous Alkali Solution (Second Etching Treatment)

Etching was carried out by using a spray line to spray the aluminum plate with an aqueous solution having a sodium hydroxide concentration of 50 g/L, an aluminum ion concentration of 5 g/L, and a temperature of 35˚C. The amount of material removed by etching from the surface of the electrochemically grained aluminum plate is shown in Table 2.

The etching solution was then removed from the aluminum plate with nip rollers, following which the plate was rinsed with water for 5 seconds using a spray line having spray tips which discharge a fan-like spray of water, and the water was removed with nip rollers.

(f) Desmutting with Aqueous Acid Solution (Second Desmutting Treatment)

Desmutting was carried out by using a spray line to spray the aluminum plate with an aqueous solution having a sulfuric acid concentration of 170 g/L, an aluminum ion concentration of 5 g/L, and a temperature of 50˚C from a spray line for 5 seconds. Wastewater from the subsequently described anodizing treatment step (j) was used as the aqueous sulfuric acid solution.

The desmutting solution was then removed from the aluminum plate with nip rollers, following which the plate was rinsed with water for 5 seconds using a spray line having spray tips which discharge a fan-like spray of water, and the water was removed with nip rollers.

(g) Electrochemical Graining Treatment with Alternating Current in Aqueous Acid Solution (Second Electrochemical Graining Treatment)

After being subjected to treatment (f), the aluminum plate was electrochemically grained using as the electrolytic solution an aqueous solution (temperature, 35˚C) having the hydrochloric acid, nitric acid and aluminum ion concentrations shown in Table 2, and using a power supply capable of generating an alternating current of the desired waveform by controlling the electrical current with an inverter that uses an IGBT device.

The waveform of the electrical current used, the rise time when the waveform is trapezoidal, the frequency of the electrical current used, the amount of electricity and the current ratio are each shown in Table 2. The amount of electricity is the total amount of electricity used during the reaction when the aluminum plate serves as the anode, and the current ratio is the ratio of the total amount of electricity during the reaction when the aluminum plate serves as the cathode to the total amount of electricity during the reaction when the aluminum plate serves as the anode.

The current density (peak value of alternating current) during the reaction when the aluminum plate served as the anode was 50 $A/dm^2$, and the duty ratio was 0.5.

Concentration control of the electrolytic solution was carried out by adding the hydrochloric acid, nitric acid and water in amounts proportional to the amount of current to be passed through, based on a data table prepared beforehand, carrying out multi-component concentration measurement using capillary electrophoresis and, based on the results of measurement, correcting the amounts of hydrochloric acid, nitric acid and water added.

The solution was then removed from the aluminum plate with nip rollers, following which the plate was rinsed with water for 5 seconds using a spray line having spray tips which discharge a fan-like spray of water, and the water was removed with nip rollers.

(h) Etching with Aqueous Alkali Solution (Third Etching Treatment)

Etching was carried out by using a spray line to spray the aluminum plate with an aqueous solution having a sodium hydroxide concentration of 50 g/L, an aluminum ion concentration of 5 g/L, and a temperature of 35˚C. The amount of material removed by etching from the surface of the electrochemically grained aluminum plate is shown in Table 2.

The etching solution was then removed from the aluminum plate with nip rollers, following which the plate was rinsed with water for 5 seconds using a spray line having spray tips which discharge a fan-like spray of water, and the water was removed with nip rollers.

(i) Desmutting with Aqueous Acid Solution (Third Desmutting Treatment)

Desmutting was carried out by using a spray line to spray the aluminum plate with an aqueous solution having a sulfuric acid concentration of 170 g/L, an aluminum ion concentration of 5 g/L, and a temperature of 50˚C from a spray line for 5 seconds. Wastewater from the subsequently described anodizing treatment step (j) was used as the aqueous sulfuric acid solution.

The desmutting solution was then removed from the aluminum plate with nip rollers, following which the plate was rinsed with water for 5 seconds using a spray line having spray tips which discharge a fan-like spray of water, and the water was removed with nip rollers.

(j) Anodizing Treatment

A solution prepared by dissolving aluminum sulfate in an aqueous solution having a sulfuric acid concentration of 170 g/L to an aluminum ion concentration of 5 g/L was used as the electrolytic solution (temperature, 50˚C). Anodizing treatment was carried out in such a way that the average current density during the anode reaction on the aluminum plate was 15 A/dm$^2$. The weight of the anodized layer ultimately obtained was 2.7 g/m$^2$.

The electrolytic solution was then removed from the aluminum plate with nip rollers, following which the plate was rinsed with water for 5 seconds using a spray line having spray tips which discharge a fan-like spray of water, and the water was removed with nip rollers.

Table 2 (Dart 1)

| | Al plate | Mechanical graining treatment | First etching treatment | First desmutting treatment | First Electrochemical Graining Treatment | | | | | | | | Second etching treatment | Second desmutting treatment |
|---|---|---|---|---|---|---|---|---|---|---|---|---|---|---|
| | | | Amount of dissolved Al (g/m$^2$) | | Waveform | HCl conc. (g/L) | $HNO_3$ conc. (g/L) | Al ion conc. (g/L) | Current rise time (ms) | Amount of electricity (C/dm$^2$) | Current ratio | Frequency (Hz) | Amount of dissolved Al (g/m$^2$) | |
| Support 1 | 1 | - | 5.0 | yes | trapezoidal | - | 9.0 | 5.0 | 1.5 | 220 | 0.95 | 60 | 0.6 | yes |
| Support 2 | 1 | - | 5.0 | yes | trapezoidal | - | 12.0 | 5.0 | 1.5 | 250 | 0.95 | 60 | 1.0 | yes |
| Support 3 | 1 | - | 5.0 | yes | trapezoidal | - | 10.0 | 5.0 | 1.5 | 240 | 0.95 | 60 | 1.0 | yes |
| Support 4 | 2 | - | 5.0 | yes | trapezoidal | - | 10.0 | 5.0 | 1.5 | 300 | 0.95 | 60 | 2.0 | yes |
| Support 5 | 3 | - | 5.0 | yes | sinusoidal | 10.0 | - | 5.0 | - | 50 × 8 | 0.90 | 60 | 0.6 | yes |
| Support 6 | 1 | - | 5.0 | yes | - | - | - | - | - | - | - | - | - | - |
| Support 7 | 1 | - | 5.0 | yes | - | - | - | - | - | - | - | - | - | - |
| Support 8 | 4 | - | 5.0 | yes | - | - | - | - | - | - | - | - | - | - |
| Support 9 | 1 | yes | 5.0 | yes | trapezoidal | - | 9.0 | 5.0 | 1.5 | 185 | 0.95 | 60 | 1.0 | yes |
| Support 10 | 1 | - | 5.0 | yes | sinusoidal | 10.0 | - | 5.0 | - | 400 | 0.90 | 60 | 0.6 | yes |

Table 2 (part 2)

| | Second Electrochemical Graining Treatment | | | | | | | | Third etching treatment | Third desmutting treatment | Anodizing treatment |
|---|---|---|---|---|---|---|---|---|---|---|---|
| | Waveform | HCl conc. (g/L) | $HNO_3$ Conc. (g/L) | Al ion conc. (g/L) | Current rise time (ms) | Amount of electricity ($C/dm^2$) | Current ratio | Frequency (Hz) | Amount of dissolved Al ($g/m^2$) | | |
| Support 1 | - | - | - | - | - | - | - | - | - | yes | yes |
| Support 2 | - | - | - | - | - | - | - | - | - | yes | yes |
| Support 3 | trapezoidal | 7.5 | - | 4.5 | 0.8 | 50 | 0.95 | 60 | 0.15 | yes | yes |
| Support 4 | trapezoidal | 5.0 | - | 4.5 | 0.8 | 40 | 0.95 | 60 | 0.10 | yes | yes |
| Support 4 | - | - | - | - | - | - | - | - | - | yes | yes |
| Support 6 | trapezoidal | 5.0 | - | 4.5 | 0.8 | 100 | 0.95 | 60 | 0.10 | yes | yes |
| Support 7 | - | - | - | - | - | - | - | - | - | yes | yes |
| Support 8 | - | - | - | - | - | - | - | - | - | yes | yes |
| Support 9 | trapezoidal | 7.5 | - | 4.5 | 0.8 | 50 | 0.95 | 60 | 0.10 | yes | yes |
| Support 10 | - | - | - | - | - | - | | - | - | yes | yes |

In Table 2, a dash (-) indicates that the particular treatment in question was not carried out or that the particular component in question was not included.

3. Surface Examination of Lithographic Printing Plate Support

The surface shapes of each of the lithographic printing plate supports obtained were examined under a scanning electron microscope (JSM-5500, manufactured by JEOL, Ltd.; the same applies below) at a magnification of 50,000X, whereupon fine asperities having a diameter of 0.01 to 2.0 μm were found to have uniformly and densely formed on the surface. Table 3 gives the arithmetical mean roughness $R_a$ of the support surface and indicates whether or not recessed portions are present and the diameter of the recessed portions.

In Table 3, the entry "1.8/0.21" for Support 3 in the "Opening diameter" column signifies recessed portions of differing diameters (i.e., 1.8 μm and 0.21 μm) that together have a superposed structure. The same applies also to the data provided for Supports 4 and 9.

Table 3

| | $R_a$ (μm) | Recessed portions (0.01 to 2.0 μm) | |
|---|---|---|---|
| | | Present/Absent | Opening diameter (μm) |
| Support 1 | 0.24 | present | 0.8 |
| Support 2 | 0.23 | present | 1.4 |
| Support 3 | 0.27 | present | 1.8/0.21 |
| Support 4 | 0.34 | present | 2.8/0.16 |
| Support 5 | 0.22 | present | 0.08 |
| Support 6 | 0.20 | present | 0.1 |
| Support 7 | 0.21 | absent | - |
| Support 8 | 0.54 | absent | 3.7 |
| Support 9 | 0.45 | present | 1.2/0.18 |
| Support 10 | 0.44 | present | 0.2 |

4. Fabrication of Presensitized Plate A

An image recording layer coating fluid (1) was bar-coated onto Lithographic Printing Plate Supports 1 to 10 obtained as described above, then oven dried at 100°C for 75 seconds so as to form an image recording layer having a coating weight when dry of 1.0 g/m$^2$. In addition, a protective layer coating fluid of the composition indicated below was applied with a bar onto the image recording layer to a coating weight when dry of 1.0 g/m$^2$, then dried in an oven at 100°C for 90 seconds, thereby giving presensitized plates A1 to A10. Before providing the image recording layer, an undercoat layer was formed by applying onto the lithographic printing plate support an undercoating solution (1) of the composition indicated below and drying at 80°C for 15 seconds. The undercoat layer formed had a coating weight when dry of 15 mg/m$^2$.

The image recording layer coating fluid (1) was prepared by mixing and stirring together Photosensitive Solution (1) and Microcapsule Liquid (1) below just prior to coating.

<Undercoating Solution (1)>

Undercoating Compound (1) of the following formula 0.017 g

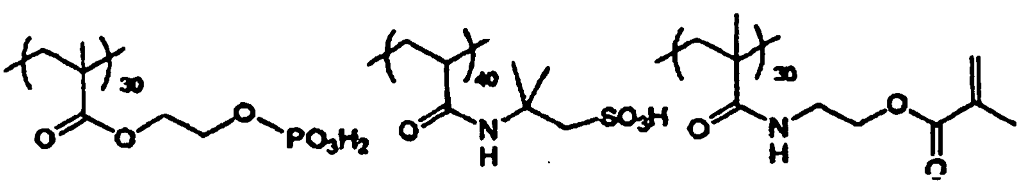

(continued)

| | |
|---|---|
| Methanol | 9.00 g |
| Water | 1.00 g |

<Photosensitive Solution (1)>

Binder Polymer (1) of the following formula 0.162 g

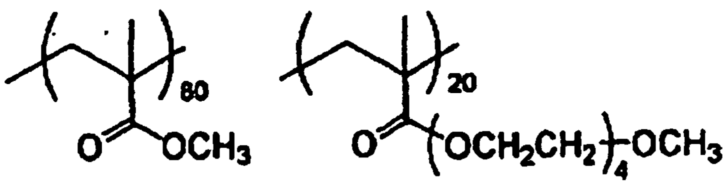

Polymerization Initiator (1) of the following formula 0.100 g

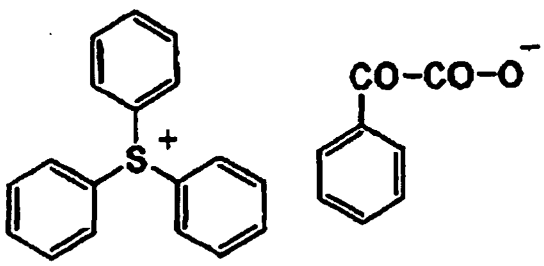

Infrared Absorber (1) of the following formula 0.020 g

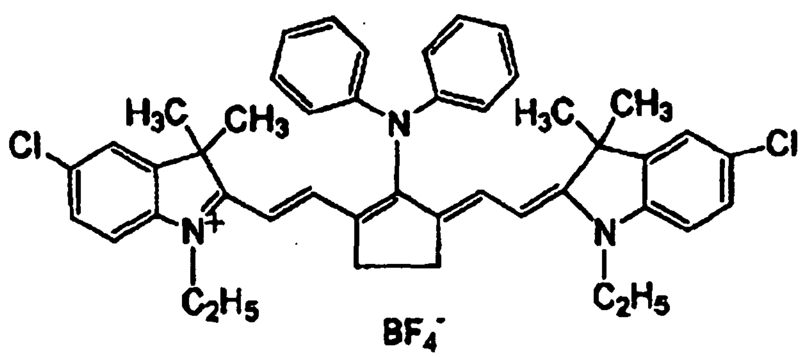

Polymerizable Compound (Aronix M-215; Toagosei Co., Ltd.) 0.385 g

Fluorochemical Surfactant (1) of the following formula 0.044 g

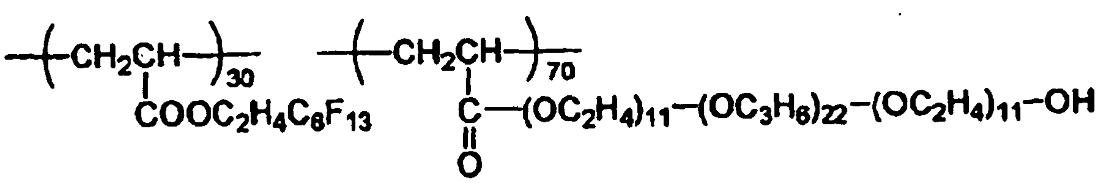

Methyl ethyl ketone 1.091 g

1 Methoxy 2 propanol 8.609 g

<Microcapsule Liquid (1)>

| | |
|---|---|
| Microcapsule liquid prepared as described below | |
| (solids equivalent) | 2.640 g |
| Water | 2.425 g |

(Preparation of Microcapsule Liquid (1))

An oil phase component was prepared by dissolving 10 g of an addition product of trimethylolpropane with xylene diisocyanate (Takenate D-110N, available as a 75% ethyl acetate solution from Mitsui Takeda Chemicals, Inc.), 6.00 g of Aronix M-215 (available from Toagosei Co., Ltd.), and 0.12 g of a surfactant (Pionin A-41C, available from Takemoto Oil & Fat Co., Ltd.) in 16.67 g of ethyl acetate. In addition, 37.5 g of an aqueous solution containing 4 wt% of PVA-205 was prepared as an aqueous phase component. The oil phase component and the aqueous phase component were mixed together, then emulsified using a homogenizer at 12,000 rpm for 10 minutes. The resulting emulsion was added to 25 g of distilled water, following which the mixture was stirred, first at room temperature for 30 minutes, then at 40˚C for 2 hours. The microcapsule liquid thus obtained was then diluted with distilled water to a solids concentration of 15 wt%. The microcapsules had an average particle size of 0.2 μm.

<Protective Layer Coating Fluid>

| | |
|---|---|
| Water | 88 g |
| Polyvinyl alcohol (PVA 105; Kuraray Co., Ltd.) | 10 g |
| Polyethylene glycol (molecular weight, 2000) | 2 g |
| Surfactant of the following formula | 1 g |

$$C_{12}H_{25}-O-(C_2H_4O)_8-H$$

5. Fabrication of Presensitized Plate B

An image recording layer coating fluid (2) of the composition indicated below was bar-coated onto Lithographic Printing Plate Supports 1 to 10 obtained as described above, then oven dried at 100˚C for 60 seconds so as to form an image recording layer having a coating weight when dry of 1.4 g/$m^2$. In addition, a protective layer coating fluid of the same composition as that described above was applied onto the image recording layer to a coating weight when dry of 0.5 g/$m^2$, then dried in an oven at 120˚C for 1 minute, thereby giving presensitized plates B1 to B10.

<Image Recording Layer Coating Fluid (2)>

| | |
|---|---|
| Binder Polymer (1) described above | 2.0 g |
| Polymerizable compound (EO-modified triacrylate of isocyanuric acid; Aronix M-315; Toagosei Co., Ltd.) | 1.5 g |
| Compound (1) below | 0.15 g |
| Compound (2) below | 0.20 g |
| Compound (3) below | 0.4 g |

(continued)

(1)

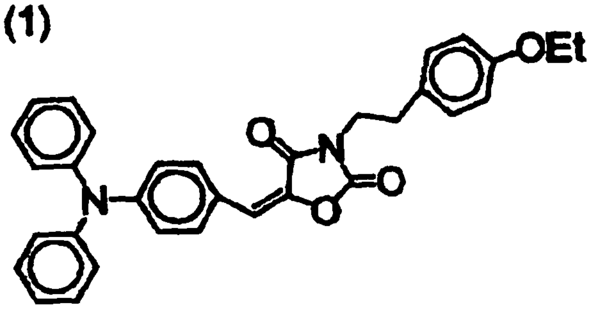

(2)

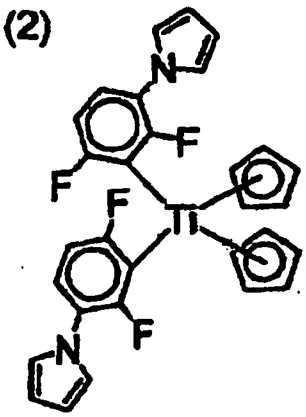

(3)

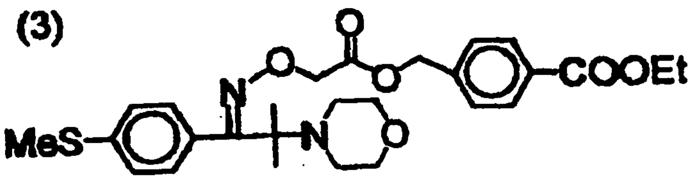

| | |
|---|---|
| Ethyl Violet | 0.1 g |
| Thermal polymerization inhibitor (aluminum N-nitroso-phenylhydroxylamine) | 0.1 g |
| Above-mentioned water-soluble fluorochemical surfactant (1) | 0.02 g |
| Tetraethylamine hydrochloride | 0.06 g |
| 1-Methoxy-2-propanol | 17.5 g |
| Methyl ethyl ketone | 19.0 g |

6. Preparation of Developer

Developers 1 to 6 having the compositions and pH values shown in Table 4 below were prepared. The units in the table are grams.

Table 4

| | Developer | | | | | |
|---|---|---|---|---|---|---|
| | 1 | 2 | 3 | 4 | 5 | 6 |
| Water | 9590 | 9590 | 9550 | 9370 | 8970 | 8970 |
| Anionic surfactant (II-13) | 400 | | 200 | | 400 | |
| Nonionic surfactant (Y-1) | | 400 | 200 | | | 400 |
| Ethylene glycol | | | 50 | | | |
| Gum arabic | | | | 150 | 150 | 150 |
| Acid-modified potato starch | | | | 400 | 400 | 400 |
| Sodium salt of dioctylsulfosuccinic acid ester | | | | 50 | 50 | 50 |
| Monobasic ammonium phosphate | | | | 10 | 10 | 10 |
| Citric acid | | | | 10 | 10 | 10 |
| Tetrasodium salt of EDTA | 10 | 10 | | 10 | 10 | 10 |

(continued)

| | Developer | | | | | |
|---|---|---|---|---|---|---|
| | 1 | 2 | 3 | 4 | 5 | 6 |
| Total | 10,000 | 10,000 | 10,000 | 10,000 | 10,000 | 10,000 |
| pH | 8 | 8 | 8 | 5 | 5 | 5 |

7. Evaluation of Platemaking

Each of the presensitized plates obtained was imagewise exposed using a Trendsetter 3244 VX (Creo Inc.) equipped with a water-cooled 40 W infrared semiconductor laser at an output of 9 W, an external drum speed of 210 rpm, and a resolution of 2,400 dpi.

<Developability>

Following imagewise exposure, the presensitized plates were subjected to development using the prepared Developers 1 to 6 or water.

Development was carried out using a processor like that shown in FIG. 5 by filling the developing tank 31 with one of Developers 1 to 6, or water, having a liquid temperature of 25°C, and passing the presensitized plate 34 through the liquid so as to form a lithographic printing plate. Also shown in FIG. 5 are delivery rollers 32. The time it takes for the plate to pass from the tank inlet to the tank outlet was set to 15 seconds. Additionally shown in FIG. 5 is a rotating brush 33, which was rotated at a speed of 280 mm/s in a positive direction relative to the direction in which the presensitized plate 34 was conveyed. Each of the lithographic printing plates discharged from the developing tank 31 was air-dried. In Table 5 below, the designation "1/4" at the top of one of the columns under "Developability" signifies that the plate was developed with Developer 1, then additionally developed with Developer 4. The same applies to the designation "3/4" elsewhere.

The developability was rated as "Exc" when the presensitized plate 34 was clearly developed just after passing through the rotating brush 33, as "Good" when the portion that emerged after passing through the delivery rollers 32 was developed, and as "NG" when residual portions of the image recording layer clearly remained after the plate had been discharged from the processor. The results are shown below in Table 5.

<Scumming Resistance>

After development with Developers 3 and 4, each air-dried lithographic printing plate was mounted in turn on the plate cylinder of a SOR-M printing press (Heidelberger Druckmaschinen AG). Next, dampening water (EU-3 (an etchant available from Fuji Photo Film Co., Ltd.)/water/isopropyl alcohol = 1/89/10 by volume) and TRANS-G (N) black ink (Dainippon Ink and Chemicals, Inc.) were supplied to the plate, following which 500 impressions were printed at a press speed of 6,000 impressions per hour.

The scumming resistance was rated as "Good" if normal impressions free of scumming in non-image areas were obtained in less than 30 copies after printing had begun, and was rated as "Fair" if it took 30 or more copies to start obtaining impressions free of scumming in non-image areas. The results are shown in Table 5.

<Press Life>

As in the scumming resistance test, after development with Developers 3 and 4, each air-dried lithographic printing plate was mounted in turn on the plate cylinder of a SOR-M printing press (Heidelberger Druckmaschinen AG). Next, dampening water (EU-3 (an etchant available from Fuji Photo Film Co., Ltd.)/water/isopropyl alcohol = 1/89/10 by volume) and TRANS-G (N) black ink (Dainippon Ink and Chemicals, Inc.) were supplied to the plate, following which 500 impressions were printed at a press speed of 6,000 impressions per hour.

The press life was rated by counting the number of clean impressions obtained after the start of printing; that is, the number of impressions that were free of scumming in non-image areas. The number of clean impressions in the case of the presensitized plate A9 was assigned an arbitrary value of 100, and the number of clean impressions obtained from the other lithographic printing plates were expressed relative to this value. The results are given in Table 5.

Table 5

| Support | Presensitized plate | Developability | | | | | | | | Scumming resistance (3/4) | Press life (3/4) |
|---|---|---|---|---|---|---|---|---|---|---|---|
| | | Developer No. | | | | | | | | | |
| | | 1 | 2 | 3 | 1/4 | 3/4 | 5 | 6 | Water NG | | |
| 1 | A1 | Exc | Exc | Exc | Exc | Exc | Exc | Exc | NG | Fair | 120 |
| 2 | A2 | Exc | Exc | Exc | Exc | Exc | Exc | Exc | NG | Fair | 105 |
| 3 | A3 | Exc | Exc | Exc | Exc | Exc | Exc | Exc | NG | Good | 100 |
| 4 | A4 | Exc | Exc | Exc | Exc | Exc | Exc | Exc | NG | Good | 110 |
| 5 | A5 | Exc | Exc | Exc | Exc | Exc | Exc | Exc | NG | Good | 40 |
| 6 | A6 | Exc | Exc | Exc | Exc | Exc | Exc | Exc | NG | Good | 40 |
| 7 | A7 | Exc | Exc | Exc | Exc | Exc | Exc | Exc | NG | Fair | 0 |
| 8 | A8 | Good | Good | Good | Good | Good | Good | Good | NG | Fair | 40 |
| 9 | A9 | Good | Good | Good | Good | Good | Good | Good | NG | Good | 100 |
| 10 | A10 | Good | Good | Good | Good | Good | Good | Good | NG | Good | 80 |
| 1 | B1 | Exc | | Exc | | Exc | | | | | |
| 2 | B2 | Exc | | Exc | | Exc | | | | | |
| 3 | B3 | Exc | | Exc | | Exc | | | | | |
| 4 | B4 | Exc | | Exc | | Exc | | | | | |
| 5 | B5 | Exc | | Exc | | Exc | | | | | |
| 6 | B6 | Exc | | Exc | | Exc | | | | | |
| 7 | B7 | Exc | | Exc | | Exc | | | | | |
| 8 | B8 | Good | | Good | | Good | | | | | |
| 9 | B9 | Good | | Good | | Good | | | | | |
| 10 | B10 | Good | | Good | | Good | | | | | |

As is apparent from the results in Table 5, when use was made of a presensitized plate having an image recording layer formed on a specific lithographic printing plate support having an arithmetical mean roughness $R_a$ of less than 0.4 μm and having on the surface thereof a grained shape with a structure bearing recessed portions having an average opening diameter of 0.01 to 2.0 μm, and of specific aqueous solutions (developers) having a pH of 2 to 10, the developability was better, and the scumming resistance and press life were comparable to or better than those in cases where the arithmetical mean roughness $R_a$ was too large or recessed portions with an average opening diameter of 0.01 to 2.0 μm were absent.

## Claims

1. A platemaking method to obtain a lithographic printing plate, comprising the steps of:

   recording an image, by imagewise exposure, on a presensitized plate comprising a lithographic printing plate support and an image recording layer on the support, then
   developing the presensitized plate on which the image has been recorded so as to obtain a lithographic printing plate, wherein the developing step is carried out using an aqueous solution which contains at least 1 wt% of a nonionic surfactant and/or an anionic surfactant and has a pH of 2 to 10;

   wherein the lithographic printing plate support is an aluminum plate having an arithmetical mean roughness Ra of less than 0.4 μm and having on the surface thereof a grained shape with a structure bearing recessed portions with an average opening diameter of 0.01 to 2.0 μm.

2. The platemaking method according to claim 1, wherein the aqueous solution used in the developing step contains a water-soluble polymeric compound.

3. The platemaking method according to claim 1 or 2, wherein the anionic surfactant has a sulfonate anionic group or a sulfate monoester anionic group, and has additionally an aromatic group which may have a substituent.

4. The platemaking method according to any one of claims 1 to 3, wherein the nonionic surfactant is a nonionic aromatic ether surfactant of the formula (1) below

   $$X\text{-}Y\text{-}O\text{-}(A)_n\text{-}(B)_m\text{-}H \qquad (1)$$

   where X is an aromatic group which may have a substituent; Y is a single bond or an alkylene group of 1 to 10 carbon atoms; A and B, which mutually differ, are $-CH_2CH_2O-$ or $-CH_2CH(CH_3)O-$; and n and m are both integers from 0 to 100, with the proviso that $n+m \geq 2$.

5. The platemaking method according to any one of claims 1 to 4, wherein the image recording layer contains a polymerization initiator, a polymerizable compound, and a hydrophobic binder polymer.

6. The platemaking method according to any one of claims 1 to 5, wherein the presensitized plate additionally has a protective layer on the image recording layer.

7. The platemaking method according to any one of claims 1 to 6, wherein a laser which emits light at a wavelength of 760 to 1200 nm is used in the imagewise exposure.

8. The platemaking method according to any one of claims 1 to 6, wherein a laser which emits light at a wavelength of 250 to 420 nm is used in the imagewise exposure.

9. The platemaking method according to any one of claims 1 to 8, wherein some or all of ingredients which form the image recording layer are encapsulated in microcapsules.

## Patentansprüche

1. Plattenherstellungsverfahren für den Erhalt einer Lithografiedruckplatte, welches die Schritte umfasst:

Aufzeichnen eines Bildes durch bildweise Exposition auf einer vorsensibilisierten Platte, welche einen Lithografiedruckplattenträger und eine Bildaufzeichnungsschicht auf dem Träger umfasst,
dann Entwickeln der vorsensibilisierten Platte, auf der das Bild aufgezeichnet wurde, um eine Lithografiedruckplatte zu erhalten, wobei der Entwicklungsschritt unter Verwendung einer wässrigen Lösung durchgeführt wird, welche mindestens 1 Gew.% eines nicht-ionischen Tensids und/oder eines anionischen Tensids enthält und einen pH von 2 bis 10 hat;
wobei der Lithografiedruckplattenträger eine Aluminiumplatte ist, die eine mittlere arithmetische Rauigkeit von weniger als 0,4 μm hat und die auf der Oberfläche eine gekörnte Form mit einer Struktur hat, die Vertiefungen mit einem mittleren Öffnungsdurchmesser von 0,01 bis 2,0 μm enthält.

**2.** Plattenherstellungsverfahren gemäß Anspruch 1, wobei die wässrige Lösung, die in dem Entwicklungsschritt verwendet wird, eine wasserlösliche polymere Verbindung enthält.

**3.** Plattenherstellungsverfahren gemäß Anspruch 1 oder 2, wobei das anionische Tensid eine anionische Sulfonatgruppe oder eine anionische Monoestersulfatgruppe und zusätzlich eine aromatische Gruppe, die einen Substituenten haben kann, enthält.

**4.** Plattenherstellungsverfahren gemäß irgendeinem der Ansprüche 1 bis 3, wobei das nicht-ionische Tensid ein nicht-ionisches aromatisches Ethertensid der unten dargestellten Formel (1) ist

$$X\text{-}Y\text{-}O\text{-}(A)_n\text{-}(B)_m\text{-}H \qquad (1)$$

worin X eine aromatische Gruppe ist, die einen Substituenten haben kann; Y ist eine Einfachbindung oder eine Alkylengruppe mit 1 bis 10 Kohlenstoffatomen; A und B, welche voneinander unterschiedlich sind, sind $-CH_2CH_2O-$ oder $-CH_2CH(CH_3)O-$; und n und m sind beide ganze Zahlen von 0 bis 100, mit der Maßgabe, dass $n+m \geq 2$.

**5.** Plattenherstellungsverfahren gemäß irgendeinem der Ansprüche 1 bis 4, wobei die Bildaufzeichnungsschicht einen Polymerisationsinitiator, eine polymerisierbare Verbindung und ein hydrophobes Bindepolymer enthält.

**6.** Plattenherstellungsverfahren gemäß irgendeinem der Ansprüche 1 bis 5, wobei die vorsensibilisierte Platte zusätzlich eine Schutzschicht auf der Bildaufzeichnungsschicht hat.

**7.** Plattenherstellungsverfahren gemäß irgendeinem der Ansprüche 1 bis 6, worin ein Laser bei der bildweisen Exposition verwendet wird, der Licht bei einer Wellenlänge von 760 bis 1.200 nm emittiert.

**8.** Plattenherstellungsverfahren gemäß irgendeinem der Ansprüche 1 bis 6, worin ein Laser in der bildweisen Exposition verwendet wird, welcher Licht bei einer Wellenlänge von 250 bis 420 nm emittiert.

**9.** Plattenherstellungsverfahren gemäß irgendeinem der Ansprüche 1 bis 8, worin einige oder alle Bestandteile, die die Bildaufzeichnungsschicht bilden, in Mikrokapseln verkapselt sind.

## Revendications

**1.** Procédé de fabrication de plaque pour obtenir une plaque d'impression lithographique, comprenant les étapes consistant à :

enregistrer une image, par exposition image par image, sur une plaque présensibilisée comprenant un support de plaque d'impression lithographique et une couche d'enregistrement d'image sur le support, ensuite
développer la plaque présensibilisée sur laquelle l'image a été enregistrée de façon à obtenir une plaque d'impression lithographique, dans lequel l'étape de développement est exécutée en utilisant une solution aqueuse qui contient au moins 1 % en poids d'un agent de surface non ionique et/ou d'un agent de surface anionique et a un pH de 2 à 10 ;
dans lequel le support de plaque d'impression lithographique est une plaque d'aluminium ayant une rugosité moyenne arithmétique Ra de moins de 0,4 μm et ayant sur la surface de celle-ci une forme grainée avec une structure portant des parties en creux avec un diamètre d'ouverture moyen de 0,01 à 2,0 μm.

**2.** Procédé de fabrication de plaque selon la revendication 1, dans lequel la solution aqueuse utilisée dans l'étape de

développement contient un composé polymère hydrosoluble.

**3.** Procédé de fabrication de plaque selon la revendication 1 ou 2, dans lequel l'agent de surface anionique a un groupe sulfonate anionique ou un groupe anionique monoester de sulfate, et a additionnellement un groupe aromatique qui peut avoir un substituant.

**4.** Procédé de fabrication de plaque selon l'une quelconque des revendications 1 à 3, dans lequel l'agent de surface non ionique est un agent de surface d'éther aromatique non ionique de la formule (1) ci-dessous

$$X\text{-}Y\text{-}O\text{-}(A)_n(B)_m\text{-}H \qquad (1)$$

où X est un groupe aromatique qui peut avoir un substituant ; Y est une liaison simple ou un groupe alkylène de 1 à 10 atomes de carbone ; A et B, qui diffèrent mutuellement, sont $-CH_2CH_2O-$ ou $-CH_2CH(CH_3)O-$; et n et m sont tous les deux des entiers de 0 à 100, sous la condition que $n+m \geq 2$.

**5.** Procédé de fabrication de plaque selon l'une quelconque des revendications 1 à 4, dans lequel la couche d'enregistrement d'image contient un initiateur de polymérisation, un composé polymérisable, et un polymère de liant hydrophobe.

**6.** Procédé de fabrication de plaque selon l'une quelconque des revendications 1 à 5, dans lequel la plaque présensibilisée a additionnellement une couche protectrice sur la couche d'enregistrement d'image.

**7.** Procédé de fabrication de plaque selon l'une quelconque des revendications 1 à 6, dans lequel un laser qui émet une lumière à une longueur d'onde de 760 à 1 200 nm est utilisé dans l'exposition image par image.

**8.** Procédé de fabrication de plaque selon l'une quelconque des revendications 1 à 6, dans lequel un laser qui émet une lumière à une longueur d'onde de 250 à 420 nm est utilisé dans l'exposition image par image.

**9.** Procédé de fabrication de plaque selon l'une quelconque des revendications 1 à 8, dans lequel certains ou tous les ingrédients qui forment la couche d'enregistrement d'image sont encapsulés dans des microcapsules.

FIG.1

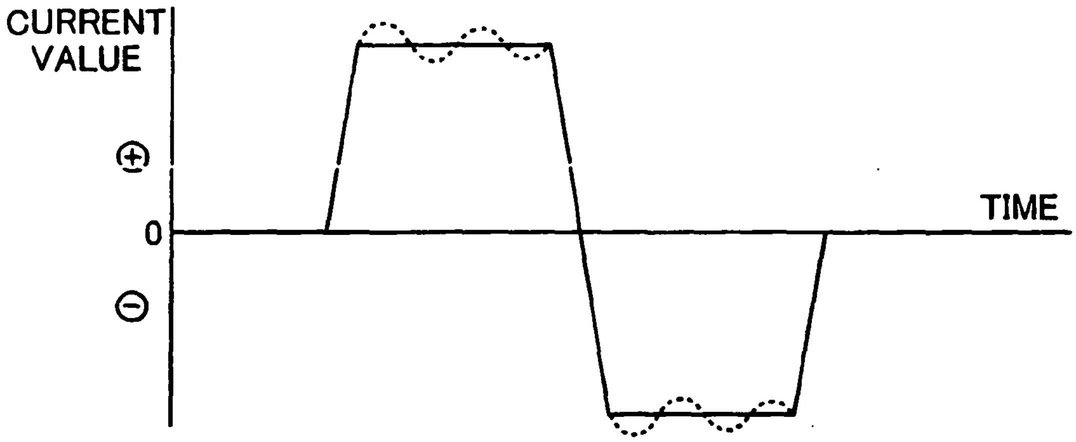
CURRENT VALUE
⊕
0
⊖
TIME

FIG.2

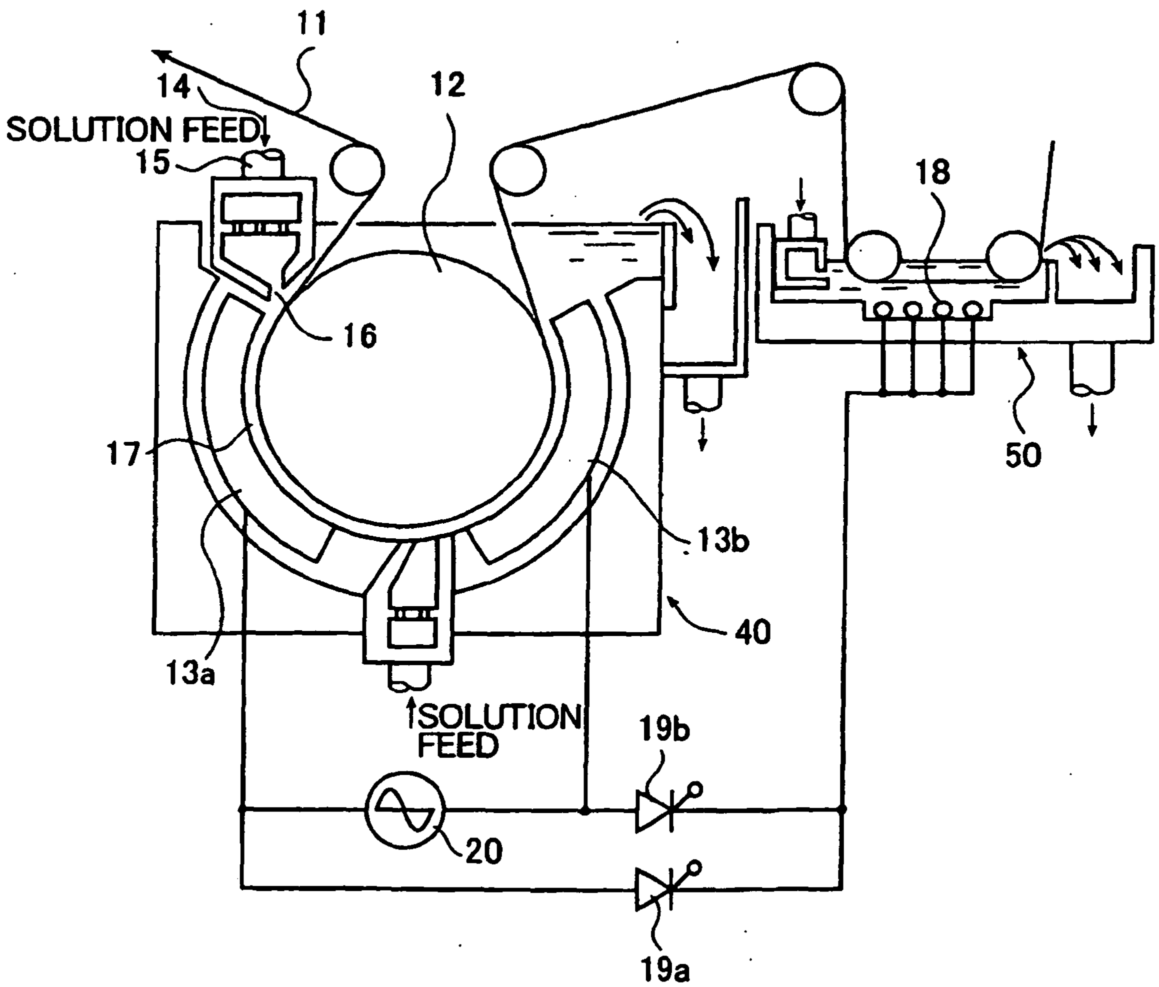
11
14
SOLUTION FEED
15
12
18
16
17
13b
50
40
13a
SOLUTION FEED
19b
20
19a

FIG.3

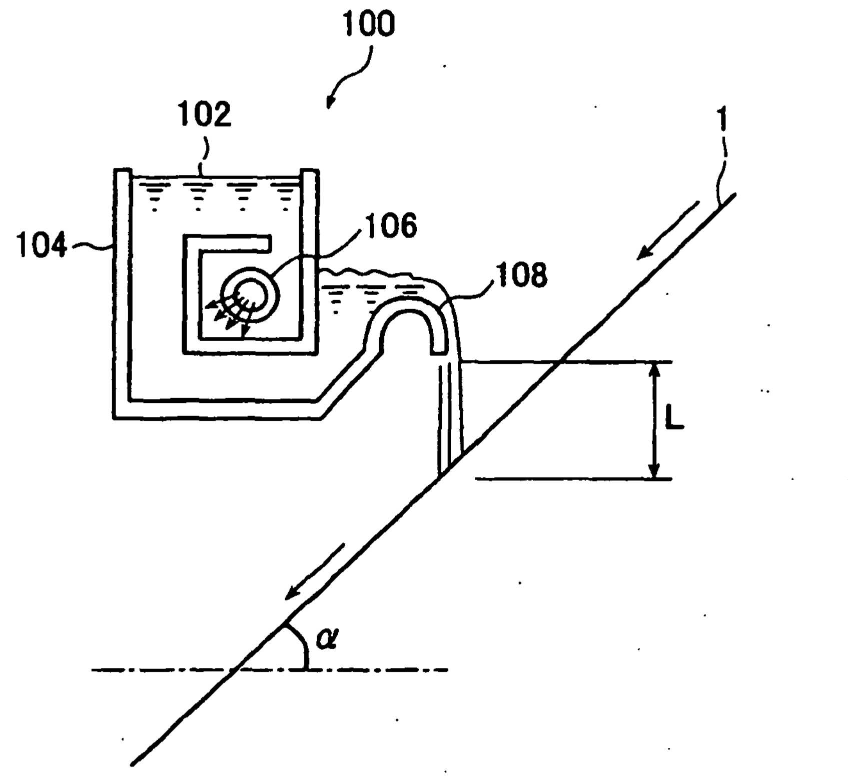


FIG.4

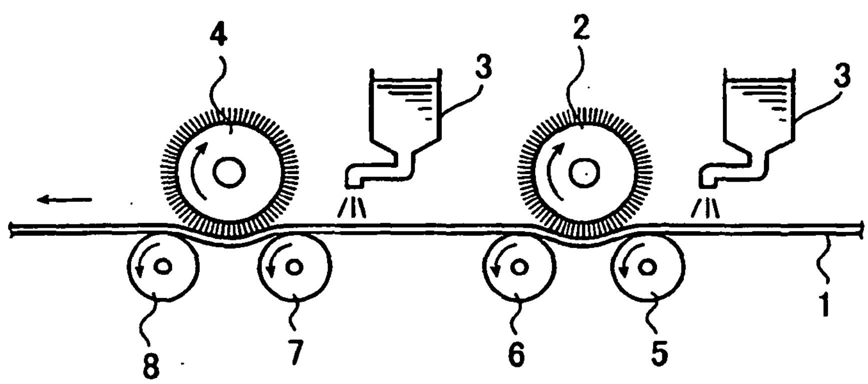

FIG. 5

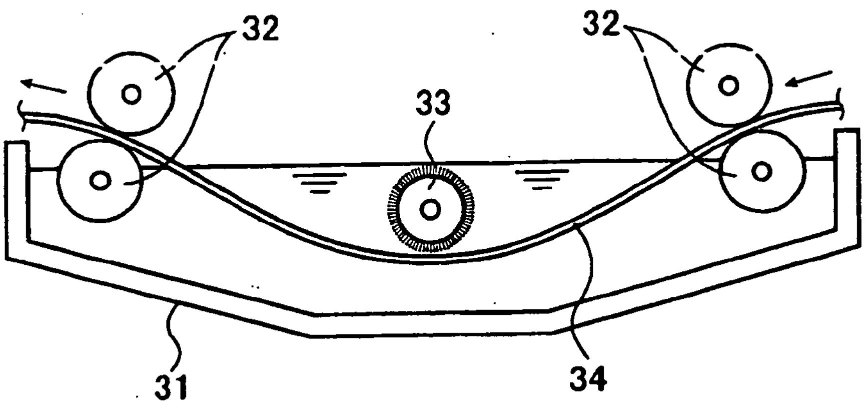

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002091016 A
- US 20040013986 A1
- EP 0316240 A
- GB 1515175 A
- EP 1503247 A2
- JP 2938397 B
- JP 54063902 A
- JP 48028123 B
- GB 896563 B
- JP 52058602 A
- JP 3079799 A
- JP 55158298 A
- JP 56028898 A
- JP 52152302 A
- JP 54085802 A
- JP 60190392 A
- JP 58120531 A
- JP 63176187 A
- JP 1005889 A
- JP 1280590 A
- JP 1118489 A
- JP 1148592 A
- JP 1178496 A
- JP 1188315 A
- JP 1154797 A
- JP 2235794 A
- JP 3260100 A
- JP 3253600 A
- JP 4072079 A
- JP 4072098 A
- JP 3267400 A
- JP 1141094 A
- US 4276129 A
- US 4676879 A
- US 4203637 A
- JP 56123400 A
- JP 57059770 A
- JP 53012738 A
- JP 53032821 A
- JP 53032822 A
- JP 53032823 A
- JP 55122896 A
- JP 55132884 A
- JP 62127500 A
- JP 1052100 A
- JP 1052098 A
- JP 60067700 A
- JP 1230800 A
- JP 3257199 A
- JP 53012739 A
- JP 53032833 A
- JP 53032824 A
- JP 53032825 A
- JP 51007081 B
- JP 52133838 A
- JP 52133840 A
- JP 52133844 A
- JP 52133845 A
- JP 53149135 A
- JP 54146234 A
- JP 5195300 A
- JP 2003096584 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A

- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2003328465 A
- JP 2000066385 A
- JP 2000080068 A
- US 4069055 A
- JP 4365049 A
- US 4069056 A
- EP 104143 B
- JP 2150848 A
- JP 2296514 A
- EP 370693 B
- EP 233567 B
- EP 297443 B
- EP 297442 B
- US 4933377 A
- US 4760013 A
- US 4734444 A
- US 2833827 A
- DE 2904626
- DE 3604580
- DE 3604581
- JP 2001343742 A
- JP 2002148790 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 2002029162 A
- JP 7021633 B
- JP 58125246 A
- JP 59084356 A
- JP 60078787 A
- GB 434875 B
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2001133969 A
- JP 2002278057 A
- JP 51048516 B
- JP 5047095 B
- JP 62170950 A
- JP 62226143 A
- JP 60168144 A
- JP 62293247 A
- JP 2001277740 A
- JP 2001277742 A
- US 2800457 A
- US 2800458 A
- US 3287154 A
- JP 3819574 B
- JP 42446 B

- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 B
- US 3111407 A
- GB 952807 B
- GB 967074 B
- JP 10282679 A
- JP 2304441 A
- US 3458311 A
- JP 55049729 B
- JP 49070702 A
- GB 1303578 B
- JP 5045885 A
- JP 6035174 A

**Non-patent literature cited in the description**

- **Wakabayashi et al.** *Bull. Chem. Soc. Japan,* 1969, vol. 42, 2924
- **Martin Kunz.** *Rad Tech' 98. Proceedings,* 19 April 1998
- *JCS Perkin II,* 1979, 1653-1660
- *JCS Perkin II,* 1979, 156-162
- *Journal of Photopolymer Science and Technology,* 1995, 202-232
- **S.I. Schlesinger.** *Photogr. Sci. Eng.,* 1974, vol. 18, 387
- **T.S. Bal et al.** *Polymer,* 1980, vol. 21, 423
- **J.V. Crivello et al.** *Macromolecules,* 1977, vol. 10 (6), 1307
- **J.V. Crivello et al.** *J. Polymer Sci., Polymer Chem. Ed.,* 1979, vol. 17, 1047
- **C.S. Wen.** *Teh, Proc. Conf. Rad. Curing ASIA,* October 1988, 478
- *Nippon Setchaku Kyokaishi,* 1984, vol. 20 (7), 300-308
- Saishin Ganryo Binran. Latest Handbook of Pigments. Japan Association of Pigment Technology, 1977
- Saishin Ganryo Oyo Gijutsu. CMC Publishing Co., Ltd, 1986
- Insatsu Inki Gijutsu. CMC Publishing Co., Ltd, 1984
- Kinzoku Sekken no Seishitsu to Oyo. Saiwai Shobo